(19) Europäisches Patentamt
European Patent Office
Office européen des brevets

(11) EP 4 439 695 A1

(12) EUROPEAN PATENT APPLICATION
published in accordance with Art. 153(4) EPC

(43) Date of publication:
02.10.2024 Bulletin 2024/40

(21) Application number: 22895724.7

(22) Date of filing: 21.11.2022

(51) International Patent Classification (IPC):
*H01M 4/13* (2010.01) *G01R 31/382* (2019.01)
*G01R 31/385* (2019.01) *G01R 31/389* (2019.01)
*H01M 4/133* (2010.01) *H01M 4/587* (2010.01)
*H01M 4/62* (2006.01) *H01M 10/052* (2010.01)
*H01M 10/48* (2006.01)

(52) Cooperative Patent Classification (CPC):
**G01R 31/382; G01R 31/385; G01R 31/389; H01M 4/13; H01M 4/133; H01M 4/587; H01M 4/62; H01M 10/052; H01M 10/48;** Y02E 60/10

(86) International application number:
PCT/JP2022/043005

(87) International publication number:
WO 2023/090443 (25.05.2023 Gazette 2023/21)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 22.11.2021 JP 2021189360
18.03.2022 JP 2022044152
18.03.2022 JP 2022044154
18.03.2022 JP 2022044156

(71) Applicants:
- Osaka Gas Co., Ltd.
  Osaka-shi, Osaka 541-0046 (JP)
- KRI, Inc.
  Kyoto-shi, Kyoto 600-8813 (JP)

(72) Inventors:
- KONDOU, Fumiya
  Kyoto-shi, Kyoto 600-8813 (JP)
- FUJII, Masanori
  Kyoto-shi, Kyoto 600-8813 (JP)
- KINOSHITA, Hajime
  Kyoto-shi, Kyoto 600-8813 (JP)

(74) Representative: Müller-Boré & Partner
Patentanwälte PartG mbB
Friedenheimer Brücke 21
80639 München (DE)

# (54) COMPOSITION FOR FORMING ELECTRODE ACTIVE MATERIAL LAYER FOR LITHIUM ION SECONDARY BATTERIES

(57) The present invention provides a composition for forming an electrode active material layer for lithium ion secondary batteries, the composition comprising an electrode active material and a carbon nanotube, wherein the content of the carbon nanotube is 0.01 to 1.4 mass% and the content of electrode constituent materials other than the electrode active material and the carbon nanotube is 0 to 10.0 mass%, based on the total amount of the composition taken as 100 mass%. This composition for forming an electrode active material layer for lithium ion secondary batteries is capable of producing a battery with extended life. After discharging the battery from a state of charge (SOC) of 100% to an SOC of 90% at 25°C and 2.5 C, the discharging is paused for 10 minutes and an increase in voltage at pause is measured. The internal resistance is calculated according to the following formula (2):

Internal resistance = (Increase in voltage at pause (V)/Current during discharge (A)) x Facing area between positive electrode and negative electrode ($cm^2$)

whereby uneven reaction distribution in the battery, which causes a rapid decrease of the capacity (secondary deterioration), can be assessed.

EP 4 439 695 A1

Fig.5

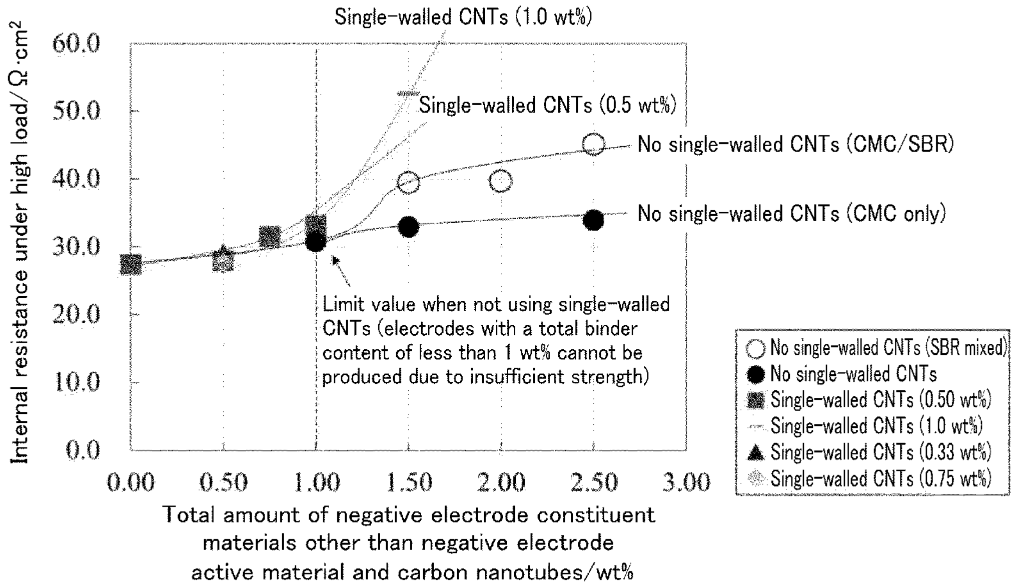

Single-walled CNTs (1.0 wt%)
Single-walled CNTs (0.5 wt%)
No single-walled CNTs (CMC/SBR)
No single-walled CNTs (CMC only)
Limit value when not using single-walled CNTs (electrodes with a total binder content of less than 1 wt% cannot be produced due to insufficient strength)
Internal resistance under high load/Ω·cm²
60.0
50.0
40.0
30.0
20.0
10.0
0.0
0.00
0.50
1.00
1.50
2.00
2.50
3.00
Total amount of negative electrode constituent materials other than negative electrode active material and carbon nanotubes/wt%
No single-walled CNTs (SBR mixed)
No single-walled CNTs
Single-walled CNTs (0.50 wt%)
Single-walled CNTs (1.0 wt%)
Single-walled CNTs (0.33 wt%)
Single-walled CNTs (0.75 wt%)

## Description

### Technical Field

The present invention relates to a composition for forming an electrode active material layer for lithium ion secondary batteries.

### Background Art

The lithium ion battery (LIB) business has achieved dramatic growth through continuous technological development for making portable devices smaller, lighter, and more functional (in pursuit of convenience) while taking advantage of its high energy density, high voltage, safety features, etc. Now that global environmental issues and resource issues are in the spotlight, policies such as promoting wide-spread use of eco-cars and switching to renewable energy are expected to continue to drive the market growth of lithium-ion batteries. If lithium-ion batteries continue to be used for privately owned electric vehicles (EVs) and stationary electricity storage (e.g., leveling of renewable energy), the amount of lithium-ion batteries that will be needed in 2030 is calculated to be approximately 10 times the amount of lithium-ion batteries in 2018. Since a situation unfavorable to users from the viewpoint of economy, such as a sharp increase in battery costs due to resource shortage or the like, may possibly occur, research and development on reuse from the viewpoint of how to use a single battery for a longer period of time or on recycling from the viewpoint of resource recovery is becoming more active, and extending battery life is effective also from the standpoint of life cycle assessment (LCA).

New proposals have been made about how mobility, such as with EVs, should be. CASE, MaaS, and the like that aim to improve user convenience are becoming a reality. There are signs that mobility, such as with EVs, will shift from private ownership to sharing in the future. In such a trend, artificial intelligence electric vehicles (AIEVs), which are expected to expand in the market in the future, are AI-powered EVs in which driving is automated, vehicles are shared, and cars are not individually owned but are managed by a management company. The management company provides mobility services (CASE) and various services required by the user in the vehicle (MaaS). In addition, since the operation control and charge and discharge control can be made by the management company, operation in consideration of battery life, safety, etc. is feasible. Further, sharing vehicles can reduce the burden on the user to about one-fifth that of individual ownership, thus resulting in highly economical operation. That is, replacing private cars, which are mainly gasoline-powered vehicles, with AIEVs (shared cars) in the future is expected to, for example, contribute to the global environment, reduce traffic accidents and traffic congestion, provide a new transportation means for ageing and depopulated areas, reduce personal expenses, and make effective use of travel time. In addition, it will also become possible for AIEVs to function as huge electricity storage systems, in which electricity generated from highly variable renewable energy sources is automatically charged by the management system of the management company and discharged as required.

However, achieving this will require rethinking the direction of development of lithium-ion batteries, which are currently the mainstream (Fig. 1).

In particular, dramatically extending the life of batteries installed in electric vehicles is essential. To achieve AIEVs, unlike the case of private ownership of a vehicle, the total mileage of the vehicle must be, for example, 500,000 km or more. If battery life is at the current level, batteries must be replaced several times, which is less economical and also does not solve resource problems. With respect to required battery performance, life of the battery is considered more important than energy density (mileage) and quick rechargeability, which are primary requirements at present. For example, a 400 Wh/L level of energy density must be secured for a single battery and the mileage is 200-300 km at 20-30 kWh. However, in actual operational life, the target life must be at least five times more than the current level.

### Summary of Invention

### Technical Problem

So far, various studies have been made on extending battery life. When extending the actual operation life to at least 5 times the current life, consideration of the issue from a new perspective is necessary. With respect to the degradation of batteries, degradation factors, such as degradation due to oxidation and reduction of active materials and components, degradation due to lithium ion insertion into or desorption from the active materials, lithium ion consumption due to, for example, electrolyte degradation, and degradation due to electrode loosening, have been often considered in the past. However, in the present invention, the present inventors focused on an overvoltage factor.

The present inventors defined a new degradation mechanism called "degradation by an overvoltage factor (current x resistance)" and thereby explained phenomena such as low temperature degradation and secondary degradation. Degradation due to the overvoltage factor is defined as a degradation factor affected by load current and battery resistance (DC resistance), and for example, degradation during low-temperature cycling can be explained as a result of increased resistance at low temperatures, and degradation due to rapid charging can be explained as a result of increased load current. In addition, as the battery deteriorates, the resistance increases. Further, as the capacity deteriorates, the load (apparent load) on a living active material portion increases when the same current as that at the beginning is applied. Further, if gas or other substances accumulate in a group of electrodes, a load is applied to the electrode part other than the gas pool, and an active material because the gas does not allow ions to pass therethrough. From this viewpoint, one factor that affects battery life as an overvoltage factor is uneven reaction distribution in the electrode. Unless a uniform reaction occurs in the electrode, a load is accumulated on, for example, some of the active materials used in the electrode during long-term operation of the battery. For example, in the negative electrode, lithium ions are consumed due to strong local reduction, and in the worst case, lithium electrodeposition etc. are induced. For example, in the positive electrode, uneven reaction distribution induces degradation of the positive electrode active material due to cracks etc. Therefore, after repetition of a certain number of charge-discharge cycles, a sharp decrease in capacity and a sharp increase in resistance (secondary degradation) occur in most cases. By achieving a uniform reaction in the battery and inhibiting uneven reaction distribution in the battery, this secondary degradation (sharp decrease in capacity) can be inhibited and battery life can be dramatically extended. Therefore, it is important to make a reaction in the battery uniform. However, little work has been done to achieve a uniform reaction in the battery.

In order to achieve a uniform reaction in the battery, it is important to form an electrode structure that allows for uniform ion movement in the electrode. As such a means, increasing the porosity rate of electrodes or reducing the basis weight of electrodes has been studied. However, since these methods involve a reduction in energy density (millage), these methods alone are limited in terms of ensuring the 400 Wh/L level. From the viewpoint of achieving uniform ion movement in the electrode, it is also considered effective to eliminate factors that can inhibit ion movement in the electrode, such as electrode constituent materials, such as binders usually used to impart strength to electrodes, and thickeners used to stabilize the electrode slurry, and dispersants. However, reducing or eliminating these constituent materials significantly reduces the electrode strength, resulting in failure to follow the volume change of the electrode upon charge and discharge, and the life characteristics would be instead reduced due to the lack of current collection paths and other factors.

The present invention is intended to solve the above problems. An object of the present invention is to provide a composition for forming a negative electrode active material layer capable of producing a battery with a longer life. Another object of the present invention is to provide a method for assessing uneven reaction distribution in a battery, which is a factor that causes a sharp decrease in capacity (secondary degradation).

Solution to Problem

In view of the above problems, the present inventors have conducted intensive research. As a result, the present inventors found that when a composition contains no electrode constituent materials that can inhibit ion movement in the electrode, such as binders, or contains a very small amount of such electrode constituent materials, and current collection between active material particles, *maintenance* of electrode shape, etc. are performed by means of a very small amount of carbon nanotube, the composition has strength sufficient to maintain the electrode shape and is less likely to inhibit the transport of lithium ions, thus achieving a uniform reaction in the battery and extending battery life. The present inventors further found that uneven reaction distribution in the battery can be assessed by calculating the internal resistance at pause after discharge under high load conditions. The present invention was accomplished as a result of further research based on the above finding. Specifically, the present invention includes the following.

Item 1.

A composition for forming an electrode active material layer for lithium ion secondary batteries, the composition comprising

an electrode active material and
a carbon nanotube,

wherein, based on the total amount of the composition taken as 100 mass%,

the content of the carbon nanotube is 0.01 to 1.4 mass% and
the content of one or more electrode constituent materials other than the electrode active material and the carbon nanotube is 0 to 10.0 mass%.

Item 2.

The composition for forming an electrode active material layer for lithium ion secondary batteries according to Item 1, wherein

the content of the electrode active material is 96.6 to 99.9 mass%,
the content of the electrode constituent materials other than the electrode active material and the carbon nanotube is 0 to 2.0 mass%, and
the composition is for forming a negative electrode active material layer for lithium ion secondary batteries.

Item 3.

The composition for forming an electrode active material layer for lithium ion secondary batteries according to Item 1, wherein

the content of the electrode active material is 97.4 to 99.9 mass%, and
the content of the electrode constituent materials other than the electrode active material and the carbon nanotube is 0 to 1.2 mass%.

Item 4.

The composition for forming an electrode active material layer for lithium ion secondary batteries according to Item 3, wherein the composition is for forming a negative electrode active material layer for lithium ion secondary batteries.

Item 5.

The composition for forming an electrode active material layer for lithium ion secondary batteries according to any one of Items 1 to 4, wherein

the content of the carbon nanotube is 0.01 to 0.8 mass%,
the electrode active material comprises an amorphous carbon material, and
the composition is for forming a negative electrode active material layer for lithium ion secondary batteries.

Item 5-1.

The composition for forming an electrode active material layer for lithium ion secondary batteries according to Item 5, wherein the composition comprises at least one conductive aid other than the carbon nanotube, the content of the at least one conductive aid other than the carbon nanotube being 0.1 to 10.0 mass%, based on the total amount of the composition taken as 100 mass%.

Item 5-2.

The composition for forming an electrode active material layer for lithium ion secondary batteries according to Item 5 or 5-1, wherein the content of the carbon nanotube is 0.1 to 10.0 mass%, based on the total amount of the carbon nanotube and the conductive aid other than the carbon nanotube taken as 100 mass%.

Item 5-3.

The composition for forming an electrode active material layer for lithium ion secondary batteries according to any one of Item 5 to 5-2, wherein the content of the electrode active material is 79.2 to 99.8 mass%, based on the total amount of the composition taken as 100 mass%.

Item 5-4.

The composition for forming an electrode active material layer for lithium ion secondary batteries according to any one of claims 5 to 5-3, wherein the composition comprises at least one electrode constituent material other than the electrode active material, the carbon nanotube, and the conductive aid other than the carbon nanotube, the content of the electrode constituent material being 0.1 to 10.0 mass%, based on the total amount of the composition taken as 100 mass%.

Item 6.

A composition for forming an electrode active material layer for lithium ion secondary batteries, the composition comprising

an electrode active material and
a carbon nanotube,

wherein, based on the total volume of the composition taken as 100 vol%,

the percentage by volume of the electrode active material is 75.06 to 99.97 vol%,
the percentage by volume of the carbon nanotube is 0.02 to 4.55 vol%, and
the percentage by volume of electrode constituent materials other than the electrode active material and the carbon nanotube is 0 to 21.56 vol%.

Item 7.

The composition for forming an electrode active material layer for lithium ion secondary batteries according to Item 6, wherein, based on the total volume of the composition taken as 100 vol%,

the percentage by volume of the electrode active material is 93.38 to 99.98 vol%,
the percentage by volume of the carbon nanotube is 0.02 to 2.18 vol%,
the percentage by volume of the electrode constituent materials other than the negative electrode active material and the carbon nanotube is 0 to 4.52 vol%, and
the composition is for forming a negative electrode active material layer for lithium ion secondary batteries.

Item 8.

The composition for forming an electrode active material layer for lithium ion secondary batteries according to Item 6, wherein

the percentage by volume of the electrode active material is 96.19 to 99.98 vol%,
the percentage by volume of the carbon nanotube is 0.02 to 2.18 vol%, and
the percentage by volume of the electrode constituent materials other than the electrode active material and the carbon nanotube is 0 to 1.63 vol%.

Item 9.

The composition for forming an electrode active material layer for lithium ion secondary batteries according to Item 8, wherein the composition is for forming a negative electrode active material layer for lithium ion secondary batteries.

Item 10.

The composition for forming an electrode active material layer for lithium ion secondary batteries according to any one of Items 1 to 9, wherein the electrode active material has an average particle size of 0.1 to 13.0 μm.

Item 11.

The composition for forming an electrode active material layer for lithium ion secondary batteries according to claim 10, wherein

the electrode active material has an average particle size of 0.1 to 13.0 um,
the content of the electrode active material is 96.6 to 99.9 mass%,
the content of the carbon nanotube is 0.01 to 1.4 mass%,
the content of the electrode constituent materials other than the electrode active material and the carbon nanotube is 0 to 2.0 mass%, and

the composition is for forming a negative electrode active material layer for lithium ion secondary batteries.

Item 12.

The composition for forming an electrode active material layer for lithium ion secondary batteries according to Item 10, wherein

the electrode active material has an average particle size of 0.1 to 13.0 μm,
the percentage by volume of the electrode active material is 93.38 to 99.98 vol%,
the percentage by volume of the carbon nanotube is 0.02 to 2.18 vol%,
the percentage by volume of the electrode constituent materials other than the electrode active material and the carbon nanotube is 0 to 4.52 vol%, and
the composition is for forming a negative electrode active material layer for lithium ion secondary batteries.

Item 13.

The composition for forming an electrode active material layer for lithium ion secondary batteries according to Item 1 or 10, wherein

the content of the electrode active material is 88.6 to 99.9 mass%,
the content of conductive aids other than the carbon nanotube is 0 to 10.0 mass%,
the composition contains no electrode constituent materials other than the electrode active material, the carbon nanotube, and the conductive aids other than the carbon nanotube, and
the composition is for forming a positive electrode active material layer for lithium ion secondary batteries.

Item 14.

The composition for forming an electrode active material layer for lithium ion secondary batteries according to Item 6 or 10, wherein

the percentage by volume of the electrode active material is 75.06 to 99.97 vol%,
the content of the carbon nanotube is 0.03 to 4.55 vol%,
the content of conductive aids other than the carbon nanotube is 0 to 21.56 vol%,
the composition contains no electrode constituent materials other than the electrode active material, the carbon nanotube, and the conductive aids other than the carbon nanotube, and
the composition is for forming a positive electrode active material layer for lithium ion secondary batteries.

Item 14-1.

The composition for forming an electrode active material layer for lithium ion secondary batteries according to Item 13 or 14, wherein the at least one conductive aid other than the carbon nanotube is carbon black.

Item 15.

The composition for forming an electrode active material layer for lithium ion secondary batteries according to any one of Items 1 to 14, wherein the electrode active material is a material capable of absorbing and releasing a lithium ion.

Item 15-1.

The composition for forming an electrode active material layer for lithium ion secondary batteries according to Item 15, wherein the electrode active material is an amorphous layered carbon material and has an interlayer distance between (002) planes of 0.350 nm or more.

Item 15-2.

The composition for forming an electrode active material layer for lithium ion secondary batteries according to Item 15 or 15-1, wherein the electrode active material comprises hard carbon.

Item 16.

The composition for forming an electrode active material layer for lithium ion secondary batteries according to any one of Items 1 to 15-2, wherein the carbon nanotube is a single-walled carbon nanotube.

Item 17.

The composition for forming an electrode active material layer for lithium ion secondary batteries according to any one of claims 1 to 16, which is for use to reduce uneven reaction distribution in a lithium ion secondary battery.

Item 18.

The composition for forming an electrode active material layer for lithium ion secondary batteries according to any one of Items 1 to 17, which is for a lithium ion secondary battery for use in an electric vehicle for car sharing.

Item 19.

An electrode active material layer for lithium ion secondary batteries comprising the composition for forming an electrode active material layer for lithium ion secondary batteries of any one of Items 1 to 18.

Item 20.

The electrode active material layer for lithium ion secondary batteries according to Item 19, which is for a lithium ion secondary battery for use in an electric vehicle for car sharing.

Item 21.

An electrode for lithium ion secondary batteries comprising the electrode active material layer for lithium ion secondary batteries of Item 19 or 20.

Item 22.

The electrode for lithium ion secondary batteries according to Item 21, which is for a lithium ion secondary battery for use in an electric vehicle for car sharing.

Item 23.

A lithium ion secondary battery comprising the electrode for lithium ion secondary batteries of claim 21 or 22.

Item 24.

The lithium ion secondary battery according to Item 23, wherein the lithium ion secondary battery has an internal resistance of 1.0 to 35.0 $\Omega \cdot cm^2$ as calculated according to the following formula (2):

$$\text{Internal resistance} = (\text{Increase in voltage at pause (V)}/\text{Current value during discharge (A)}) \times \text{Facing area between positive electrode and negative electrode } (cm^2) \quad (2),$$

wherein the increase in voltage at pause is a value measured after discharging from a state of charge (SOC) of 100% to an SOC of 90% at 25°C and 3.0 C and then pausing for 10 minutes, wherein the SOC is defined according to the following formula (1):

$$\text{SOC (\%)} = \text{Remaining capacity (Ah)}/\text{Full charge capacity (Ah)} \times 100 \quad (1).$$

Item 24-1.

The lithium ion secondary battery according to Item 24, wherein the internal resistance is in the range of 1.0 to 25.0 $\Omega \cdot cm^2$.

Item 24-2.

The lithium ion secondary battery according to Item 24 or 24-1, wherein the internal resistance is in the range of 1.0 to 19.0 $\Omega \cdot cm^2$.

Item 25.

The lithium ion secondary battery according to any one of claims 23 to 24-2, wherein the lithium ion secondary battery has an internal resistance of 1.0 to 45.0 $\Omega \cdot cm^2$ as calculated according to the following formula (2):

Internal resistance = (Increase in voltage at pause (V)/Current value during discharge (A)) x Facing area between positive electrode and negative electrode ($cm^2$) (2),

wherein the increase in voltage at pause is a value measured after discharging from a state of charge (SOC) of 100% to an SOC of 90% at 0°C and 0.5 C and then pausing for 1 minute, wherein the SOC is defined according to the following formula (1):

SOC (%) = Remaining capacity (Ah)/Full charge capacity (Ah) x 100 (1).

Item 26.

The lithium ion secondary battery according to any one of Items 23 to 25 for use in an electric vehicle for car sharing.

Item 27.

A method for assessing uneven reaction distribution in a lithium ion battery, comprising

discharging the battery from a state of charge (SOC) of 100% to an SOC of 90% at 25°C and 2.5 C and then pausing for 10 minutes, wherein the SOC is defined according to the following formula (1):

SOC (%) = Remaining capacity (Ah)/Full charge capacity (Ah) x 100 (1),

measuring an increase in voltage at pause, and
calculating an internal resistance according to the following formula (2):

Internal resistance = (Increase in voltage at pause (V)/Current value during discharge (A)) x Facing area between positive electrode and negative electrode ($cm^2$) (2).

Advantageous Effects of Invention

According to the present invention, for example, current collection between active material particles and maintenance of electrode shape are performed by means of a very small amount of carbon nanotube and no binders or a very small amount of binders are contained, whereby the resulting composition has strength sufficient to maintain the electrode shape and is less likely to inhibit the transport of lithium ions, thus achieving a uniform reaction in the battery and extending battery life.

According to the present invention, uneven battery reaction distribution can be assessed by calculating the internal resistance at pause after discharge under high-load conditions.

Brief Description of Drawings

Fig. 1 is a schematic diagram showing the direction of development of lithium-ion batteries while bearing in mind the world view that the use and operation of vehicles will significantly change.
Fig. 2 is a graph showing an outline of the analysis method used in AC impedance measurement in Test Examples 2 and 6.
Fig. 3 is a graph showing the results of the AC impedance measurement in Test Example 2.
Fig. 4 is a graph showing an outline of the method for analyzing internal resistance used in the high-load current rest method in Test Examples 3, 7, 11, and 14.
Fig. 5 is a graph showing the results of internal resistance measured at room temperature (25°C) by the high-load current rest method in Test Example 3.
Fig. 6 is a graph showing the results of life characteristics in Test Example 3.
Fig. 7 shows the results of estimating battery life from the results of Test Example 3.
Fig. 8 is a diagram summarizing the results of internal resistance in Test Example 3 and life characteristics in Test Example 4.
Fig. 9 is a graph showing the results of AC impedance measurement in Test Example 6.
Fig. 10 is a graph showing the results of internal resistance measured at room temperature (25°C) by the high-load current rest method in Test Example 7.
Fig. 11 is a graph showing the results of internal resistance measured at a low temperature (0°C) by the high-load current rest method in Test Example 7.
Fig. 12 is a graph showing capacity retention determined while gradually increasing overvoltage load in the limit load test of Test Example 8.
Fig. 13 is a graph showing the results of 10-cycle capacity retention relative to overvoltage load in the limit load test of Test Example 8.
Fig. 14 is a graph showing the results of life characteristics in Test Example 9.
Fig. 15 is a graph showing the results of life characteristics in Test Example 12.
Fig. 16 is a graph showing the results of life characteristics in Test Example 15.

Description of Embodiments

In the present specification, the terms "comprise," "contain," and "include" encompass the concepts of comprising, consisting essentially of, and consisting of.
In the present specification, the range indicated by "A to B" means A or more and B or less.
1. Composition for Forming an Electrode Active Material Layer for

Lithium Ion Secondary Batteries

In general, the active material layer in an electrode often contains, in addition to an electrode active material, a considerable amount of electrode constituent materials other than the electrode active material, such as a binder. The electrode constituent materials other than the electrode active material are substances impermeable to lithium ions. Therefore, if the composition contains a significant amount of electrode constituent materials other than the electrode active material, lithium ion transport is inhibited and uniform charge and discharge fail to occur. When the transport of lithium ions is inhibited, the reaction is concentrated in areas where lithium ion transport is less inhibited. As a result, in negative electrodes, lithium electrodeposition is induced, whereas in positive electrodes, cracking is induced. Therefore, when a certain cycle of charge and discharge is repeated, deterioration of the electrode active substance due to cracking or other factors is induced, thus resulting in a sharp decrease in capacity and a sharp increase in resistance (secondary degradation). On the other hand, simply reducing the amount of electrode constituent materials other than the electrode active material fails to retain sufficient strength to maintain the electrode shape. Therefore, during charge and discharge, expansion and contraction occur and the electrode structure breaks down, which results in current collection degradation, such as reduced conductivity within the electrode, thereby reducing life characteristics of the battery. Accordingly, simply reducing the amount of electrode constituent materials other than the electrode active material is not sufficient to achieve the reduction of uneven reaction distribution as well as the improvement of life characteristics. In negative electrodes, as described above, the electrode structure breaks down, which results in current collection degradation, such as reduced conductivity within the electrode, thereby reducing life characteristics of the battery. In positive electrodes, as described above, degradation of the positive electrode active material due to cracking or other factors is induced. Therefore, it was common technical knowledge that the amount of electrode constituent materials other than the electrode active material cannot be significantly reduced. This tendency is particularly prominent in negative electrodes where the electrode structure breaks down.

In contrast, the composition for forming an electrode active material layer for lithium ion secondary batteries according to the present invention (No. 1) is a composition for forming an electrode active material layer for lithium ion secondary batteries, the composition comprising an electrode active material and a carbon nanotube, wherein the content of the carbon nanotube is 0.01 to 1.4 mass% and the content of electrode constituent materials other than the electrode active material and the carbon nanotube is 0 to 10.0 mass%. In the composition for forming an electrode active material layer for lithium ion secondary batteries according to the present invention (No. 1), the total amount of the electrode active material, the carbon nanotube, and electrode constituent materials other than the electrode active material and the carbon nanotube (the total amount of the composition) is 100 mass%.

In the composition for forming an electrode active material layer for lithium ion secondary batteries according to the present invention (No. 2), the percentage by volume of the electrode active material is 75.06 to 99.97 vol%, the percentage by volume of the carbon nanotube is 0.02 to 4.55 vol%, and the content of negative electrode constituent materials other than the electrode active material and the carbon nanotube is 0 to 21.56 mass%. In the composition for forming an electrode active material layer for lithium ion secondary batteries according to the present invention (No. 2), the total amount of the electrode active material, the carbon nanotube, and electrode constituent materials other than the electrode active material and the carbon nanotube (the total volume of the composition) is 100 vol%.

Based on such structural features, the present invention can suppress the inhibition of lithium ion transport by reducing the mass of lithium ion inhibitors while retaining sufficient strength to maintain the electrode shape, thus achieving a uniform reaction of the battery and extending battery life. That is, the composition for forming an electrode active material layer for lithium ion secondary batteries of the present invention can be used to reduce uneven reaction distribution in a lithium ion secondary battery.

Further, as stated above, when lithium ion transport is inhibited, the reaction is concentrated in areas where the transport of lithium ions is less inhibited, and as a result, in negative electrodes, for example, lithium electrodeposition is induced and the electrode structure breaks down, whereby life characteristics of the battery are deteriorated due to current collection degradation, such as reduced conductivity in the electrode. Therefore, it was common technical knowledge in the past that the amount of negative electrode constituent materials other than the negative electrode active material cannot be significantly reduced. Accordingly, using the composition for forming an electrode active material layer for lithium ion secondary batteries of the present invention to achieve a uniform reaction in the battery is particularly useful for application to negative electrodes. Thus, the composition for forming an electrode active material layer for lithium ion secondary batteries according to the present invention (No. 1) is a composition for forming an electrode active material layer for lithium ion secondary batteries, the composition comprising an electrode active material and a carbon nanotube, wherein the content of the electrode active material is 96.6 to 99.9 mass%, the content of the carbon nanotube is 0.01 to 1.4 mass%, the content of electrode constituent materials other than the electrode active material and the carbon nanotube is 0 to 2.0 mass%, and the composition is a composition for forming a negative electrode active material layer for lithium ion secondary batteries. Similarly, the composition for forming an electrode active material layer for lithium ion secondary batteries according to the present invention (No. 2) is a composition for forming an electrode active material layer for lithium ion secondary batteries, the composition comprising an electrode active material and a carbon nanotube, wherein the percentage by volume of the electrode active material is 93.38 to 99.98 vol%, the percentage by volume of the carbon nanotube is 0.02 to 2.18 vol%, the percentage by volume of electrode constituent materials other than the electrode active material and the carbon nanotube is 0 to 4.52 vol%, and the composition is preferably a composition for forming a negative electrode active material layer.

On the other hand, the composition of the present invention contains no electrode constituent materials or contains only a very small amount of electrode constituent materials that can inhibit ion movement in the electrode, such as binders, and current collection between active material particles and maintenance of the electrode shape are performed by means of a very small amount of carbon nanotube, whereby the composition has strength sufficient to maintain the electrode shape and is also less likely to inhibit the transport of lithium ions, thus achieving a uniform reaction in the electrode and extending battery life. Therefore, it is preferable to make the amount of electrode constituent materials other than the electrode active material and the carbon nanotube as small as possible. From this viewpoint, the composition for forming an electrode active material layer for lithium ion secondary batteries according to the present invention (No. 1) is preferably a composition for forming an electrode active material layer for lithium ion secondary batteries, the composition comprising an electrode active material and a carbon nanotube, wherein the content of the electrode active material is 97.4 to 99.9 mass%, the content of the carbon nanotube is 0.01 to 1.4 mass%, and the content of electrode constituent materials other than the electrode active material and the carbon nanotube is 0 to 1.2 mass%. Similarly, the composition for forming an electrode active material layer for lithium ion secondary batteries according to the present invention (No. 2) is preferably a composition for forming an electrode active material layer for lithium ion secondary batteries, the composition comprising an electrode active material and a carbon nanotube, wherein the percentage by volume of the electrode active material is in the range of 96.19 to 99.98 vol%, the percentage by volume of the carbon nanotube is in the range of 0.02 to 2.18 vol%, and the percentage by volume of electrode constituent materials other than the electrode active material and the carbon nanotube is in the range of 0 to 1.63 vol%. Since these compositions are particularly useful for application to negative electrodes, the compositions are preferably compositions for forming a negative electrode active material layer for lithium ion secondary batteries.

Four preferred embodiments of the composition for forming an electrode active material layer for lithium ion secondary batteries are individually described below.

(1-1) Composition for Forming an Electrode Active Material Layer for Lithium Ion Secondary Batteries (First Embodiment)

The composition for forming an electrode active material layer for lithium ion secondary batteries according to the first embodiment of the present invention (No. 1) is a composition for forming an electrode active material layer for lithium ion secondary batteries, the composition comprising an electrode active material and a carbon nanotube, wherein the content of the electrode active material is 97.4 to 99.9 mass%, the content of the carbon nanotube is 0.01 to 1.4 mass%, the content of electrode constituent materials other than the electrode active material and the carbon nanotube is 0 to 1.2 mass%, and the composition is a composition for forming a negative electrode active material layer. Similarly, the composition for forming an electrode active material layer for lithium ion secondary batteries according to the first embodiment of the present invention (No. 2) is a composition for forming an electrode active material layer for lithium ion secondary batteries, the composition comprising an electrode active material and a carbon nanotube, wherein the percentage by volume of the electrode active material is in the range of 96.19 to 99.98 vol%, the percentage by volume of carbon nanotube is in the range of 0.02 to 2.18 vol%, and the percentage by volume of electrode constituent materials other than the electrode active material and the carbon nanotube is in the range of 0 to 1.63 vol%, and the composition is a composition for forming a negative electrode active material layer.

[1-1-1] Electrode Active Material

The electrode active material (negative electrode active material) is not particularly limited. Materials that can be used as negative electrode active materials in lithium ion secondary batteries, i.e., materials capable of absorbing and releasing lithium ions, can be used. Examples include carbon materials, such as natural graphite, artificial graphite, and amorphous carbon; metal materials that can be alloyed with lithium, such as Si, Al, Sn, Pb, Zn, Bi, In, Mg, Ga, Si alloy, Sn alloy, and Al alloy; metal oxides capable of absorbing and releasing lithium ions, such as $SiO_x$ ($0<x<2$), $SnO_x$ ($0<x<2$), Si, $Li_2TiO_3$, and vanadium; and composite materials containing a metal material and a carbon material, such as Si-C composite and Sn-C composite. As amorphous carbon, amorphous carbon materials described below can also be used. These electrode active materials (negative electrode active materials) can be used alone or in a combination of two or more. In terms of particularly suppressing the volume change of the electrode active material (negative electrode active material) during charge and discharge and particularly improving charge-discharge cycle characteristics with ease, the following materials can also be used: silicon-free materials, i.e., carbon materials; silicon-free metal materials, e.g., metal materials capable of being alloyed with lithium, such as Al, Sn, Pb, Zn, Bi, In, Mg, Ga, Sn alloys, and Al alloys; silicon-free metal oxides capable of absorbing and releasing lithium ions, such as $SnO_x$ ($0<x<2$), Si, $Li_2TiO_3$, and vanadium oxides; and silicon-free composites containing metal materials and carbon materials, such as Sn-C composites. When a conductive material, such as a carbon material, among these is used as an electrode active material (negative electrode active material), the electrode active material (negative electrode active material) can also act as a conducting material and the content of substances that inhibit the transport of lithium ions can be particularly easily reduced.

In terms of particularly suppressing the volume change of the electrode active material (negative electrode active material) during charge and discharge, easily suppressing the capacity loss due to volume change, and particularly easily improving charge-discharge cycle characteristics, the electrode active material (negative electrode active material) such as those described above preferably has a volume change during charge and discharge of 50% or less, and preferably 20% or less. The smaller the volume change of the electrode active material, the better. There is no lower limit. If the lower limit is set, it will be 0%. The numerical value of the volume change is shown based on no change in volume being defined as 0%. The numerical value of the volume change shows to what extent the electrode active material (negative electrode active material) at full charge expands, as compared with the electrode active material (negative electrode active material) at full discharge. The volume change is calculated according to the following formula:

$$\text{(Volume at fully charge)-(Volume at full discharge)/(volume at full discharge)} \times 100.$$

Examples of electrode active materials (negative electrode active materials) that satisfy such volume changes include carbon materials, such as natural graphite, artificial graphite, and amorphous carbon; and lithium composite titanium oxides (such as $Li_2TiO_3$). The volume change of these materials varies depending on the type of material and charge-discharge depth. For example, the volume change of graphite is around 10% and the volume change of amorphous carbon is about several percent. If multiple electrode active materials (negative electrode active materials) are used, the average volume change of the electrode active materials (negative electrode active materials) is preferably within the range described above.

The shape of the electrode active material (negative electrode active material) is not particularly limited. The electrode active material can be in various shapes, such as spherical, scaly, lumpy, fibrous, whisker-shaped, fragmented, or like shapes. Electrode active materials (negative electrode active materials) of multiple shapes can also be used in combination. The spherical shape may be true spherical, elliptical, or like shapes.

The particle size of the electrode active material (negative electrode active material) is not particularly limited. From the viewpoint of easily collecting current between negative electrode active material particles by means of a small amount of carbon nanotube and extending battery life, the electrode active material preferably has an average particle size of 0.1 to 25 pm, and more preferably 1 to 20 um. In consideration of achieving a uniform reaction at low temperatures, the average particle size of the electrode active material (negative electrode active material) can be set to a range of 0.1 to 13.0 pm, preferably 0.5 to 10.0 pm, and more preferably 1.0 to 8.0 um. The average particle size of the negative electrode active material is measured by the laser diffraction and scattering method.

The composition for forming an electrode active material layer for lithium ion secondary batteries according to the first embodiment of the present invention can collect current between active material particles and maintain the electrode shape by means of a very small amount of carbon nanotube, thus reducing the amount of electrode constituent materials (negative electrode constituent material) other than the electrode active material (negative electrode active materials), so that the composition has strength sufficient to maintain the electrode shape and it is also less likely to inhibit the transport of lithium ions. As compared to currently used compositions for forming an electrode active material layer (compositions for forming a negative electrode active material layer), the composition of the present invention has a higher content of the electrode active material (negative active material). Thus, the content of the negative electrode active material is 97.4 to 99.9 mass%, preferably 97.7 to 99.7 mass%, and more preferably 98.0 to 99.5 mass%. When multiple electrode active materials (negative electrode active materials) are used, the total amount of the negative electrode active materials is preferably adjusted to the range described above. In one composition for forming an electrode active material layer for lithium ion secondary batteries according to the first embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, in another composition for forming an electrode active material layer for lithium ion secondary batteries according to the first embodiment of the present invention (No. 2), the percentage by volume of the negative electrode active material is 96.19 to 99.98 vol%, preferably 97.00 to 99.70 vol%, and more preferably 97.50 to 99.50 vol%. When multiple electrode active materials (negative electrode active materials) are used, the total volume of the negative electrode active materials is preferably adjusted to the range described above. In the composition for forming an electrode active material layer for lithium ion secondary batteries according to the first embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

<u>[1-1-2] Carbon Nanotube</u>

The composition for forming an electrode active material layer for lithium ion secondary batteries according to the first embodiment of the present invention can collect current between active material particles and maintain the electrode shape by means of a very small amount of carbon nanotube, thus reducing the amount of electrode constituent materials (negative electrode constituent materials) other than the electrode active material (negative electrode active material), so that the composition has strength sufficient to maintain the electrode shape and it is also less likely to inhibit the transport of lithium ions, thus achieving a uniform reaction in the battery and extending battery life. Although carbon nanotubes are also a substance that inhibits the transport of lithium ions, carbon nanotubes in small amounts do not inhibit the transport of lithium ions. That is, the composition containing a small amount of carbon nanotube keeps the reaction in the battery uniform and also has strength sufficient enough to maintain the electrode shape.

Carbon nanotubes are a hollow carbon substance that comprises a graphite sheet (i.e., a carbon atom surface of a graphite structure or a single-layer graphene sheet) closed into a tubular shape and has a diameter in the nanometer-scale range and whose wall structure is a graphite structure. Carbon nanotubes whose wall structure is a single-layer graphene sheet closed into a tubular shape are called "single-walled carbon nanotubes." On the other hand, carbon nanotubes comprising a plurality of graphite sheets each closed into a tubular shape with one sheet being nested in another are called "nested multi-walled carbon nanotubes." In the present invention, both single-walled carbon nanotubes and nested multi-walled carbon nanotubes can be used. On the other hand, carbon nanotubes comprising several graphite sheets each closed in a tubular shape with one sheet being nested in another are referred to as "nested multilayer carbon nanotubes." Although single-walled carbon nanotubes and multi-layer carbon nanotubes can both be used in the present invention, single-walled carbon nanotubes are preferred in terms of easily achieving a uniform reaction in the battery and easily extending battery life due to easily having strength sufficient to maintain the electrode shape, easily collecting current between electrode active material particles (negative electrode active material particles), and being less likely to inhibit the transport of lithium ions.

Such carbon nanotubes can be used alone or in a combination of two or more.

In terms of easily increasing the number of carbon nanotubes per volume, reducing the carbon nanotube content for maintaining the electrode shape, and being less likely to inhibit the transport of lithium ions, the carbon nanotube to be used preferably has a smaller average outer diameter. Accordingly, the average outer diameter of the carbon nanotube is preferably in the range of 0.43 to 20 nm, and more preferably 0.43 to 10 nm. The average outer diameter of the carbon nanotube is measured by electron microscopy (TEM) observation. The carbon nanotube with such an average outer diameter is set to have an average inner diameter according to the average outer diameter.

The longer the average length of carbon nanotube, the more easily the composition has strength sufficient to maintain the electrode shape and to collect current between negative active material particles. On the other hand, from the viewpoint of easily improving dispersibility and being less likely to inhibit the transport of lithium ions, the carbon nanotube preferably has a shorter average length. Accordingly, the average length of the carbon nanotube is preferably in the range of 0.5 to 200 pm, and more preferably 1 to 50 um. The average length of the carbon nanotube is measured by electron microscopy (SEM) observation.

The average aspect ratio of the carbon nanotube is defined as the ratio of the average length of the carbon nanotube to the average outer diameter of the carbon nanotube. The higher the average aspect ratio, the lower the content of the carbon nanotube required to have strength sufficient to maintain the electrode shape, the easier the current collection between negative active material particles is, and the less likely the composition inhibits the transport of lithium ions, thus easily achieving a uniform reaction in the battery and easily extending battery life. From these viewpoints, the average aspect ratio is preferably 25 to 200000, and more preferably 100 to 50000.

The carbon nanotube used in the present invention can be carbon nanotubes independent from each other, or an aggregate of carbon nanotubes comprising several carbon nanotubes bundled together to easily exhibit high strength as a bundle. Regardless of whether either of the above carbon nanotubes is used, current collection between active material particles and maintenance of the electrode shape can be achieved by means of a very small amount of carbon nanotube, thus reducing the amount of electrode constituent materials (negative electrode constituent materials) other than the electrode active material (negative electrode active material) in the composition, so that the composition has strength sufficient to maintain the electrode shape and it is also less likely to inhibit the transport of lithium ions, thus achieving a uniform reaction in the battery and extending battery life.

Having fewer defects in the graphene structure of carbon nanotube, that is, having a high G/D ratio in the Raman spectrum, is considered preferable from the viewpoint of suppressing the reactivity between the carbon nanotube and electrolytes. Therefore, it is preferred in the present invention that the carbon nanotube has a G/D ratio in the range of 1 to 200, and more preferably 50 to 150.

The composition for forming an electrode active material layer for lithium ion secondary batteries according to the first embodiment of the present invention (composition for forming a negative electrode active material layer for lithium ion secondary batteries) can collect current between active material particles and maintain the electrode shape by means of a very small amount of carbon nanotube, thus reducing the amount of negative electrode constituent materials other than the electrode active material (negative electrode active material), so that the composition has strength sufficient to maintain the electrode shape and it is also less likely to inhibit the transport of lithium ions, thus achieving a uniform reaction in the battery and extending battery life. Therefore, the content of the carbon nanotube is a small amount. Accordingly, the content of the carbon nanotube in the composition for forming an electrode active material layer for lithium ion secondary batteries according to the first embodiment of the present invention (No. 1) is 0.01 to 1.4 mass%, preferably 0.1 to 1.2 mass%, and more preferably 0.2 to 1.0 mass%. When multiple carbon nanotubes are used, the total amount of the carbon nanotubes is preferably within the range described above. Although carbon nanotubes are a substance that inhibits the transport of lithium ions, carbon nanotubes in an amount of about 1.2 mass% or less are less likely to inhibit the transport of lithium ions, so that the composition can keep the reaction in the battery uniform and also have strength sufficient to maintain the electrode shape. In the composition for forming an electrode active material layer for lithium ion secondary batteries according to the first embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, the percentage by volume of the carbon nanotube in the composition for forming an electrode active material layer for lithium ion secondary batteries according to the first embodiment of the present invention (No. 2) is in the range of 0.02 to 2.18 vol%, preferably 0.20 to 2.00 vol%, and more preferably 0.40 to 1.75 vol%. When multiple carbon nanotubes are used, the total volume of the carbon nanotubes is preferably within the range described above. In the composition for forming an electrode active material layer for lithium ion secondary batteries according to the first embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

[1-1-3] Electrode Constituent Materials Other Than the Electrode Active Material and the Carbon nanotube

The composition for forming an electrode active material layer for lithium ion secondary batteries according to the first embodiment of the present invention can collect current between active material particles and maintain the electrode shape by means of a very small amount of carbon nanotube as described above, thus reducing the amount of electrode constituent materials (negative electrode constituent materials) other than the electrode active material (negative electrode active material), so that the composition has strength sufficient to maintain the electrode shape and it is also less likely to inhibit the transport of lithium ions, thus achieving a uniform reaction in the battery and extending battery life.

In the present invention, electrode constituent materials (negative electrode constituent materials) other than the electrode active material (negative electrode active material) and the carbon nanotube are a generic concept that includes: substances having adhesion to an electrode active material (negative electrode active material) or an electrode current collector (negative electrode current collector) (binding agents); conductive materials other than the carbon nanotube, such as carbon black; and substances that inhibit the transport of lithium ions other than the carbon nanotube (lithium ion transport inhibitors), such as dispersants.

Such electrode constituent materials (negative electrode constituent materials) other than the electrode active material (negative electrode active material) and the carbon nanotube in the present invention include, for example, the following materials. Examples of conductive materials include acetylene black, Ketjen black, carbon black, graphene, and amorphous carbon obtained by heat treatment of an organic material. Examples of binders, thickeners, or dispersants include fluorinated polymers (e.g., polyvinylidene fluoride resins, polytetrafluoroethylene resins, and polyvinylidene fluoridehexafluoropropylene copolymers), polyolefin resins (e.g., styrene-butadiene copolymer resins and ethylene-vinyl alcohol copolymer resins), synthetic rubbers (e.g., styrene butadiene rubber, acrylonitrile butadiene rubber, and ethylene propylene diene rubber), polyacrylonitrile, polyamide, polyimide, polyacrylic acid, polyacrylic acid esters, polyvinyl ethers, carboxymethyl cellulose, carboxymethyl cellulose sodium salts, carboxymethyl cellulose ammonium, polyurethane, hydroxypropyl cellulose, hydroxyethyl cellulose, methyl cellulose, and the like. As amorphous carbon, amorphous carbon materials described below can also be used. These electrode constituent materials (negative electrode constituent materials) other than the electrode active material (negative electrode active material) and the carbon nanotube can be used alone or in a combination of two or more.

The composition for forming an electrode active material layer for lithium ion secondary batteries according to the first embodiment of the present invention can collect current between active material particles and maintain the electrode shape by means of a very small amount of carbon nanotube, thus reducing the amount of electrode constituent materials (negative electrode constituent materials) other than the electrode active material (negative electrode active material), so that the composition has strength sufficient to maintain the electrode shape and it is also less likely to inhibit the transport of lithium ions, thus achieving a uniform reaction in the battery and extending battery life. Accordingly, the composition contains no electrode constituent materials other than the electrode active material (negative electrode active material) and the carbon nanotube (negative electrode constituent materials) or contains a small amount of such electrode constituent materials. Accordingly, the content of electrode constituent materials other than the electrode active material (negative electrode active material) and the carbon nanotube (negative electrode constituent materials) in the composition for forming an electrode active material layer for lithium ion secondary batteries according to the first embodiment of the present invention (No. 1) is 0 to 1.2 mass%, preferably 0.2 to 1.1 mass%, and more preferably 0.4 to 1.0 mass%. When multiple electrode constituent materials other than the electrode active material (negative electrode active material) and the carbon nanotube (negative electrode constituent materials) are used, the total amount of the negative electrode active materials is preferably adjusted to the range described above. Although the electrode constituent materials other than the electrode active material (negative electrode active material) and the carbon nanotube (negative electrode constituent materials) are a substance that inhibits the transport of lithium ions, the electrode constituent materials in an amount of around 1.2 mass% or less are less likely to inhibit the transport of lithium ions, so that the composition comprising such electrode constituent materials in a small amount can keep the reaction in the battery uniform and also have strength sufficient to maintain the electrode. In the composition for forming a negative electrode active material layer for lithium ion secondary batteries according to the first embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, the percentage by volume of electrode constituent materials other than the electrode active material (negative electrode active material) and the carbon nanotube (negative electrode constituent materials) in the composition for forming an electrode active material layer for lithium ion secondary batteries according to the first embodiment of the present invention (No. 2) is 0 to 1.63 vol%, preferably 0.20 to 1.50 vol%, and more preferably 0.40 to 1.40 vol%. When multiple electrode active materials (negative electrode active materials) are used, the total volume of the electrode active materials is preferably adjusted to the range described above. In the composition for forming an electrode active material layer for lithium ion secondary batteries according to the first embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

[1-1-4] Composition for Forming an Electrode Active Material Layer for Lithium Ion Secondary Batteries

In the composition for forming an electrode active material layer for lithium ion secondary batteries (composition for forming a negative electrode active material layer) according to the first embodiment of the present invention, when the electrode active material (negative electrode active material), carbon nanotube, and electrode constituent materials other than the electrode active material (negative electrode active material) and the carbon nanotube (negative electrode constituent materials) are mixed to produce a paste composition for forming a positive electrode active material layer for lithium ion secondary batteries, the mixture can be formed into a paste by incorporating one or more solvents such as water, alcohols (e.g., methanol, ethanol, n-propyl alcohol, and isopropyl alcohol), acetone, N-methylpyrrolidone, dimethylsulphoxide, dimethylformamide, and like organic solvents. In this case, the content of each component is indicated by a numerical value calculated based on the total amount of the electrode active material (negative electrode active material), carbon nanotube, and electrode constituent materials (negative electrode constituent materials) other than the electrode active material (negative electrode active material) and the carbon nanotube, i.e., the total solids content, taken as 100 mass% or 100 vol%.

The method for producing the composition for forming an electrode active material layer for lithium ion secondary batteries according to the first embodiment of the present invention (composition for forming a negative electrode active material layer) is not particularly limited. The composition for forming an electrode active material layer for lithium ion secondary batteries according to the present invention can be produced, for example, by mixing each of the above components in a usual method. Mixing can be performed by mixing all the components simultaneously or sequentially.

(1-2) Composition for Forming an Electrode Active Material Layer for Lithium Ion Secondary Batteries (Second Embodiment)

The composition for forming an electrode active material layer for lithium ion secondary batteries according to the second embodiment of the present invention (No. 1) is a composition for forming an electrode active material layer for lithium ion secondary batteries, the composition comprising an electrode active material and a carbon nanotube, wherein the electrode active material has an average particle size of 0.1 to 13.0 μm, the content of the electrode active material is 96.6 to 99.9 mass%, the content of the carbon nanotube is 0.01 to 1.4 mass%, the content of electrode constituent materials other than the electrode active material and the carbon nanotube is 0 to 2.0 mass%, and the composition is a composition for forming a negative electrode active material layer for lithium ion secondary batteries. In the composition for forming an electrode active material layer for lithium ion secondary batteries according to the second embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%. Similarly, the composition for forming an electrode active material layer for lithium ion secondary batteries according to the second embodiment of the present invention (No. 2) is a composition for forming an electrode active material layer for lithium ion secondary batteries, the composition comprising an electrode active material and a carbon nanotube, wherein the percentage by volume of the electrode active material is 96.19 to 99.98 vol%, the percentage by volume of the carbon nanotube is 0.02 to 2.18 vol%, the percentage by volume of electrode constituent materials other than the electrode active material and the carbon nanotube is 0 to 1.63 vol%, and the composition is a composition for forming a negative electrode active material layer. In the composition for forming an electrode active material layer for lithium ion secondary batteries according to the second embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

When the particle size of the electrode active material (negative electrode active material) is reduced, interfaces between particles of the electrode active material (negative electrode active material) increase, thus resulting in more starting points for structural collapse. Therefore, conventionally, it has been even more difficult to significantly reduce the amount of electrode constituent materials (negative electrode constituent materials) other than the electrode active material (negative electrode active material). In the second embodiment of the present invention, based on the structural features described above, although a reduced particle size of the electrode active material (negative electrode active material) increases interfaces between particles of the electrode active material (negative electrode active material) and thus increases the number of starting points for structural collapse, even if the amount of the electrode constituent materials (negative electrode constituent materials) other than the electrode active material (negative electrode active material) is reduced, a very small amount of carbon nanotube can collect current between active material particles and maintain the electrode shape, so that the composition can have strength sufficient to maintain the electrode shape. Further, in the present invention, a reduced particle size of the electrode active substance (negative electrode active substance) increases the reaction area and thus reduces lithium ion flux per unit area, and particularly reduces the risk of lithium precipitation under high load conditions or in long-term use, and the amount of electrode constituent materials (negative electrode component materials) other than the electrode active material (negative electrode active material) is also significantly reduced, thus significantly improving life characteristics. That is, the composition for forming an electrode active material layer for lithium ion secondary batteries according to the second embodiment of the present invention (composition for forming a negative electrode active material layer for lithium ion secondary batteries) can be used to reduce uneven reaction distribution in a lithium-ion battery.

[1-2-1] Electrode Active Material

The electrode active material (negative electrode active material) is not particularly limited and can be a material that can be used as an electrode active material (negative electrode active material) in lithium ion secondary batteries, i.e., a material capable of absorbing and releasing lithium ions. Examples of usable materials include carbon materials, such as natural graphite, artificial graphite, and amorphous carbon; metal materials capable of being alloyed with lithium, such as Si, Al, Sn, Pb, Zn, Bi, In, Mg, Ga, Si alloys, Sn alloys, and Al alloys; metal oxides capable of absorbing and releasing lithium ions, such as $SiO_x$ (0<x<2), $SnO_x$ (0<x<2), Si, $Li_2TiO_3$, and vanadium oxides; and composite materials containing a metal material and a carbon material, such as Si-C composites and Sn-C composites. The amorphous carbon can be an amorphous carbon material described below. Such electrode active materials (negative electrode active materials) can be used alone or in a combination of two or more. In particular, when a conductive material, such as a carbon material, is used as the electrode active material (negative electrode active material), the electrode active material (negative electrode active material) also acts as a conducting material, and the content of substances that inhibit transport of lithium ions can be particularly easily reduced.

The shape of the electrode active material (negative electrode active material) is not particularly limited and can be selected from various shapes, such as spherical, scaly, lumpy, fibrous, whisker-shaped, fragmented, or other shapes. Electrode active materials (negative electrode active materials) of multiple shapes can also be used in combination. The spherical shape may be true spherical, or may be elliptical or like shapes.

The average particle size of the electrode active material (negative electrode active material) is 0.1 to 13.0 pm, preferably 0.5 to 10.0 pm, and more preferably 1.0 to 8.0 um. When the electrode active material (negative electrode active material) has an average particle size of less than 0.1 pm, aggregation is unavoidable and the flux of lithium ions per unit area is instead increased, resulting in deterioration of life characteristics. On the other hand, when the average particle size of the electrode active material (negative electrode active material) is more than 13.0 um, the uniformity of the reaction, in particular at low temperatures, still has room for improvement. The average particle size of the negative electrode active material is measured by the laser diffraction and scattering method.

In view of particularly suppressing the volume change of the electrode active material (negative electrode active material) during charge and discharge, easily suppressing a decrease in capacity due to volume change, and in particular, easily improving charge-discharge cycle characteristics, the volume change of the electrode active material (negative electrode active material), such as those described above, during charge and discharge is preferably 50% or less, and more preferably 20% or less. The smaller the volume change, the better. There is no lower limit. If the lower limit is set, it will be 0%. In numerical values of the volume change, 0% means no change in volume. The numerical value of the volume change shows to what extent the electrode active material (negative electrode active material) at full charge expands, as compared with the electrode active material (negative electrode active material) at full discharge. The volume change is calculated according to the following formula:

$$(\text{Volume at full charge}) - (\text{Volume at full discharge}) / (\text{Volume at full discharge}) \times 100.$$

The electrode active material (negative electrode active material) that satisfies such a volume change includes carbon materials, such as natural graphite, artificial graphite, and amorphous carbon; lithium composite titanium oxides (such as $Li_2TiO_3$); and the like. The volume change of such materials varies depending on the type of material and charge-discharge depth. For example, the volume change of graphite is around 10%, and that of amorphous carbon is about several percent. If multiple electrode active materials (negative electrode active materials) are used, the average volume change of the electrode active materials (negative electrode active materials) is preferably within the range described above.

In the composition for forming an electrode active material layer for lithium ion secondary batteries (composition for forming a negative electrode active material layer for lithium ion secondary batteries) according to the second embodiment of the present invention, although a reduced particle size of the electrode active material (negative electrode active material) increases interfaces between particles of the electrode active material (negative electrode active material) and increases the number of starting points for structural collapse, even if the amount of electrode constituent materials (negative electrode constituent materials) other than the electrode active material (negative electrode active materials) is reduced, a very small amount of carbon nanotube can collect current between active material particles and maintain the electrode shape, so that the composition can have strength sufficient to maintain the electrode (negative electrode) shape. Further, in the present invention, a reduced particle size of the electrode active substance (negative electrode active substance) increases the reaction area, thus reducing lithium ion flux per unit area and particularly reducing lithium precipitation under high load conditions or in long-term use, and the amount of electrode constituent materials (negative electrode component materials) other than the electrode active material (negative electrode active material) is also significantly reduced, thus significantly improving life characteristics. Therefore, as compared to currently used compositions for forming an electrode active material layer for lithium ion secondary batteries (composition for forming a negative electrode active material layer for lithium ion secondary batteries), the composition for forming an electrode active material layer for lithium ion secondary batteries (composition for forming a negative electrode active material layer for lithium ion secondary batteries) according to the second embodiment of the present invention has a high electrode active material (negative electrode active material) content. Accordingly, the content of the electrode active material (negative electrode active material) in the composition for forming an electrode active material layer for lithium ion secondary batteries according to the second embodiment of the present invention (No. 1) is 96.6 to 99.9 mass%, preferably 97.6 to 99.8 mass%, and more preferably 98.2 to 99.7 mass%. When multiple electrode active materials (negative electrode active materials) are used, the total amount of the electrode active materials is preferably adjusted to the range described above. In the composition for forming an electrode active material layer for lithium ion secondary batteries according to the second embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, the composition for forming an electrode active material layer for lithium ion secondary batteries according to the second embodiment of the present invention (No. 2) has an electrode active material (negative electrode active material) of 93.38 to 99.98 vol%, preferably 95.00 to 99.70 vol%, and more preferably 96.00 to 99.50 vol%. When multiple electrode active materials (negative electrode active materials) are used, the total volume of the electrode active materials is preferably adjusted to the range described above. In the composition for forming a negative electrode active material layer for lithium ion secondary batteries according to the second embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

[1-2-2] Carbon Nanotubes

The composition for forming an electrode active material layer for lithium ion secondary batteries according to the second embodiment of the present invention (composition for forming a negative electrode active material layer for lithium ion secondary batteries) can collect current between active material particles and maintain the electrode shape by means of a very small amount of carbon nanotube. As a result, although a reduced particle size of the electrode active material (negative electrode active material) increases interfaces between particles of the electrode active material (negative electrode active material) and thus increases the number of starting points for structural collapse, even if the amount of electrode constituent materials (negative electrode constituent materials) other than the electrode active material (negative electrode active materials) is reduced, the composition can have strength sufficient to maintain the electrode (negative electrode) shape, and a reduced particle size of the electrode active substance (negative electrode active substance) increases the reaction area, thus reducing lithium ion flux per unit area and particularly reducing the risk of lithium precipitation under high load conditions or in long-term use, and the amount of electrode constituent materials (negative electrode component materials) other than the electrode active material (negative electrode active material) is also significantly reduced, thus significantly improving life characteristics. Although carbon nanotubes are also a substance that inhibits the transport of lithium ions, carbon nanotubes in a small amount do not inhibit the transport of lithium ions. That is, the composition comprising a small amount of carbon nanotube keeps the reaction in the battery uniform and also has strength sufficient to maintain the electrode (negative electrode) shape.

Usable carbon nanotubes can be the same as those explained above in [1-1-2].

The composition for forming an electrode active material layer for lithium ion secondary batteries (composition for forming a negative electrode active material layer for lithium ion secondary batteries) according to the second embodiment of the present invention can collect current between particles of the electrode active material and maintain the electrode shape by means of a very small amount of carbon nanotube. As a result, although a reduced particle size of the electrode active material (negative electrode active material) increases interfaces between particles of the electrode active material (negative electrode active material) and thus increases the number of starting points for structural collapse, even if the amount of electrode constituent materials (negative electrode constituent material) other than the electrode active material (negative electrode active material) is reduced, the resulting composition has strength sufficient to maintain the electrode (negative electrode) shape, and a reduced particle size of the electrode active substance (negative electrode active substance) increases the reaction area, thus reducing lithium ion flux per unit area and particularly reducing the risk of lithium precipitation under high load conditions or in long-term use, and the amount of electrode constituent materials (negative electrode component materials) other than the electrode active material (negative electrode active material) is significantly reduced, thus significantly improving life characteristics. Therefore, in the composition for forming an electrode active material layer for lithium ion secondary batteries (composition for forming a negative electrode active material layer for lithium ion secondary batteries) according to the second embodiment of the present invention, the content of the carbon nanotube is a small amount. Accordingly, the content of the carbon nanotube in the composition for forming an electrode active material layer for lithium ion secondary batteries according to the second embodiment of the present invention (No. 1) is 0.01 to 1.4 mass%, preferably 0.1 to 1.2 mass%, and more preferably 0.2 to 1.0 mass%. When multiple carbon nanotubes are used, the total amount of the carbon nanotubes is preferably within the range described above. Although carbon nanotubes are also a substance that inhibits the transport of lithium ions, the presence of carbon nanotubes in an amount of about 1.4 mass% or less in addition to a small particle size of the electrode active material (negative electrode active material) is less likely to inhibit the transport of lithium ions, and the composition comprising such a small amount of carbon nanotube can keep the reaction in the battery uniform and also have strength sufficient to maintain the electrode (negative electrode) shape. In the composition for forming an electrode active material layer for lithium ion secondary batteries according to the second embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, in the composition for forming an electrode active material layer for lithium ion secondary batteries according to the second embodiment of the present invention (No. 2), the percentage by volume of the carbon nanotube is in the range of 0.02 to 2.18 vol%, preferably 0.20 to 2.00 vol%, and more preferably 0.40 to 1.75 vol%. When multiple carbon nanotubes are used, the total volume of the carbon nanotubes is preferably adjusted to the range described above. In the composition for forming an electrode active material layer for lithium ion secondary batteries according to the second embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

[1-2-3] Electrode Constituent Materials Other Than the Electrode Active Material and the Carbon Nanotube

The composition for forming an electrode active material layer for lithium ion secondary batteries (composition for forming a negative electrode active material layer) according to the second embodiment of the present invention can collect current between active material particles and maintain the electrode shape by means of a very small amount of carbon nanotube. As a result, although a reduced particle size of the electrode active material (negative electrode active material) increases interfaces between particles of the electrode active material (negative electrode active material) and thus increases the number of starting points for structural collapse, even if the amount of electrode constituent materials (negative electrode constituent materials) other than the electrode active material (negative electrode active material) is reduced, the resulting composition has strength sufficient to maintain the shape of the electrode (negative electrode), and a reduced particle size of the electrode active substance (negative electrode active substance) increases the reaction area, thus reducing lithium ion flux per unit area and particularly reducing the risk of lithium precipitation under high load conditions and in long-term use, and the amount of electrode constituent materials (negative electrode component materials) other than the electrode active material (negative electrode active material) is significantly reduced, thus significantly improving life characteristics.

In the present invention, the electrode constituent materials (negative electrode constituent materials), and the electrode constituent materials (negative electrode constituent materials other than the carbon nanotube can be the same as those as described above in [1-1-3].

The composition for forming an electrode active material layer for lithium ion secondary batteries (composition for forming a negative electrode active material layer for lithium ion secondary batteries) according to the second embodiment of the present invention can collect current between active material particles and maintain the electrode shape by means of a very small amount of carbon nanotube. As a result, although a reduced particle size of the electrode active material (negative electrode active material) increases interfaces between particles of the electrode active material (negative electrode active material) and thus increases the number of starting points for structural collapse, even if the amount of electrode constituent materials (negative electrode constituent material) other than the electrode active material (negative electrode active material) is reduced, the resulting composition has strength sufficient to maintain the electrode (negative electrode) shape, and a reduced particle size of the electrode active substance (negative electrode active substance) increases the reaction area, thus reducing lithium ion flux per unit area and particularly reducing the risk of lithium precipitation under high load conditions or in long-term use, and the amount of electrode constituent materials (negative electrode component materials) other than the electrode active material (negative electrode active material) is significantly reduced, thus significantly improving life characteristics. Therefore, the composition of the present invention contains no electrode constituent materials (negative electrode constituent materials) other than the electrode active substance (negative electrode active substance) and the carbon nanotube, or contains a small amount of such electrode constituent materials. Accordingly, in the composition for forming an electrode active material layer for lithium ion secondary batteries according to the second embodiment of the present invention (No. 1), the content of electrode constituent materials other than the electrode active material (negative electrode active material) and the carbon nanotube (negative electrode constituent materials) is 0 to 2.0 mass%, preferably 0 to 1.2 mass%, and more preferably 0 to 0.8 mass%. When multiple electrode constituent materials other than the electrode active material (negative electrode active material) and the carbon nanotube (negative electrode constituent materials) are used, the total amount of the electrode constituent materials is preferably adjusted to the range described above. Although the electrode constituent materials other than the electrode active material (negative electrode active material) and the carbon nanotube (negative electrode constituent materials) are a substance that inhibits the transport of lithium ions, the presence of the electrode constituent materials in an amount of about 2.0 mass% or less in addition to a small particle size of the electrode active material (negative electrode active material) is less likely to inhibit the transport of lithium ions also and the resulting composition can keep the reaction in the battery uniform and also have strength sufficient to maintain the electrode (negative electrode) shape. In the composition for forming an electrode active material layer for lithium ion secondary batteries according to the second embodiment of the present invention (No. 1), the total amount of the electrode active material (negative electrode active material), carbon nanotube, and electrode constituent materials other than the electrode active material (negative electrode active material) and the carbon nanotube (negative electrode constituent materials) (the total amount of the composition) is 100 mass%.

For the same reason, in the composition for forming an electrode active material layer for lithium ion secondary batteries according to the second embodiment of the present invention (No. 2), the percentage by volume of the electrode constituent materials (negative electrode constituent materials) other than the electrode active material (negative electrode active material) and the carbon nanotube is in the range of 0 to 4.52 vol%, preferably 0 to 2.00 vol%, and more preferably 0 to 1.20 vol%. When multiple electrode active materials (negative electrode active materials) are used, the total volume of the electrode active materials is preferably adjusted to the range described above. In the composition for forming an electrode active material layer for lithium ion secondary batteries according to the second embodiment of the present invention (No. 2), the total amount of the electrode active material (negative electrode active material), carbon nanotube, and electrode constituent materials other than the electrode active material (negative electrode active material) and the carbon nanotube (negative electrode constituent materials) (the total mass of the composition) is 100 vol%.

[1-2-4] Composition for Forming an Electrode Active Material Layer for Lithium Ion Secondary Batteries

In the composition for forming an electrode active material layer for lithium ion secondary batteries (composition for forming a negative electrode active material layer for lithium ion secondary batteries) according to the second embodiment of the present invention, when the electrode active material (negative electrode active material), carbon nanotube, and electrode constituent materials other than the electrode active material (negative electrode active material) and the carbon nanotube (negative electrode constituent materials) are mixed to produce a paste composition for forming an electrode active material layer for lithium ion secondary batteries (a paste composition for forming a negative electrode active material layer for lithium ion secondary batteries), the mixture can be formed into a paste by incorporating one or more solvents such as water, alcohols (e.g., methanol, ethanol, n-propyl alcohol, and isopropyl alcohol), acetone, N-methylpyrrolidone, dimethylsulphoxide, dimethylformamide, and like organic solvents. In this case, the content of each component is indicated by a numerical value based on the total amount of the electrode active material (negative electrode active material), carbon nanotube, and electrode constituent materials other than the electrode active material (negative electrode active material) and the carbon nanotube (negative electrode constituent materials), i.e., the total solids content taken as 100 mass% or 100 vol%.

The method for producing the composition for forming an electrode active material layer for lithium ion secondary batteries (composition for forming a negative electrode active material layer for lithium ion secondary batteries) according to the second embodiment of the present invention is not particularly limited. The composition for forming an electrode active material layer for lithium ion secondary batteries (composition for forming a negative electrode active material layer for lithium ion secondary batteries) according to the second embodiment of the present invention can be produced, for example, by mixing each of the above components in a usual method. Mixing can be performed by mixing all the components simultaneously or sequentially.

(1-3) Composition for Forming an Electrode Active Material Layer for Lithium Ion Secondary Batteries (Third Embodiment)

The composition for forming an electrode active material layer for lithium ion secondary batteries according to the third embodiment of the present invention (No. 1) is a composition for forming an electrode active material layer for lithium ion secondary batteries, the composition comprising an electrode active material and a carbon nanotube, wherein the content of the electrode active material is 88.6 to 99.9 mass%, the content of the carbon nanotube is 0.01 to 1.4 mass%, the content of conductive aids other than the carbon nanotube is 0 to 10.0 mass%, the composition contains no electrode constituent materials other than the electrode active material, the carbon nanotube, and the conductive aids other than the carbon nanotube, and the composition is a composition for forming a positive electrode active material layer for lithium ion secondary batteries. In the composition for forming an electrode active material layer for lithium ion secondary batteries according to the third embodiment of the present invention (No. 1), the total amount of the electrode active material (positive electrode active material), the carbon nanotube, and the conductive aids other than the electrode active material (positive electrode active material) and the carbon nanotube (the total amount of the composition) is 100 mass%. Similarly, the composition for forming an electrode active material layer for lithium ion secondary batteries according to the third embodiment of the present invention (No. 2) is a composition comprising an electrode active material and a carbon nanotube, wherein the percentage by volume of the electrode active material is in the range of 75.06 to 99.97 vol%, the percentage by volume of the carbon nanotube is 0.03 to 4.55 vol%, the percentage by volume of the conductive aids other than the carbon nanotube is 0 to 21.56 vol%, and the composition is a composition for forming a positive electrode active material layer for lithium ion secondary batteries. In the composition for forming an electrode active material layer for lithium ion secondary batteries according to the third embodiment of the present invention (No. 2), the total amount of the electrode active material (positive electrode active material), carbon nanotube, and conductive aids other than the carbon nanotube (the total volume of the composition) is 100 vol%.

Based on such structural features, the composition of the present invention can retain sufficient strength to maintain the electrode shape and also suppress the inhibition of lithium ion transport by reducing the mass of lithium ion inhibitors, thus achieving a uniform reaction in the battery and extending battery life. That is, the composition for forming an electrode active material layer for lithium ion secondary batteries (composition for forming a negative electrode active material layer for lithium ion secondary batteries) according to the third embodiment of the present invention can be used to reduce uneven reaction distribution in a lithium-ion secondary battery.

[1-3-1] Electrode Active Material

The electrode active material (positive electrode active material) is not particularly limited and can be a material that can be used as an electrode active material (positive electrode active material) in a lithium ion secondary battery, i.e., a material capable of absorbing and releasing lithium ions. Examples include lithium transition metal composite oxides having an $\alpha$-$NaFeO_2$-type crystal structure, lithium transition metal oxides having a spinel-type crystal structure, polyanionic compounds, chalcogen compounds, sulfur, and the like. Examples of lithium transition metal complex oxides having an $\alpha$-$NaFeO_2$-type crystal structure include Li $[Li_{x1}Ni_{\gamma1}Mn_{\beta1}Co_{(1-x1-\gamma1-\beta1)}]O_2$ ($0 \leq x1 < 0.5$, $0 \leq \gamma1 \leq 1$, $0 \leq \beta1 \leq 1$, $0 \leq \gamma1+\beta1 \leq 1$), $Li[Li_{x2}Ni_{\gamma2}Co_{\beta2}Al_{(1-x\leq2-\gamma2-\beta2)}]O_2$ ($0 \leq x2 < 0.5$, $0 \leq \gamma2 \leq 1$, $0 \leq \beta2 \leq 1$, $0 \leq \gamma2+\beta2 \leq 1$), and the like. Examples of the lithium transition metal oxide having a spinel-type crystal structure include $Li_{x3}Mn_2O_4$($0.9 \leq x3 < 1.5$) and $Li_{x4}Ni_{\gamma4}Mn_{(2-\gamma4)}O_4$ ($0.9 \leq x4 < 1.5$, $0 \leq \gamma4 \leq 2$). Examples of polyanion compounds include $LiFePO_4$, $LiMnPO_4$, $LiNiPO_4$, $LiCoPO_4$, $Li_3V_2(PO_4)_3$, $Li_2MnSiO_4$, $Li_2CoPO_4F$, and the like. Examples of chalcogen compounds include titanium disulfide, molybdenum disulfide, and molybdenum dioxide. Atoms or polyanions in these materials may be partially replaced by atoms or anion species comprising other elements. These electrode active materials (positive electrode active materials) can be used alone or in a combination of two or more. Among these, lithium transition metal composite oxides, such as those mentioned above, are preferable as the electrode active material (positive electrode active material) in terms of high energy density, and polyanionic compounds are preferable in terms of high safety.

The shape of the electrode active material (positive electrode active material) is not particularly limited and can be selected from various shapes such as spherical, scaly, lumpy, fibrous, whisker-shaped, fragmented, or like shapes. Positive electrode active materials of multiple shapes can also be used in combination. The spherical shape may be, for example, true spherical or oval.

The particle size of the electrode active material (positive electrode active material) is not particularly limited. In terms of easily collecting current between electrode active material particles and maintaining the electrode shape by means of a very small amount of carbon nanotube and easily extending battery life, the average particle size is preferably 0.1 to 25 pm, and more preferably 1 to 20 μm. In consideration of achieving a uniform reaction at low temperatures, the average particle size of the electrode active material (positive electrode active material) can be 0.1 to 13.0 pm, preferably 0.5 to 10.0 pm, and more preferably 1.0 to 8.0 um. The average particle size of the electrode active material (the positive electrode active material) is measured by the laser diffraction and scattering method.

The composition for forming an electrode active material layer for lithium ion secondary batteries (composition for forming a positive electrode active material layer for lithium ion secondary batteries) according to the third embodiment of the present invention can collect current between active material particles and maintain the shape of the electrode (positive electrode) by means of a very small amount of carbon nanotube. As a result, the amount of electrode constituent materials (positive electrode constituent materials) other than the electrode active material (positive electrode active material) can be reduced by not containing any electrode constituent materials (positive electrode constituent materials) other than conductive aids, so that the resulting composition can have strength sufficient to maintain the shape of the electrode (positive electrode) and it is also less likely to inhibit the transport of lithium ions, thus easily achieving a uniform reaction in the battery and extending battery life. Therefore, as compared with currently used compositions for forming an electrode active material layer (compositions for forming a positive electrode active material layer), the composition of the present invention has a high electrode active material (positive electrode active material) content. Accordingly, in the composition for forming an electrode active material layer for lithium ion secondary batteries according to the third embodiment of the present invention (No. 1), the content of the electrode active material (positive electrode active material) is 88.6 to 99.9 mass%, preferably 90.8 to 98.4 mass%, and more preferably 93.0 to 97.8 mass%. When multiple electrode active materials (positive electrode active materials) are used, the total amount of the electrode active materials is preferably adjusted to the range described above. In the composition for forming a positive electrode active material layer for lithium ion secondary batteries according to the third embodiment of the present invention (No. 1), the total amount of the electrode active material (positive electrode active material), carbon nanotube, and conductive aids other than the electrode active material (positive electrode active material) and the carbon nanotube (the total amount of the composition) is 100 mass%.

For the same reason, in the composition for forming a positive electrode active material layer for lithium ion secondary batteries according to the third embodiment of the present invention (No. 2), the percentage by volume of the electrode active material (positive electrode active material) is in the range of 75.06 to 99.97 vol%, preferably 79.20 to 94.99 vol%, and more preferably 83.63 to 93.93 vol%. When multiple electrode active materials (positive electrode active materials) are used, the total volume of the electrode active materials is preferably adjusted to the range described above. In the composition for forming an electrode active material layer for lithium ion secondary batteries according to the second embodiment of the present invention (No. 2), the total amount of the electrode active material (positive electrode active material), carbon nanotube, and conductive aids other than the carbon nanotube (the total volume of the composition) is 100 vol%.

[1-3-2] Carbon Nanotube

The composition for forming an electrode active material layer for lithium ion secondary batteries (composition for forming a positive electrode active material layer) of the present invention can collect current between active material particles and maintain the electrode (positive electrode) shape by means of a very small amount of carbon nanotube. As a result, the amount of electrode constituent materials (positive electrode constituent materials) other than the electrode active material (positive electrode active material) can be reduced by not containing any electrode constituent materials (positive electrode constituent materials) other than conductive aids, so that the resulting composition can have strength sufficient to maintain the electrode (positive electrode) shape and is also less likely to inhibit the transport of lithium ions, thus easily achieving a uniform reaction in the battery and extending battery life. Although carbon nanotubes are also a substance that inhibits the transport of lithium ions, carbon nanotubes in a small amount do not inhibit the transport of lithium ions, that is, the composition comprising a small amount of carbon nanotube can keep the reaction in the battery uniform and also have strength sufficient to maintain the electrode (positive electrode) shape.

Usable carbon nanotubes are the same as those explained above in [1-1-2].

The composition for forming an electrode active material layer for lithium ion secondary batteries (composition for forming a positive electrode active material layer for lithium ion secondary batteries) according to the third embodiment of the present invention can collect current between particles of the active material (positive electrode active material) and maintain the electrode (positive electrode) shape by means of a very small amount of carbon nanotube. As a result, the amount of electrode constituent materials (positive electrode constituent materials) other than the electrode active material (positive electrode active material) can be reduced by not containing any electrode constituent materials (positive electrode constituent materials) other than conductive aids, so that the resulting composition can have strength sufficient to maintain the electrode (positive electrode) shape and is also less likely to inhibit the transport of lithium ions, thus easily achieving a uniform reaction in the battery and extending battery life. Therefore, the carbon nanotube content of the composition is a small amount. Accordingly, in the composition for forming an electrode active material layer for lithium ion secondary batteries according to the third embodiment of the present invention (No. 1), the carbon nanotube content is 0.01 to 1.4 mass%, preferably 0.1 to 1.2 mass%, and more preferably 0.2 to 1.0 mass%. When multiple carbon nanotubes are used, the total amount of the carbon nanotubes is preferably adjusted to the range described above. Although carbon nanotubes are also a substance that inhibits the transport of lithium ions, carbon nanotubes in an amount of about 1.4 mass% or less are less likely to inhibit the transport of lithium ions, and the composition comprising such a small amount of carbon nanotube can keep the reaction in the battery uniform and also have strength sufficient to maintain the electrode (positive electrode) shape. In the composition for forming an electrode active material layer for lithium ion secondary batteries according to the third embodiment of the present invention (No. 1), the total amount of the electrode active material (positive electrode active material), carbon nanotube, and conductive aids other than the electrode active material (positive electrode active material) and the carbon nanotube (the total volume of the composition) is 100 mass%.

For the same reason, in the composition for forming an electrode active material layer for lithium ion secondary batteries according to the third embodiment of the present invention (No. 2), the percentage by volume of the carbon nanotube is in the range of 0.03 to 4.55 vol%, preferably 0.30 to 3.73 vol%, and more preferably 0.60 to 3.12 vol%. When multiple carbon nanotubes are used, the total volume of the carbon nanotubes is preferably adjusted to the range described above. In the composition for forming an electrode active material layer for lithium ion secondary batteries according to the third embodiment of the present invention (No. 2), the total amount of the electrode active material (positive electrode active material), carbon nanotube, and conductive aids other than the electrode active material (positive electrode active material) and the carbon nanotube (the total volume of the composition) is 100 vol%.

[1-3-3] Conductive Aids Other than the Carbon Nanotube

The composition for forming an electrode active material layer for lithium ion secondary batteries (composition for forming a positive electrode active material layer for lithium ion secondary batteries) according to the third embodiment of the present invention can collect current between particles of the electrode active material (positive electrode active material) and maintain the shape of the electrode (positive electrode) by means of a very small amount of carbon nanotube, so that the amount of electrode constituent materials (positive electrode constituent materials) other than the electrode active material (positive electrode active material) can be reduced by not containing any electrode constituent materials (positive electrode constituent materials) other than conductive aids. As a result, the resulting composition can have strength enough to maintain the electrode (positive electrode) shape and is also less likely to inhibit transport of lithium ions, thus easily achieving a uniform reaction in the battery and extending battery life.

However, from the standpoint of, for example, easily collecting current between particles of the electrode active material (positive electrode active material), the composition for forming an electrode active material layer for lithium ion secondary batteries (composition for forming a positive electrode active material layer for lithium ion secondary batteries) according to the third embodiment of the present invention may further contain a certain amount of conductive aid in addition to a very small amount of carbon nanotube, depending on particle morphology, particle size, particle shape, and electronic conductivity of the electrode active material (positive electrode active material). For example, when a lithium transition metal composite oxide having a secondary particle morphology is used as the electrode active material (positive electrode active material), the composition preferably contains a certain amount of conductive aid other than the carbon nanotube.

Examples of such conductive aids other than the carbon nanotube in the composition for forming an electrode active material layer for lithium ion secondary batteries (composition for forming a positive electrode active material layer for lithium ion secondary batteries) according to the third embodiment of the present invention include carbon black, such as acetylene black, furnace black, and Ketjen black; scaly graphite; graphene; amorphous carbon obtained by heat-treating an organic material; and the like. These conductive aids other than the carbon nanotube can be used alone or in a combination of two or more. In terms of being less likely to inhibit the transport of lithium ions, easily achieving a uniform reaction in the battery, and easily extending battery life, carbon black is particularly preferable.

In terms of being less likely to inhibit the transport of lithium ions, easily achieving a uniform reaction in the battery, and easily extending battery life, the content of conductive aids other than the carbon nanotube in the composition for forming an electrode active material layer for lithium ion secondary batteries according to the third embodiment of the present invention (No. 1) is 0 to 10.0 mass%, preferably 1.0 to 8.0 mass%, and more preferably 2.0 to 6.0 mass%. When multiple conductive aids other than the carbon nanotube are used, the total amount of such conductive aids is preferably adjusted to the range described above. In the composition for forming an electrode active material layer for lithium ion secondary batteries according to the third embodiment of the present invention (No. 1), the total amount of the electrode active material (positive electrode active material), carbon nanotube, and conductive aids other than the carbon nanotube (the total volume of the composition) is 100 mass%.

For the same reason, in the composition for forming an electrode active material layer for lithium ion secondary batteries according to the third embodiment of the present invention (No. 2), the percentage by volume of conductive aids other than the carbon nanotube is in the range of 0 to 21.56 vol%, preferably 2.41 to 17.52 vol%, and more preferably 4.82 to 13.49 vol%. When multiple conductive aids other than the carbon nanotube are used, the total amount of such conductive aids is preferably adjusted to the range described above. In the composition for forming an electrode active material layer for lithium ion secondary batteries according to the third embodiment of the present invention (No. 2), the total amount of the electrode active material (positive electrode active material), carbon nanotube, and conductive aids other than the carbon nanotube (the total volume of the composition) is 100 vol%.

[1-3-4] Electrode Constituent Materials Other Than the Electrode Active Material, Carbon Nanotube, and Conductive Aids Other Than the Carbon Nanotube

The composition for forming an electrode active material layer for lithium ion secondary batteries (composition for forming a positive electrode active material layer for lithium ion secondary batteries) according to the third embodiment of the present invention can collect current between particles of the active material (positive electrode active material) and maintain the shape of the electrode (positive electrode) by means of a very small amount of carbon nanotube. As a result, the amount of electrode constituent materials (positive electrode constituent materials) other than the electrode active material (positive electrode active material) can be reduced by not containing any electrode constituent materials (positive electrode constituent materials) other than the electrode active material (positive electrode active material) and conductive aids. As a result, the composition has strength sufficient to maintain the shape of the electrode (positive electrode) and is also less likely to inhibit the transport of lithium ions, thus easily achieving a uniform reaction in the battery and extending battery life.

Conventional compositions for forming an electrode active material layer for lithium ion secondary batteries (compositions for forming a positive electrode active material layer) usually contain, in addition to an electrode active material (positive electrode active material) and one or more conductive aids, a small amount of a substance that has adhesion to the electrode active material (positive electrode active material) or to an electrode current collector (positive electrode current collector) and a substance that inhibits the transport of lithium ions (lithium ion transport inhibitors), such as a dispersant.

In contrast, the composition for forming an electrode active material layer for lithium ion secondary batteries (composition for forming a positive electrode active material layer for lithium ion secondary batteries) according to the third embodiment of the present invention can collect current between particles of the active material (positive electrode active material) and maintain the shape of the electrode (positive electrode) by means of a very small amount of carbon nanotube, and so the composition can be configured to contain no electrode constituent materials (positive electrode constituent materials) other than conductive aids.

Examples of electrode constituent materials (positive electrode constituent materials) that are not contained in the composition for forming an electrode active material layer for lithium ion secondary batteries (composition for forming a positive electrode active material layer for lithium ion secondary batteries) according to the third embodiment of the present invention include, as binders, thickeners, or dispersants, fluorinated polymers (e.g., polyvinylidene fluoride resins, polytetrafluoroethylene resins, and vinylidene fluoride-hexafluoropropylene copolymers), polyolefin resins (e.g., styrene-butadiene copolymer resins and ethylene-vinyl alcohol copolymer resins), synthetic rubbers (e.g., styrene butadiene rubber, acrylonitrile butadiene rubber, and ethylene propylene diene rubber), polyacrylonitrile, polyamide, polyimide, polyacrylic acid, polyacrylic acid esters, polyvinyl ethers, carboxymethyl cellulose, carboxymethyl cellulose sodium salts, carboxymethyl cellulose ammonium, polyurethane, hydroxypropyl cellulose, hydroxyethyl cellulose, methyl cellulose, and the like.

[1-3-5] Composition for Forming an Electrode Active Material Layer for Lithium Ion Secondary Batteries

In the composition for forming an electrode active material layer for lithium ion secondary batteries (composition for forming a positive electrode active material layer for lithium ion secondary batteries) according to the third embodiment of the present invention, when the electrode active material (positive electrode active material), carbon nanotube, and conductive aids other than the carbon nanotube are mixed to form a paste composition for forming an electrode active material layer for lithium ion secondary batteries (a paste composition for forming a positive electrode active material layer for lithium ion secondary batteries), the mixture can be formed into a paste by incorporating one or more organic solvents, such as water, alcohols (e.g., methanol, ethanol, n-propyl alcohol, and isopropyl alcohol), acetone, N-methylpyrrolidone, dimethylsulphoxide, dimethylformamide, and like organic solvents. In this case, the content of each component is indicated by a numerical value based on the total amount of the electrode active material (positive electrode active material), carbon nanotube, and conductive aids other than the carbon nanotube, i.e., the total solids content taken as 100 mass% or 100 vol%.

The method for producing the composition for forming an electrode active material layer for lithium ion secondary batteries (composition for forming a positive electrode active material layer for lithium ion secondary batteries) according to the third embodiment of the present invention is not particularly limited. The composition for forming an electrode active material layer for lithium ion secondary batteries (composition for forming a positive electrode active material layer for lithium ion secondary batteries) according to the third embodiment of the present invention can be produced, for example, by mixing each of the above components in a usual method. Mixing can be performed by mixing all the components simultaneously or sequentially.

(1-4) Composition for Forming an Electrode Active Material Layer for Lithium Ion Secondary Batteries (Fourth Embodiment)

The composition for forming an electrode active material layer for lithium ion secondary batteries according to the fourth embodiment of the present invention is a composition for forming an electrode active material layer for lithium ion secondary batteries, the composition comprising an electrode active material and a carbon nanotube, wherein the electrode active material comprises an amorphous carbon material, the content of the carbon nanotube is 0.01 to 0.8 mass%, based on the total amount of the composition taken as 100 mass%, and the composition is a composition for forming a negative electrode active material layer.

When a graphite material, which has low electron conductivity, is used as the amorphous carbon material, a uniform electron conduction path needs to be formed to maintain a uniform reaction in the battery. On the other hand, when a conductive aid having a low aspect ratio, such as carbon black, is used, the amount of conductive aid required to form an electron conduction path increases, which possibly inhibits the transport of lithium ions. On the other hand, carbon nanotubes with a high aspect ratio can form a uniform electron conduction path even when used in a small amount. In this way, a combination of an amorphous carbon material and a carbon nanotube forms a uniform electron conduction path while suppressing the inhibition of lithium ion transport, thereby keeping the reaction in the battery uniform. Although carbon nanotubes are a substance that inhibits the transport of lithium ions, the carbon nanotube content in the present invention is very low, so that a reaction in the battery can be kept uniform and battery life can also be extended due to a synergistic effect with an amorphous carbon material. That is, the composition for forming an electrode active material layer for lithium ion secondary batteries (composition for forming a negative electrode active material layer) according to the fourth embodiment of the present invention can be used to reduce uneven reaction distribution in a lithium ion secondary battery.

[1-4-1] Electrode Active Material

In terms of easily achieving a uniform reaction in the battery and easily extending battery life, an amorphous layered carbon material is preferably used as an electrode active material (negative electrode active material).

In terms of easily achieving a uniform reaction in the battery and easily extending battery life, the interlayer distance between the (002) planes of the amorphous layered carbon material is preferably 0.35 nm or more, and more preferably 0.36 nm or more. The upper limit of the interlayer distance between the (002) planes of the amorphous layered carbon material is not particularly limited but is usually 0.40 nm. The interlayer distance of the amorphous layered carbon material is measured by the X-ray diffraction method.

In terms of easily achieving a uniform reaction in the battery and easily extending battery life, the amorphous layered carbon material preferably has an average particle size of 1 to 10 pm, and more preferably 3 to 8 um. The average particle size of the amorphous layered carbon material is measured by the laser diffraction scattering method.

Examples of amorphous carbon materials that satisfy the above conditions include hard carbon (hard carbon material), soft carbon (soft carbon material), mesophase pitch carbide, and the like. These amorphous carbon materials can be used alone or in a combination of two or more. In terms of easily achieving a uniform reaction in the battery and easily extending battery life, hard carbon is preferable. In the present invention, hard carbon refers to an amorphous carbon material having an interlayer distance between the (002) planes of 0.34 nm or more when fired at 3000°C. Soft carbon refers to an amorphous carbon material having an interlayer distance between the (002) planes of less than 0.34 nm when fired at 3000°C.

The shape of the electrode active material (negative electrode active material) is not particularly limited, and can be spherical, scaly, lumpy, fibrous, whisker-shaped, fragmented, or like various shapes. Electrode active materials (negative electrode active materials) of multiple shapes can also be used in combination. The spherical shape may be, for example, true spherical or oval.

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus achieving a uniform reaction in the battery and extending battery life. In the present invention, the content of the electrode active material (negative electrode active material) is preferably 79.2 to 99.8 mass%, more preferably 83.5 to 96.4 mass%, and even more preferably 77.8 to 94.9 mass%. When multiple electrode active materials (negative electrode active materials) are used, the total amount of the negative electrode active materials is preferably adjusted to the range described above. In the composition for forming an electrode active material layer for lithium ion secondary batteries (composition for forming a negative electrode active material layer for lithium ion secondary batteries) according to the fourth embodiment of the present invention, the total amount of the electrode active material (negative electrode active material), carbon nanotube, conductive aids other than the carbon nanotube, and the electrode constituent materials other than the electrode active material (negative electrode active material), carbon nanotube, and conductive aids other than the carbon nanotube (negative electrode constituent materials) (other electrode constituent materials (negative electrode constituent materials)) (the total amount of the composition) is 100 mass%.

[1-4-2] Carbon Nanotube

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus easily achieving a uniform reaction in the battery and extending battery life. Although carbon nanotubes are a substance that inhibits the transport of lithium ions, carbon nanotubes in a small amount do not inhibit the transport of lithium ions, thus achieving a uniform reaction in the battery and extending battery life.

Usable carbon nanotubes can be the same as those explained above in [1-1-2].

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus easily achieving a uniform reaction in the battery and extending battery life. Therefore, the carbon nanotube content of the composition is a small amount. Accordingly, in the present invention, the carbon nanotube content is 0.01 to 0.8 mass%, preferably 0.02 to 0.5 mass%, and more preferably 0.05 to 0.2 mass%. When multiple carbon nanotubes are used, the total amount of the carbon nanotubes is preferably within the range described above. Although carbon nanotubes are a substance that inhibits the transport of lithium ions, carbon nanotubes in an amount of about 0.8 mass% or less are less likely to inhibit the transport of lithium ions and the composition containing such a small amount of carbon nanotube can keep the reaction in the battery uniform. In the composition for forming an electrode active material layer for lithium ion secondary batteries (composition for forming a negative electrode active material layer for lithium ion secondary batteries) according to the fourth embodiment of the present invention, the total amount of the electrode active material (negative electrode active material), carbon nanotube, and conductive aids other than the carbon nanotube, electrode constituent materials (negative constituent materials) other than the electrode active material (negative electrode active material), carbon nanotube, and conductive aids other than the carbon nanotube is 100 mass%.

[1-4-3] Conductive Aids Other than the Carbon Nanotube

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus easily achieving a uniform reaction in the battery and extending battery life.

However, in terms of easily collecting current between particles of the electrode active material (negative electrode active material), the composition for forming an electrode active material layer for lithium ion secondary batteries (composition for forming a negative electrode active material layer for lithium ion secondary batteries) according to the fourth embodiment of the present invention may further contain a certain amount of conductive aid in addition to a very small amount of carbon nanotube, depending on particle morphology, particle size, particle shape, and electronic conductivity of the amorphous carbon material. For example, if an amorphous carbon material comprising spherical particles is used as an electrode active material (negative electrode active material), containing a certain amount of conductive aid in addition to carbon nanotube is preferable.

Usable conductive aids other than the carbon nanotube can be the same as those explained above in [1-3-3].

When the composition of the present invention contains a conductive aid other than the carbon nanotube, the content of the conductive aid other than the carbon nanotube is preferably 0.1 to 10.0 mass%, more preferably 1.0 to 8.0 mass%, and even more preferably 2.0 to 6.0 mass%, in terms of easily achieving a uniform reaction in the battery and easily extending battery life. When multiple conductive aids other than the carbon nanotube are used, the total amount of the conductive aids other than the carbon nanotube is preferably adjusted to the range described above. In the composition for forming an electrode active material layer for lithium ion secondary batteries (composition for forming a negative electrode active material layer for lithium ion secondary batteries) according to the fourth embodiment of the present invention, the total amount of the electrode active material (negative electrode active material), the carbon nanotube, and conductive aid other than the carbon nanotube, electrode constituent materials (negative constituent materials) other than the electrode active material (negative electrode active material), carbon nanotube, and conductive aid other than the carbon nanotube is 100 mass%.

For the same reason, the content of the carbon nanotube is preferably 0.1 to 100.0 mass%, more preferably 0.5 to 50 mass%, and even more preferably 1.0 to 20.0 mass%, based on the total amount of the carbon nanotube and conductive aid other than the carbon nanotube taken as 100 mass%. When multiple conductive aids other than the carbon nanotube are used, the total amount of the conductive aids other than the carbon nanotube is preferably adjusted to the range described above.

[1-4-4] Electrode Constituent Materials Other Than the Electrode Active Material, Carbon Nanotube, and Conductive Aids Other than the Carbon Nanotube (Other Electrode Constituent Materials)

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus easily achieving a uniform reaction in the battery and extending battery life.

In the present invention, the phrase "electrode constituent materials (negative constituent materials) other than the electrode active material (negative electrode active material), carbon nanotube, and conductive aids other than the carbon nanotube (other electrode constituent materials (negative electrode constituent materials)" is a generic concept that includes substances having adhesion to the electrode active material (negative electrode active material) or an electrode current collector (negative electrode current collector) (e.g., binders) and substances that inhibit the transport of lithium ions and that are other than the carbon nanotube and conductive aids other than the carbon nanotube (lithium ion transport inhibitors), such as dispersants.

Examples of usable electrode constituent materials (negative electrode constituent materials) other than the electrode active material (negative electrode active material), carbon nanotube, and conductive aids other than the carbon nanotube (other electrode constituent materials) (negative electrode constituent materials) can be the same as those described above in [1-3-4] above. The electrode constituent materials (negative constituent materials) other than the electrode active material (negative electrode active material), carbon nanotube, and conductive aids other than the carbon nanotube (other electrode constituent materials (negative electrode constituent materials)) can be used alone or in a combination of two or more.

The composition for forming an electrode active material layer for lithium ion secondary batteries (composition for forming a negative electrode active material layer for lithium ion secondary batteries) according to the fourth embodiment of the present invention contains an amorphous carbon material as an electrode active material (negative electrode active material) and contains a very small amount of carbon nanotube, whereby a uniform electron conduction path is formed while suppressing the inhibition of lithium ion transport, thus easily achieving a uniform reaction in the battery and extending battery life. From this viewpoint, the content of the electrode constituent materials (negative electrode constituent materials) other than the electrode active material (negative electrode active material), carbon nanotube, and conductive aids other than the carbon nanotube (other electrode constituent materials (negative electrode constituent materials)) is preferably a small amount. On the other hand, in terms of easily having strength sufficient to maintain the electrode shape, the content of such electrode constituent materials is preferably above a certain level. Therefore, in the composition for forming an electrode active material layer for lithium ion secondary batteries (composition for forming a negative electrode active material layer for lithium ion secondary batteries) according to the fourth embodiment of the present invention, the content of the electrode constituent materials (negative constituent materials) other than the electrode active material (negative electrode active material), carbon nanotube, and conductive aids other than the carbon nanotube (other electrode constituent materials (negative electrode constituent materials)) is preferably 0.1 to 10.0 mass%, more preferably 1.0 to 8.0 mass%, and even more preferably 2.0 to 6.0 mass%. When multiple electrode constituent materials (negative constituent materials) other than the electrode active material (negative electrode active material), carbon nanotube, and conductive aids other than the carbon nanotube (other electrode constituent materials (negative electrode constituent materials)) are used, the total amount of such electrode constituent materials is preferably adjusted to the range described above. In the composition for forming an electrode active material layer for lithium ion secondary batteries (composition for forming a negative electrode active material layer for lithium ion secondary batteries) according to the fourth embodiment of the present invention, the total amount of the electrode active material (negative electrode active material), carbon nanotube, and conductive aids other than the carbon nanotube, the electrode constituent materials (negative constituent materials) other than the electrode active material (negative electrode active material), carbon nanotube, and conductive aids other than the carbon nanotube is 100 mass%.

[1-4-5] Composition for Forming an Electrode Active Material Layer for Lithium Ion Secondary Batteries

In the composition for forming an electrode active material layer for lithium ion secondary batteries (composition for forming a negative electrode active material layer for lithium ion secondary batteries) according to the fourth embodiment of the present invention, the electrode active material (negative electrode active material) and the carbon nanotube, optionally together with one or more conductive aids other than the carbon nanotube and optionally together with one or more electrode constituent materials (negative constituent materials) other than the electrode active material (negative electrode active material), carbon nanotube, and conductive aids other than the carbon nanotube (other electrode constituent materials (negative electrode constituent materials)) are mixed to form a paste composition for forming an electrode active material layer for lithium ion secondary batteries (a paste composition for forming a negative electrode active material layer for lithium ion secondary batteries), the mixture can be formed into a paste by incorporating one or more solvents, such as water, alcohols (e.g., methanol, ethanol, n-propyl alcohol, and isopropyl alcohol), acetone, N-methylpyrrolidone, dimethylsulphoxide, dimethylformamide, or like organic solvents. In this case, the content of each component is indicated by a numerical value based on the total amount of the electrode active material (negative electrode active material) and the carbon nanotube, and any optional components, i.e., optional conductive aids other than the carbon nanotube, and optional electrode constituent materials (negative constituent materials) other than the electrode active material (negative electrode active material), carbon nanotube, and conductive aids other than the carbon nanotube, i.e., the total solids content taken as 100 mass%.

The method for producing the composition for forming an electrode active material layer for lithium ion secondary batteries (composition for forming a negative electrode active material for lithium ion secondary batteries) according to the fourth embodiment of the present invention is not particularly limited. The composition for forming an electrode active material layer for lithium ion secondary batteries (composition for forming a negative electrode active material layer for lithium ion secondary batteries) according to the fourth embodiment of the present invention can be produced, for example, by mixing each of the above components in a usual method. Mixing can be performed by mixing all the components simultaneously or sequentially.

## 2. Electrode Active Material Layer for Lithium Ion Secondary Batteries

The electrode active material layer for lithium ion secondary batteries (negative electrode active material layer for lithium ion secondary batteries or positive electrode active material layer for lithium ion secondary batteries) of the present invention comprises the composition for forming an electrode active material layer for lithium ion secondary batteries (composition for forming a negative electrode active material layer for lithium ion secondary batteries or composition for forming a positive electrode active material layer for lithium ion secondary batteries) of the present invention.

The thickness of the electrode active material layer for lithium ion secondary batteries (negative electrode active material layer for lithium ion secondary batteries or positive electrode active material layer for lithium ion secondary batteries) of the present invention is not particularly limited. It is better for the electrode active material layer to be thinner in terms of ensuring lithium ion penetration and electrical conductivity to facilitate a uniform reaction. However, since the present invention is aimed at reducing factors that inhibit the transport of lithium ions to achieve a uniform reaction in the battery and improve its life, it is also possible to increase the thickness of the layer for energy density per electrode. Thus, the thickness of the electrode active material layer for lithium ion secondary batteries (negative electrode active material layer for lithium ion secondary batteries or positive electrode active material layer for lithium ion secondary batteries) of the present invention is preferably 1 to 300 μm, more preferably 10 to 150 μm, and even more preferably 50 to 100 μm.

The electrode active material layer for lithium ion secondary batteries (negative electrode active material layer for lithium ion secondary batteries or positive electrode active material layer for lithium ion secondary batteries) of the present invention can be produced by shaping the composition for forming an electrode active material layer for lithium ion secondary batteries (composition for forming a negative electrode active material layer for lithium ion secondary batteries or composition for forming a positive electrode active material layer for lithium ion secondary batteries) of the present invention described above into a layer. For example, when the composition for forming an electrode active material layer for lithium ion secondary batteries (composition for forming a negative electrode active material layer for lithium ion secondary batteries or composition for forming a positive electrode active material layer for lithium ion secondary batteries) of the present invention is a paste composition for forming an electrode active material layer for lithium ion secondary batteries (paste composition for forming a negative electrode active material layer for lithium ion secondary batteries or paste composition for forming a positive electrode active material layer for lithium ion secondary batteries), the paste composition can be dried to shape it into a layer by a usual method.

## 3. Electrode for Lithium Ion Secondary Batteries

The electrode for lithium ion secondary batteries (negative electrode for lithium ion secondary batteries or positive electrode for lithium ion secondary batteries) of the present invention comprises the electrode active material layer for lithium ion secondary batteries (negative electrode active material layer for lithium ion secondary batteries or positive electrode active material layer for lithium ion secondary batteries) of the present invention. Specifically, the electrode for lithium ion secondary batteries (negative electrode for lithium ion secondary batteries or positive electrode for lithium ion secondary batteries) of the present invention preferably comprises an electrode current collector (negative electrode current collector or positive electrode current collector) and the electrode active material layer for lithium ion secondary batteries (negative electrode active material layer for lithium ion secondary batteries or positive electrode active material layer for lithium ion secondary batteries) of the present invention disposed on the electrode current collector (negative electrode current collector or positive electrode current collector).

The negative electrode current collector is preferably made of a material that is electrochemically stable at the electric potential used and has high electronic conductivity, such as copper, stainless steel, nickel, or a carbon material. The negative electrode current collector may be, for example, a foil-shaped or mesh-shaped component.

The positive electrode current collector is preferably made of a material that is electrochemically stable at the electric potential used and has high electronic conductivity, such as aluminum, stainless steel, or a carbon material. The positive electrode current collector may be, for example, a foil-shaped or mesh-shaped component.

The electrode for lithium ion secondary batteries (negative electrode for lithium ion secondary batteries or positive electrode for lithium ion secondary batteries) of the present invention can be produced by shaping the composition for forming an electrode active material layer for lithium ion secondary batteries (composition for forming a negative electrode active material layer for lithium ion secondary batteries or composition for forming a positive electrode active material layer for lithium ion secondary batteries) of the present invention described above into a layer, on the electrode current collector (negative electrode current collector or positive electrode current collector). For example, when the composition for forming an electrode active material layer for lithium ion secondary batteries (composition for forming a negative electrode active material layer for lithium ion secondary batteries or composition for forming a positive electrode active material layer for lithium ion secondary batteries) of the present invention is a paste composition for forming an electrode active material layer for lithium ion secondary batteries (paste composition for forming a negative electrode active material layer for lithium ion secondary batteries or paste composition for forming a positive electrode active material layer for lithium ion secondary batteries), the electrode for lithium ion secondary batteries (negative electrode for lithium ion secondary batteries or positive electrode for lithium ion secondary batteries) of the present invention can be produced by drying the paste composition to shape it into a layer, on the electrode current collector (negative electrode current collector or positive electrode current collector), by a usual method.

## 4. Lithium Ion Secondary Battery

The lithium ion secondary battery of the present invention comprises the electrode for lithium ion secondary batteries (negative electrode for lithium ion secondary batteries or positive electrode for lithium ion secondary batteries) of the present invention described above. When the electrode for lithium ion secondary batteries of the present invention is used as the negative electrode, the positive electrode may be the electrode for lithium ion secondary batteries of the present invention or a positive electrode that is applied to known lithium ion secondary batteries. When the electrode for lithium ion secondary batteries of the present invention is used as the positive electrode, the negative electrode may be the electrode for lithium ion secondary batteries of the present invention or a negative electrode that is applied to known lithium ion secondary batteries. The lithium ion secondary battery of the present invention may also comprise an electrolyte that is applied to known lithium ion secondary batteries and a container for housing these electrode components.

When a negative electrode that is applied to known lithium ion secondary batteries is used as the negative electrode, the negative electrode is not particularly limited and may be a well-known negative electrode. An example of such a well-known negative electrode is described below.

The negative electrode current collector constituting the negative electrode is preferably made of a material that is electrochemically stable at the electric potential used and has high electronic conductivity, such as copper, stainless steel, nickel, or a carbon material. The negative electrode current collector may be, for example, a foil-shaped or mesh-shaped component.

The negative electrode active material constituting the negative electrode can generally be a material capable of absorbing and releasing lithium ions. Examples include carbon materials such as natural graphite, artificial graphite, and amorphous carbon; metal materials that can be alloyed with lithium, such as Si, Al, Sn, Pb, Zn, Bi, In, Mg, Ga, Si alloys, Sn alloys, and Al alloys; metal oxides capable of absorbing and releasing lithium ions, such as $SiO_x$ (0<x<2), $SnO_x$ (0<x<2), Si, $Li_2TiO_3$, and vanadium oxide; composite materials containing a metal material and a carbon material, such as Si-C composites and Sn-C composites; and the like. These negative electrode active materials can be used alone or in a combination of two or more. In terms of particularly suppressing the volume change of the electrode active material (negative electrode active material) during charge and discharge and particularly improving charge-discharge cycle characteristics with ease, the following materials can also be used: silicon-free materials, i.e., carbon materials; silicon-free metal materials, e.g., metal materials capable of being alloyed with lithium, such as Al, Sn, Pb, Zn, Bi, In, Mg, Ga, Sn alloys, and Al alloys; silicon-free metal oxides capable of absorbing and releasing lithium ions, such as $SnO_x$ (0<x<2), Si, $Li_2TiO_3$, and vanadium oxide; silicon-free composite materials containing a metal material and a carbon material, such as Sn-C composites; and the like. Among them, when a conductive material such as a carbon material is used as the negative electrode active material, it is particularly easy to make the negative electrode active material also function as a conducting material and reduce the content of substances that inhibit the transport of lithium ions.

In terms of particularly suppressing the volume change of the electrode active material (negative electrode active material) during charge and discharge, easily suppressing the capacity loss due to volume change, and particularly easily improving the charge-discharge cycle characteristics, the electrode active material (negative electrode active material) such as those described above preferably has a volume change during charge and discharge of 150% or less, and preferably 120% or less. The smaller the volume change of the electrode active material, the better. There is no lower limit. If the lower limit is set, it will be 0%. The numerical value of the volume change is shown based on no change in volume being defined as 0%. The numerical value of the volume change shows to what extent the electrode active material (negative electrode active material) at full charge expands, as compared with the electrode active material (negative electrode active material) at full discharge. The volume change is calculated according to the following formula:

$$(\text{Volume at full charge})-(\text{Volume at full discharge})/(\text{Volume at full discharge}) \times 100.$$

As negative electrode constituent materials, other than the negative electrode active material, that constitute the negative electrode, the same as the conductive aids other than the carbon nanotube, and other negative electrode constituent materials described above for the electrode for lithium ion secondary batteries of the present invention can be used. Their content may be content usually used.

When a positive electrode that is applied to known lithium ion secondary batteries is used as the positive electrode, the positive electrode may be any positive electrode that can supply lithium ions to the negative electrode, and a well-known positive electrode can be used. An example of the well-known positive electrode is described below.

Examples of the positive electrode current collector constituting the positive electrode include materials that are electrochemically stable at the electric potential used and have high electronic conductivity, such as aluminum, stainless steel, and carbon materials.

The positive electrode active material constituting the positive electrode may generally be a material capable of absorbing and releasing lithium ions. Examples include lithium transition metal composite oxides having an $\alpha$-$NaFeO_2$-type crystal structure, lithium transition metal oxides having a spinel-type crystal structure, polyanion compounds, chalcogen compounds, sulfur, and the like. Examples of lithium transition metal composite oxides having an $\alpha$-$NaFeO_2$-type crystal structure include $Li[Li_{x1}Ni_{\gamma1}Mn_{\beta1}Co_{(1-x1-\gamma1-\beta1)}]O_2$ ($0 \le x1 < 0.5$, $0 \le \gamma1 \le 1$, $0 \le \beta1 \le 1$, $0 \le \gamma1+\beta1 \le 1$), $Li[Li_{x2}Ni_{\gamma2}Co_{\beta2}Al_{(1-x2-\gamma2-\beta2)}]O_2$ ($0 \le x2 < 0.5$, $0 \le \gamma2 \le 1$, $0 \le \beta2 \le 1$, $0 \le \gamma2+\beta2 \le 1$), and the like. Examples of lithium transition metal oxides having a spinel-type crystal structure include $Li_{x3}Mn_2O_4$ ($0.9 \le x3 < 1.5$), $Li_{x4}Ni_{\gamma4}Mn_{(2-\gamma4)}O_4$ ($0.9 \le x4 < 1.5$, $0 \le \gamma4 \le 2$), and the like. Examples of polyanion compounds include $LiFePO_4$, $LiMnPO_4$, $LiNiPO_4$, $LiCoPO_4$, $Li_3V_2(PO_4)_3$, $Li_2MnSiO_4$, $Li_2CoPO_4F$, and the like. Examples of chalcogen compounds include titanium disulfide, molybdenum disulfide, molybdenum dioxide, and the like. Atoms or polyanions in these materials may be partially replaced by atoms or anion species comprising other elements. These positive electrode active materials can be used alone or in a combination of two or more. Among the positive electrode active materials described above, lithium transition metal composite oxides are preferable in terms of high energy density.

As positive electrode constituent materials, other than the positive electrode active material, that constitute the positive electrode, the same as the electrode constituent materials other than the electrode active material and the carbon nanotube described above for the electrode for lithium ion secondary batteries of the present invention can be used. Their content may be the same as that of electrode constituent materials other than the electrode active material and the carbon nanotube in the electrode for lithium ion secondary batteries of the present invention.

It is preferred that the electrolyte is an electrolyte in which a salt is dissolved in an aprotic organic solvent, that the electrolyte is placed between the positive electrode and the negative electrode, and that the electrolyte is impregnated and held into a separator made of a nonwoven fabric or the like to, for example, prevent a short circuit between the positive electrode and the negative electrode.

Examples of the aprotic organic solvent constituting the electrolyte include esters, such as ethylene carbonate, propylene carbonate, butylene carbonate, dimethyl carbonate, diethyl carbonate, methyl ethyl carbonate, γ-butyrolactone, methyl formate, and methyl acetate; furans, such as tetrahydrofuran and 2-methyltetrahydrofuran; ethers, such as dioxolane, diethyl ether, dimethoxyethane, diethoxyethane, and methoxyethoxyethane; dimethyl sulfoxide; sulfolanes, such as sulfolane and methylsulfolane; acetonitrile; and the like. These aprotic organic solvents can be used alone or in a combination of two or more.

Examples of the salt dissolved in such an aprotic organic solvent include lithium salts, such as lithium perchlorate, lithium tetrafluoroborate, lithium hexafluorophosphate, lithium hexafluoroarsenate, lithium trifluoromethanesulfonate, lithium halide, lithium tetrachloroaluminate, and lithium bis(fluorosulfonyl)imide. These salts can be used alone or in a combination of two or more.

Since the lithium ion secondary battery of the present invention comprises the composition for forming an electrode active material layer for lithium ion secondary batteries (composition for forming a negative electrode active material layer for lithium ion secondary batteries or composition for forming a positive electrode active material layer for lithium ion secondary batteries) of the present invention in the negative electrode and/or positive electrode, the lithium ion secondary battery of the present invention has strength high enough to maintain the shape of the electrode and is less likely to inhibit the transport of lithium ions, thus achieving a uniform reaction in the battery and extending the life of the battery. Thus, this lithium ion secondary battery can be effectively used in electric vehicle applications for car sharing, which are expected to expand in the market in the future and will require extended life, particularly for artificial intelligence electric vehicles (AIEVs).

5. Method for Evaluating Internal Resistance and Uneven Reaction Distribution of Lithium Ion Secondary Battery

In general, the resistance of the battery reaction is usually measured by AC impedance measurement. However, according to AC impedance measurement, the resistance of the battery reaction is almost the same value even when the amount of binder or carbon nanotube is changed. That is, the reaction resistance measured by AC impedance measurement is an index that does not include the effect of uneven reaction distribution and cannot evaluate the degree of uneven reaction distribution. As described above, even when the amount of binder is increased, the resistance of the battery reaction is almost the same value, and uneven reaction distribution cannot be evaluated. Thus, conventionally, a considerable amount of binder is incorporated into an electrode active material (negative electrode active material, positive electrode active material, or the like) for electrode strength, and there is no motivation to further reduce the amount of binder.

On the other hand, under high-load conditions, uneven reaction distribution is likely to occur. Thus, reaction inhibition by the binder and inhibition of the transport of lithium ions can be evaluated by measuring the internal resistance under high-load conditions.

However, under high-load conditions in the charge process, there is concern about electrodeposition of lithium on the negative electrode, and it is difficult to measure resistance accurately. Thus, it is necessary to measure internal resistance under high-load conditions in the discharge process.

Therefore, in the present invention, the battery is discharged from a state of charge (SOC) of 100% to an SOC of 90% at 25°C and 2.5 C or more, followed by 10-minute, wherein the SOC is defined according to the following formula (1):

$$\text{SOC (\%)} = \text{Remaining capacity (Ah)/Full charge capacity (Ah)} \times 100 \quad (1).$$

The increase in voltage at pause is then measured, and the internal resistance is calculated according to the following formula (2):

Internal resistance = (Increase in voltage at pause (V)/Current value during discharge (A)) $\times$ Facing area between positive electrode and negative electrode ($cm^2$) (2).

As described above, uneven reaction distribution can be easily evaluated by setting conditions in which uneven reaction distribution is likely to occur. Thus, the discharge rate is set to 2.5 C or more (preferably 2.7 to 10.0 C), which is a high-load condition, and is set to 0.3 C or more (preferably 0.4 to 4.0 C), which is a high-load condition, when the temperature is 0°C.

The SOC at the start of discharge is set to 100% for the purpose of ensuring that the state before measurement is a state in which no uneven reaction distribution occurs by sufficiently absorbing lithium ions in the negative electrode.

After discharge under these conditions, the reaction is paused, and thus, the voltage increases. Usually after 10 minutes, the increase in voltage is saturated, and the voltage remains constant. Therefore, the increase in voltage at pause can be measured after 10 minutes, and the internal resistance can be calculated according to the following formula (2):

Internal resistance = (Increase in voltage at pause (V)/Current value during discharge (A)) $\times$ Facing area between positive electrode and negative electrode ($cm^2$) (2).

The time until saturation varies depending on the temperature and discharge rate conditions. For example, the pause time can be set to 1 minute when the discharge rate is 0.5 C, and 10 minutes when the discharge rate is 3.0 C.

As a result, when the internal resistance value is large, the degree of uneven reaction distribution can be evaluated as being large, and the life can be evaluated as being short. When the internal resistance value is small, the degree of uneven reaction distribution can be evaluated as being small, and the life can be evaluated as being extended.

Specifically, when the composition for forming an electrode active material layer for lithium ion secondary batteries (composition for forming a negative electrode active material layer for lithium ion secondary batteries or composition for forming a positive electrode active material layer for lithium ion secondary batteries) of the present invention is used, the internal resistance calculated as described above at 25°C and 3.0 C is preferably 1.0 to 35.0 $\Omega\cdot cm^2$, more preferably 1.0 to 33.6 $\Omega\cdot cm^2$, and even more preferably 1.0 to 33.2 $\Omega\cdot cm^2$. In particular, when an amorphous carbon material is used as the electrode active material (in the case of the fourth embodiment described above), the internal resistance measured in the same manner is preferably 1.0 to 25.0 $\Omega\cdot cm^2$, more preferably 1.0 to 24.0 $\Omega\cdot cm^2$, and even more preferably 1.0 to 23.0 $\Omega\cdot cm^2$. When an electrode active material having an average particle size of 0.1 to 13.0 um is used as the electrode active material (in the case of the second embodiment described above), the internal resistance measured in the same manner is preferably 1.0 to 19.0 $\Omega\cdot cm^2$, more preferably 1.0 to 18.0 $\Omega\cdot cm^2$, and even more preferably 1.0 to 17.0 $\Omega\cdot cm^2$. As described above, the lower limit of the internal resistance is preferably 1.0 $\Omega\cdot cm^2$, but can be, for example, 2.0 $\Omega\cdot cm^2$ or 3.0 $\Omega\cdot cm^2$.

For example, when an electrode active material having an average particle size of 0.1 to 13.0 um is used as the electrode active material (in the case of the second embodiment described above), the internal resistance calculated as described above at 0°C and 0.5 C is preferably 1.0 to 45.0 $\Omega\cdot cm^2$, more preferably 1.0 to 40.0 $\Omega\cdot cm^2$, and even more preferably 1.0 to 38.0 $\Omega\cdot cm^2$. That is, the present invention can sufficiently reduce internal resistance and make the reaction uniform even under low-temperature conditions, in which internal resistance is likely to increase. As described above, the lower limit of the internal resistance is preferably 1.0 $\Omega\cdot cm^2$, but can be, for example, 2.0 $\Omega\cdot cm^2$ or 3.0 $\Omega\cdot cm^2$.

In the charge process described above to bring the SOC to 100%, charging at 3.0 C, which is a high-load condition, may cause electrodeposition of lithium on the negative electrode, as described above; thus, it is preferable that charge is not performed under high-load conditions. The temperature is preferably 20°C or more, at which the internal resistance is reduced. In addition, since the purpose is to achieve a state before measurement in which uneven reaction distribution does not occur by sufficiently absorbing lithium ions in the negative electrode, it is preferable to perform constant current, constant voltage charge (CCCV charge) to an upper-limit voltage corresponding to an SOC of 100% in the charge process to bring the SOC to 100% described above. The charge rate is preferably 0.01 to 1.0 C, and more preferably 0.01 to 0.75 C. As described above, the lower limit of the charge rate is preferably 0.01 C, but can be, for example, 0.02 C or 0.03 C.

Examples

The present invention is described in detail below with reference to Examples; however, the present invention is not limited to these Examples.

In the following Examples, both graphite particles and hard carbon used as negative electrode active materials have a volume change of 0% calculated according to the following formula:

(Volume at full charge) - (Volume at full discharge)/(Volume at full discharge) × 100.

First Embodiment

Comparative Examples 1 to 7

According to the formulations shown in Tables 1 and 2, graphite particles (spherical coated natural graphite; average particle size: 17 μm) as a negative electrode active material, carboxymethyl cellulose (CMC) and styrene-butadiene rubber (SBR) as other negative electrode constituent materials, and an appropriate amount of water were added and kneaded to prepare slurries. Each slurry was individually applied to copper foil (thickness: 10 μm) with a doctor blade so that the weight per unit area of the negative electrode active material layer after drying was 10.3 to 10.9 mg/cm$^2$, dried at 60°C, roll-pressed so that the density of the negative electrode active material layer was 1.3 g/cm$^3$, and dried under reduced pressure at 120°C to obtain a negative electrode.

However, in Comparative Example 7, due to insufficient strength, it was impossible to produce a negative electrode.

Examples 1 to 6 and Comparative Examples 8 and 9

According to the formulations shown in Tables 1 and 2, the graphite particles described above as a negative electrode active material, single-walled carbon nanotubes (bundled single-walled CNT aggregate; per single-walled CNT, average outer diameter: 2 nm, average length: >5 μm; G/D: 80 to 150), CMC and SBR as other negative electrode constituent materials, and an appropriate amount of water were added and kneaded to prepare slurries. Each slurry was individually applied to the copper foil described above with a doctor blade so that the weight per unit area of the negative electrode active material layer after drying was 10.3 to 10.9 mg/cm$^2$, dried at 60°C, roll-pressed so that the density of the negative electrode active material layer was 1.3 g/cm$^3$, and dried under reduced pressure at 120°C to obtain a negative electrode.

However, in Comparative Example 9, the amount of the single-walled CNTs was large relative to CMC as a dispersant, resulting in poor dispersion of the single-walled CNTs, making it impossible to produce a negative electrode.

Example 7

According to the formulations shown in Tables 1 and 2, the graphite particles described above, the single-walled CNTs described above, and an appropriate amount of N-methylpyrrolidone (NMP) were added and kneaded to prepare a slurry. The slurry was applied to the copper foil described above with a doctor blade so that the weight per unit area of the negative electrode active material layer after drying was 10.3 to 10.9 mg/cm$^2$, dried at 100°C, roll-pressed so that the density of the negative electrode active material layer was 1.3 g/cm$^3$, and dried under reduced pressure at 170°C to obtain a negative electrode.

Tables 1 and 2 show the formulations of the Examples and the Comparative Examples. Note that Table 1 shows percentages by mass and that Table 2 shows percentages by volume.

Table 1

| | Formulation (parts by mass) | | | | |
|---|---|---|---|---|---|
| | Graphite | Single-walled CNTs | CMC | SBR | Total amount of materials other than active material and CNTs |
| Comparative Example 1 | 97.50 | - | 1.00 | 1.50 | 2.50 |
| Comparative Example 2 | 98.00 | - | 1.00 | 1.00 | 2.00 |
| Comparative Example 3 | 98.50 | - | 1.00 | 0.50 | 1.50 |
| Comparative Example 4 | 97.50 | - | 2.50 | - | 2.50 |
| Comparative Example 5 | 98.50 | - | 1.50 | - | 1.50 |
| Comparative Example 6 | 99.00 | - | 1.00 | - | 1.00 |

(continued)

| | Formulation (parts by mass) | | | | |
|---|---|---|---|---|---|
| | Graphite | Single-walled CNTs | CMC | SBR | Total amount of materials other than active material and CNTs |
| Comparative Example 7 | 99.50 | - | 0.50 | - | 0.50 |
| Comparative Example 8 | 97.50 | 1.00 | 1.50 | - | 1.50 |
| Comparative Example 9 | 98.00 | 1.50 | 0.50 | - | 2.00 |
| Example 1 | 99.17 | 0.33 | 0.50 | - | 0.50 |
| Example 2 | 99.00 | 0.50 | 0.50 | - | 0.50 |
| Example 3 | 98.75 | 0.75 | 0.50 | - | 0.50 |
| Example 4 | 98.50 | 1.00 | 0.50 | - | 0.50 |
| Example 5 | 98.75 | 0.50 | 0.75 | - | 0.75 |
| Example 6 | 98.50 | 0.50 | 1.00 | - | 1.00 |
| Example 7 | 99.50 | 0.50 | - | - | - |

Table 2

| | Formulation (parts by volume) | | | | |
|---|---|---|---|---|---|
| | Graphite | Single-walled CNTs | CMC | SBR | Total amount of materials other than active material and CNTs |
| Comparative Example 1 | 95.25 | - | 1.35 | 3.40 | 4.75 |
| Comparative Example 2 | 96.36 | - | 1.36 | 2.28 | 3.64 |
| Comparative Example 3 | 97.49 | - | 1.36 | 1.15 | 2.51 |
| Comparative Example 4 | 96.59 | - | 3.41 | - | 3.41 |
| Comparative Example 5 | 97.94 | - | 2.06 | - | 2.06 |
| Comparative Example 6 | 98.63 | - | 1.37 | - | 1.37 |
| Comparative Example 7 | 99.31 | - | 0.69 | - | 0.69 |
| Comparative Example 8 | 96.40 | 1.56 | 2.04 | - | 2.04 |
| Comparative Example 9 | 96.98 | 2.34 | 0.68 | - | 0.68 |
| Example 1 | 98.80 | 0.52 | 0.69 | - | 0.69 |
| Example 2 | 98.53 | 0.78 | 0.69 | - | 0.69 |
| Example 3 | 98.14 | 1.17 | 0.69 | - | 0.69 |
| Example 4 | 97.75 | 1.56 | 0.69 | - | 0.69 |
| Example 5 | 98.19 | 0.78 | 1.03 | - | 1.03 |
| Example 6 | 97.85 | 0.78 | 1.37 | - | 1.37 |
| Example 7 | 99.21 | 0.79 | - | - | - |

Production Example: Production of Lithium Ion Secondary Batteries

Each of the negative electrodes obtained in Examples 1-7 and Comparative Examples 1-6 was used as a negative electrode.

$LiNi_{1/3}Mn_{1/3}Co_{1/3}O_2$ (NMC111; average particle size: 10 um) (93.0 wt% based on the total weight of the positive electrode composition) as a positive electrode active material, polyvinylidene fluoride (PVdF) (3.0 wt% based on the total weight of the positive electrode composition) and acetylene black (4.0 wt% based on the total weight of the positive electrode composition) as other positive electrode constituent materials, and an appropriate amount of N-methyl-2-pyrrolidone (NMP) were added and kneaded to prepare a slurry. The slurry was applied to aluminum foil (thickness: 15 μm) with a doctor blade so that the weight per unit area of the positive electrode active material layer after drying was 20.6 to 21.8 mg/cm$^2$, dried at 100°C, roll-pressed so that the density of the positive electrode active material layer was 2.55 g/cm$^3$, and dried under reduced pressure at 170°C to obtain a positive electrode.

The electrolyte used was composed of a mixture of ethylene carbonate (EC) and methyl ethyl carbonate (MEC) at a volume ratio of 3:7 as a solvent, and 1 mol/L of lithium hexafluorophosphate ($LiPF_6$) as a salt. The electrolyte was impregnated into a porous polyethylene film as a separator.

Lithium ion secondary batteries composed of the negative electrode, the positive electrode, the electrolyte, and the separator were produced. The facing area between the positive and negative electrodes of the produced lithium ion secondary batteries was 2.8 cm$^2$.

Test Example 1: Initial Charge-discharge Characteristics

A charge-discharge test was conducted to investigate the initial charge-discharge capacity of each of the produced lithium ion secondary batteries of the Examples and the Comparative Examples.

For charge and discharge, constant current, constant voltage charge (CCCV charge) was performed to an upper-limit voltage of 4.2 V at a charge rate of 0.2 C until the current value reached 0.05 C, followed by a 10-minute pause; thereafter, discharge was performed to a lower-limit voltage of 2.7 V at a discharge rate of 0.2 C, followed by a 10-minute pause. Table 3 shows the results of initial charge-discharge characteristics.

Even when the total amount of materials other than the active material and the single-walled carbon nanotubes was as low as 1.2 mass% or less (1.63 volume% or less), there was almost no effect on the initial characteristics compared with conventional lithium ion secondary batteries, in which the total amount of materials other than the active material and the single-walled carbon nanotubes is large, and the initial charge-discharge characteristics were equivalent to those of the cases in which no single-walled carbon nanotubes were contained.

Test Example 2: Measurement of Reaction Resistance

In the lithium ion secondary batteries of the Examples and the Comparative Examples, to measure resistance to the charge-discharge reaction of the graphite negative electrode active material:

$$Li^+ + 6C + e^- \rightleftarrows LiC_6$$

**[0196]** , AC impedance measurement, which is a common method of measuring reaction resistance, was performed.

The reaction resistance was analyzed by using as reaction resistance the value obtained by subtracting bulk resistance from the arc terminal resistance value, with the lowest intercept of the Z'-axis in a Nyquist plot regarded as bulk resistance. The measurement was performed under the following conditions: 25°C, state of charge (SOC): 100% based on the cell voltage, amplitude: 10 mV, and frequency: 500 kHz to 0.1 Hz. Fig. 2 shows an outline of the analysis method used in the AC impedance measurement.

Table 3 and Fig. 3 show the results of the AC impedance measurement. As a result, little difference in reaction resistance due to differences in the amount of negative electrode constituent materials other than the negative electrode active material could be confirmed. Thus, it can be understood that the reaction resistance generally evaluated is an index that does not include the effect of uneven reaction distribution and that it is impossible to evaluate uneven reaction distribution by measuring general electrode resistance.

Test Example 3: Internal Resistance under High-Load Conditions

The internal resistance of each of the lithium ion secondary batteries of the Examples and the Comparative Examples was measured by a high-load current rest method to investigate the degree of uneven reaction distribution.

Specifically, the lithium ion secondary batteries of the Examples and the Comparative Examples were subjected to constant current, constant voltage charge (CCCV charge) to an upper-limit voltage of 4.2 V, which corresponds to an SOC of 100%, at 25°C, under the conditions of a charge rate of 0.5 C and a cut off current of 0.05 C, followed by a 10-minute pause. Thereafter, discharge was performed to an SOC of 90% (for 2 minutes) at a discharge rate of 3.0 C, followed by a 10-minute pause. The state of charge (SOC) is defined according the following formula (1):

SOC (%) = Remaining capacity (Ah)/Full charge capacity (Ah) × 100 (1).

The internal resistance was then calculated using the following formula:
Internal resistance = (Increase in voltage at pause ($\Delta$V (10 min))/Current value during discharge (3C current)) × Facing area between positive electrode and negative electrode (2.8 $cm^2$).

Fig. 4 shows an outline of the analysis method used in the high-load current rest method.

Table 3 and Fig. 5 show the results of the high-load current rest method.

The results confirmed that although the reaction resistance was equivalent regardless of the total amount of materials other than the active material and the single-walled carbon nanotubes, the internal resistance under high-load conditions was dramatically reduced, i.e., uneven reaction distribution in the electrode was suppressed, by reducing the total amount of material other than the active material and the single-walled carbon nanotubes.

Table 3

| | Test Example 1 | | | Test Example 2 | Test Example 3 |
|---|---|---|---|---|---|
| | Charge capacity (mAh) | Discharge capacity (mAh) | Coulombic efficiency (%) | Reaction resistance ($\Omega \cdot cm^2$) | Internal resistance ($\Omega \cdot cm^2$) |
| Comparative Example 1 | 9.59 | 8.29 | 86.5 | 8.09 | 45.06 |
| Comparative Example 2 | 9.50 | 8.28 | 87.1 | 7.99 | 39.66 |
| Comparative Example 3 | 9.56 | 8.28 | 86.6 | 7.76 | 39.46 |
| Comparative Example 4 | 9.46 | 8.30 | 87.8 | 9.37 | 33.81 |
| Comparative Example 5 | 9.59 | 8.36 | 87.2 | 7.96 | 32.83 |
| Comparative Example 6 | 9.53 | 8.16 | 85.6 | 7.13 | 30.65 |
| Comparative Example 7 | Not measurable | Not measurable | Not measurable | Not measurable | Not measurable |
| Comparative Example 8 | 9.55 | 8.12 | 85.0 | 9.11 | 52.60 |
| Comparative Example 9 | Not measurable | Not measurable | Not measurable | Not measurable | Not measurable |
| Example 1 | 9.56 | 8.28 | 86.6 | 8.00 | 28.72 |
| Example 2 | 9.53 | 8.21 | 86.1 | 7.72 | 27.91 |
| Example 3 | 9.56 | 8.21 | 85.8 | 7.16 | 27.64 |
| Example 4 | 9.69 | 8.22 | 84.8 | 7.91 | 27.29 |
| Example 5 | 9.55 | 8.26 | 86.5 | 7.88 | 31.46 |
| Example 6 | 9.55 | 8.30 | 87.0 | 8.61 | 33.13 |
| Example 7 | 9.46 | 8.16 | 86.2 | 7.82 | 27.28 |

<u>Test Example 4: Life Characteristics</u>

The lithium ion secondary batteries of the Examples and the Comparative Examples were subjected to a charge-discharge cycle test at 45°C. The charge and discharge conditions were as follows. Constant current, constant voltage charge (CCCV charge) was performed to an upper-limit voltage of 4.2 V at a charge rate of 0.5 C until the current value reached 0.05 C, followed by a 10-minute pause. Thereafter, discharge was performed to a lower-limit voltage of 2.7 V at a discharge rate of 0.5 C, followed by a 10-minute pause. These charge and discharge processes were regarded as one cycle, and the charge-discharge cycle test was conducted. Charge and discharge to investigate the capacity of each of the lithium ion secondary batteries of the Examples and the Comparative Examples were performed every 25 cycles up to 100 cycles and every 100 cycles after 100 cycles. In the charge and discharge to investigate the capacity, constant current, constant voltage charge (CCCV charge) was performed to an upper-limit voltage of 4.2 V at a charge rate of 0.2 C until the current value reached 0.05 C, followed by a 10-minute pause; thereafter, discharge was performed to a lower-limit voltage of 2.7 V at a discharge rate of 0.2 C, followed by a 10-minute pause.

Fig. 6 shows the results of charge-discharge cycle characteristics.

The results showed that in the case in which no single-walled carbon nanotubes were contained, when the total amount of negative electrode constituent materials other than the negative electrode active material and the carbon nanotubes was 2.5 mass% and 4.75 volume% (Comparative Example 1), secondary degradation in which the rate of decrease in capacity retention relative to the number of cycles increased was observed after 200 cycles, and the capacity retention after 300 cycles was 73%. Since the proportion of the negative electrode constituent materials other than the negative electrode active material and the carbon nanotubes was large, secondary degradation, presumably due to uneven reaction distribution in the electrode, occurred. When the amount of negative electrode constituent materials other than the negative electrode active material and the carbon nanotubes was reduced to 1.0 mass% in order to suppress the uneven reaction distribution in the electrode, the strength of the electrode decreased, a sharp decrease in capacity, which was thought to be due to the isolation of the active material, was observed from the beginning of the cycles due to the volume change of the active material layer of the electrode upon charge and discharge, and the life characteristics further deteriorated. These results showed that even if a negative electrode in which the internal resistance under the high load shown in Test Example 3 is reduced i.e., uneven reaction distribution is suppressed, by reducing the total amount of negative electrode constituent materials other than the negative electrode active material and the carbon nanotubes is used in a lithium ion secondary battery, good life characteristics cannot be obtained unless the electrode has a strength high enough to follow the volume change upon charge and discharge.

In the case in which a small amount (1.4 mass% or less) of single-walled carbon nanotubes was contained, it was confirmed that a sharp decrease in capacity, which is thought to be due to the isolation of the active material described above, was not observed and that the electrode had a strength high enough to follow the volume change upon charge and discharge, even when the total amount of negative electrode constituent materials other than the negative electrode active material and the carbon nanotubes was small (1.2 mass% or less) or no negative electrode constituent materials other than the negative electrode active material and the carbon nanotubes were contained (0 mass%). It can be understood that the secondary degradation was also suppressed after 200 cycles and that the life characteristics were improved. Fig. 7 shows the results of estimating the life of the battery of Example 7 by determining the following A and $\beta$ by the least-squares method from actual measurement data, using the following formula:

$$\text{Decrease in capacity} = A \times (\text{Number of cycles})^{\beta}.$$

The capacity retention after 300 cycles in Comparative Example 1 was 73%, as described above, and the number of cycles for the battery of Example 7 to reach a capacity retention of 73% was calculated. As a result, the number of cycles for the battery of Example 7 to reach a capacity retention of 73% was estimated to be 1300 cycles, indicating about 4.3-fold improvement in battery life compared with the 300 cycles of Comparative Example 1.

Fig. 8 summarizes the results of the internal resistance of Test Example 3 and the life characteristics of Test Example 4 described above.

Second Embodiment

<u>Comparative Examples 10 and 12</u>

According to the formulations shown in Tables 4 and 5, graphite particles as a negative electrode active material, carboxymethyl cellulose (CMC) and styrene-butadiene rubbber (SBR) as other negative electrode constituent materials, and an appropriate amount of water were added and kneaded to prepare slurries. Each slurry was individually applied to copper foil (10 μm) with a doctor blade so that the weight per unit area of the negative electrode active material layer after drying was 10.3 to 10.9 mg/$cm^2$, dried at 60°C, roll-pressed so that the density of the negative electrode active material layer was 1.3 g/$cm^3$, and dried under reduced pressure at 120°C to obtain a negative electrode. As the graphite particles, coated natural graphite (average particle size: 17.0 μm) or coated natural graphite (average particle size: 5.0 μm) was used.

Examples 8 and 9 and Comparative Example 11

According to the formulations shown in Tables 4 and 5, graphite particles as a negative electrode active material, single-walled carbon nanotubes (bundled single-walled CNT aggregate; per single-walled CNT, average outer diameter: 2 nm, average length: >5 pm, G/D: 80 to 150), and an appropriate amount of N-methylpyrrolidone (NMP) were added and kneaded to prepare slurries. Each slurry was individually applied to the copper foil described above with a doctor blade so that the weight per unit area of the negative electrode active material layer after drying was 10.3 to 10.9 mg/cm$^2$, dried at 100°C, roll-pressed so that the density of the negative electrode active material layer was 1.3 g/cm$^3$, and dried under reduced pressure at 170°C to obtain a negative electrode. As the graphite particles, coated natural graphite (average particle size: 17.0 μm), coated natural graphite (average particle size: 12.0 μm), or coated natural graphite (average particle size: 5.0 μm) was used.

Examples 10 to 12

According to the formulations shown in Tables 4 and 5, graphite particles as a negative electrode active material, the single-walled CNTs described above, carboxymethyl cellulose (CMC) as another negative electrode constituent material, and an appropriate amount of water were added and kneaded to prepare slurries. Each slurry was individually applied to the copper foil described above with a doctor blade so that the weight per unit area of the negative electrode active material layer after drying was 10.3 to 10.9 mg/cm$^2$, dried at 60°C, roll-pressed so that the density of the negative electrode active material layer was 1.3 g/cm$^3$, and dried under reduced pressure at 120°C to obtain a negative electrode. As the graphite particles, coated natural graphite (average particle size: 5.0 um) was used.

Tables 4 and 5 show the formulations of the Examples and the Comparative Examples. Note that Table 4 shows percentages by mass and that Table 5 shows percentages by volume.

Table 4

| | Graphite | | Single-walled CNTs (mass%) | CMC (mass%) | SBR (mass%) | Total amount of materials other than active material and CNTs |
|---|---|---|---|---|---|---|
| | Content (mass%) | Average particle size (μm) | | | | |
| Comparative Example 10 | 97.50 | 17.0 | - | 1.00 | 1.50 | 2.50 |
| Comparative Example 11 | 99.50 | 17.0 | 0.50 | - | - | - |
| Comparative Example 12 | 97.50 | 5.0 | - | 1.00 | 1.50 | 2.50 |
| Example 8 | 99.50 | 12.0 | 0.50 | - | - | - |
| Example 9 | 99.50 | 5.0 | 0.50 | - | - | - |
| Example 10 | 99.00 | 5.0 | 0.50 | 0.50 | - | 0.50 |
| Example 11 | 98.50 | 5.0 | 0.50 | 1.00 | - | 1.00 |
| Example 12 | 98.00 | 5.0 | 0.50 | 1.50 | - | 1.50 |

Table 5

| | Graphite | | Single-walled CNTs (volume% ) | CMC (volume% ) | SBR (volume% ) | Total amount of materials other than active material and CNTs |
|---|---|---|---|---|---|---|
| | Content (volume% ) | Average particle size (μm) | | | | |
| Comparative Example 10 | 95.25 | 17.0 | - | 1.35 | 3.40 | 4.75 |
| Comparative Example 11 | 99.21 | 17.0 | 0.79 | - | - | - |

(continued)

| | Graphite | | Single-walled CNTs (volume% ) | CMC (volume% ) | SBR (volume% ) | Total amount of materials other than active material and CNTs |
|---|---|---|---|---|---|---|
| | Content (volume% ) | Average particle size (μm) | | | | |
| Comparative Example 12 | 95.25 | 5.0 | - | 1.35 | 3.40 | 4.75 |
| Example 8 | 99.21 | 12.0 | 0.79 | - | - | - |
| Example 9 | 99.21 | 5.0 | 0.79 | - | - | - |
| Example 10 | 98.53 | 5.0 | 0.78 | 0.69 | - | 0.69 |
| Example 11 | 97.85 | 5.0 | 0.78 | 1.37 | - | 1.37 |
| Example 12 | 97.17 | 5.0 | 0.78 | 2.05 | - | 2.05 |

Production Example: Production of Lithium Ion Secondary Batteries

Each of the negative electrodes obtained in Examples 8 to 12 and Comparative Examples 10 to 12 was used as a negative electrode.

$LiNi_{0.8}Co_{0\cdot15}Al_{0.05}O_2$ (NCA; average particle size: 6 um) (92.0 mass% based on the total mass of the positive electrode composition) as a positive electrode active material, polyvinylidene fluoride (PVdF) (4.0 mass% based on the total mass of the positive electrode composition) and acetylene black (4.0 mass% based on the total mass of the positive electrode composition)) as other positive electrode constituent materials, and an appropriate amount of N-methyl-2-pyrrolidone (NMP) were added and kneaded to prepare a slurry. The slurry was applied to aluminum foil (thickness: 17 μm) with a doctor blade so that the mass per unit area of the positive electrode active material layer after drying was 20.05 to 21.29 mg/cm$^2$, dried at 100°C, roll-pressed so that the density of the positive electrode active material layer was 3.0 g/cm$^3$, and dried under reduced pressure at 170°C to obtain a positive electrode.

The electrolyte used was composed of a mixture of ethylene carbonate (EC) and methyl ethyl carbonate (MEC) at a volume ratio of 3:7 as a solvent, and 1 mol/L of lithium hexafluorophosphate ($LiPF_6$) as a salt. The electrolyte was impregnated into a porous polyethylene film as a separator.

Lithium ion secondary batteries composed of the negative electrode, the positive electrode, the electrolyte, and the separator were produced. The facing area between the positive and negative electrodes of the produced lithium ion secondary batteries was 2.8 cm$^2$.

Test Example 5: Initial Charge-discharge Characteristics

A charge-discharge test was conducted to investigate the initial charge-discharge capacity of each of the produced lithium ion secondary batteries of the Examples and the Comparative Examples.

For charge and discharge, constant current, constant voltage charge (CCCV charge) was performed to an upper-limit voltage of 4.0 V at a charge rate of 0.1 C until the current value reached 0.05 C, followed by a 10-minute pause; thereafter, discharge was performed to a lower-limit voltage of 2.7 V at a discharge rate of 0.1 C, followed by a 10-minute pause. Table 6 shows the results of initial charge-discharge characteristics.

Even when the particle size of the negative electrode active material was reduced or the total amount of materials other than the negative electrode active material and the single-walled carbon nanotubes was as small as 2.0 mass% or less (4.52 volume% or less), there was almost no effect on the initial characteristics compared with the cases in which the negative electrode active material had a larger particle size or the total amount of materials other than the negative electrode active material and the single-walled carbon nanotubes was large, and comparable initial charge-discharge characteristics were exhibited.

Test Example 6: Measurement of Reaction Resistance

In the lithium ion secondary batteries of the Examples and the Comparative Examples, to measure resistance to the charge-discharge reaction of the graphite negative electrode active material:

$Li^+ + 6C + e^- \rightleftarrows LiC_6$

**[0222]** , AC impedance measurement, which is a common method of measuring reaction resistance, was performed.

The reaction resistance was analyzed by using as reaction resistance the value obtained by subtracting bulk resistance from the arc terminal resistance value, with the lowest intercept of the Z'-axis in a Nyquist plot regarded as bulk resistance. The measurement was performed under the following conditions: 25°C, state of charge (SOC): 100% based on the cell voltage, amplitude: 10 mV, and frequency: 500 kHz to 0.1 Hz. Fig. 2 shows an outline of the analysis method used in the AC impedance measurement.

Table 6 and Fig. 9 show the results of the AC impedance measurement. The results show that there were slight differences in reaction resistance due to differences in the particle size of the negative electrode active material or the amount of negative electrode constituent materials other than the negative electrode active material and that there was a tendency for reaction resistance to be reduced when the particle size of the negative electrode active material was smaller and the amount of negative electrode constituent materials other than the negative electrode active material was decreased. However, the reaction resistance generally evaluated is an index that does not include the effect of uneven reaction distribution, and it is presumably difficult to evaluate uneven reaction distribution by measuring general electrode resistance.

Test Example 7: Internal Resistance under High-Load Conditions

To investigate the degree of uneven reaction distribution, the internal resistance of the lithium ion secondary batteries of the Examples and the Comparative Examples was measured at room temperature (25°C) by a high-load current rest method, and the internal resistance of the lithium ion secondary batteries of the Examples and the Comparative Examples was measured at low temperature (0°C) by a high-load current rest method.

To measure the internal resistance at room temperature (25°C) by the high-load current rest method, the lithium ion secondary batteries of the Examples and the Comparative Examples were subjected to constant current, constant voltage charge (CCCV charge) to an upper-limit voltage of 4.0 V, which corresponds to an SOC of 100%, at room temperature (25°C), under the conditions of a charge rate of 0.5 C and a cut off current of 0.05 C, followed by a 10-minute pause. Thereafter, discharge was performed to an SOC of 90% (for 2 minutes) at a discharge rate of 3.0 C, followed by a 10-minute pause. The state of charge (SOC) is defined according to the following formula (1):

SOC (%) = Remaining capacity (Ah)/Full charge capacity (Ah) × 100 (1).

The internal resistance was then calculated using the following formula:

Internal resistance = (Increase in voltage at pause (V)/Current value during discharge (A)) × Facing area between positive electrode and negative electrode (2.8 $cm^2$)

Fig. 4 shows an outline of the analysis method used in the high-load current rest method.

To measure the internal resistance at low temperature (0°C) by the high-load current rest method, the lithium ion secondary batteries of the Examples and the Comparative Examples were subjected to constant current, constant voltage charge (CCCV charge) to an upper-limit voltage of 4.0 V, which corresponds to an SOC of 100%, at room temperature (25°C), under the conditions of a charge rate of 0.5 C and a cut off current of 0.05 C. The temperature was then changed to 0°C, followed by a 180-minute pause. Thereafter, discharge was performed to an SOC of 90% (for 12 minutes) at a discharge rate of 0.5 C, followed by a 1-minute pause. The state of charge (SOC) is defined according to the following formula (1):

SOC (%) = Remaining capacity (Ah)/Full charge capacity (Ah) × 100 (1).

The internal resistance was then calculated using the following formula:

Internal resistance = (Increase in voltage at pause ($\Delta$V(1 min))/Current value during discharge (0.5 C current)) × Facing area between positive electrode and negative electrode (2.8 $cm^2$)

Table 6 and Figs. 10 and 11 show the results of these high-load current rest methods.

The results confirmed that even though there were only slight differences in reaction resistance due to differences in the particle size of the negative electrode active material or the amount of negative electrode constituent materials other than the negative electrode active material, the internal resistance under high-load conditions was reduced, i.e., uneven reaction distribution in the electrode was suppressed, by reducing the particle size of the negative electrode active material and reducing the amount of negative electrode constituent materials other than the negative electrode active material. This tendency was particularly noticeable at low temperature, in which internal resistance tends to increase, and it can be understood that the effects of the present invention were noticeable under harsh conditions in which internal resistance tends to increase.

Table 6

| | Test Example 5 | | | Test Example 6 | Test Example 7 | |
|---|---|---|---|---|---|---|
| | Charge capacity (mAh) | Discharge capacity (mAh) | Coulombic efficiency (%) | Reaction resistance ($\Omega \cdot cm^2$) | Internal resistance (25°C) ($\Omega \cdot cm^2$) | Internal resistance (0°C) ($\Omega \cdot cm^2$) |
| Comparative Example 10 | 9.56 | 8.24 | 86.2 | 8.29 | 24.71 | 55.94 |
| Comparative Example 11 | 9.81 | 8.37 | 85.3 | 5.26 | 19.38 | 51.38 |
| Comparative Example 12 | 9.58 | 8.24 | 86.0 | 7.11 | 19.12 | 58.02 |
| Example 8 | 9.97 | 8.38 | 84.0 | 3.84 | 18.12 | 40.15 |
| Example 9 | 9.81 | 8.28 | 84.4 | 3.95 | 16.91 | 32.60 |
| Example 10 | 10.01 | 8.52 | 85.1 | 3.84 | 15.68 | 35.09 |
| Example 11 | 10.11 | 8.61 | 85.1 | 4.24 | 16.55 | 39.08 |
| Example 12 | 9.94 | 8.56 | 86.1 | 4.56 | 17.50 | 40.52 |

Test Example 8: Limit Load Characteristics

A charge-discharge cycle test was conducted on the lithium ion secondary batteries of Example 9 and Comparative Examples 10 to 12 while gradually increasing the overvoltage load from condition 1 to condition 12, as shown in Table 8. Ten cycles of charge and discharge were performed for each condition; i.e., a total of 120 cycles of charge and discharge were performed. In each charge-discharge cycle, constant current charge (CC charge) was performed to an upper-limit voltage of 4.0 V, followed by a 10-minute pause, and discharge was performed to a lower-limit voltage of 2.7 V, followed by a 10-minute pause.

The overvoltage load was then calculated according to the following formula:

Overvoltage load (mV) = Current value (mA) in the case of 1 C $\times$ Charge-discharge rate (C) $\times$ DC resistance ($\Omega$).

Then, the overvoltage load at which the capacity retention falls below 99.0% for the first time in 10 cycles of charge and discharge under each condition was evaluated as the limit overvoltage load.

Table 7 shows the DC resistance of the lithium ion secondary batteries of Example 9 and Comparative Examples 10 to 12 at different temperatures. Table 8 shows charge-discharge cycle conditions and the results of the overvoltage load under the conditions. Table 9 shows the results of the limit overvoltage load. Fig. 12 shows the results of capacity retention during charge-discharge cycles. Fig. 13 show the results of 10-cycle capacity retention relative to overvoltage load.

Table 7

| | DC resistance (Ω) | | | |
|---|---|---|---|---|
| | Comparative Example 10 | Comparative Example 11 | Comparative Example 12 | Example 9 |
| Current value (mA) in the case of 1 C | 8.40 | 8.15 | 8.10 | 8.36 |
| Temperature (°C) | | | | |
| 25 | 8.88 | 6.82 | 6.56 | 5.55 |
| 10 | 13.64 | 11.28 | 12.68 | 8.42 |
| 0 | 19.98 | 18.35 | 20.72 | 11.64 |

Table 8

| | Temperature (°C) | Charge-discharge rate (C) | Number of cycles | Overvoltage load (mV) | | | |
|---|---|---|---|---|---|---|---|
| | | | | Comparative Example 10 | Comparative Example 11 | Comparative Example 12 | Example 9 |
| Condition 1 | 25 | 0.50 | 10 | 37 | 28 | 27 | 23 |
| Condition 2 | 25 | 0.75 | 10 | 56 | 42 | 40 | 35 |
| Condition 3 | 10 | 0.50 | 10 | 57 | 46 | 51 | 35 |
| Condition 4 | 10 | 0.75 | 10 | 86 | 69 | 77 | 53 |
| Condition 5 | 0 | 0.50 | 10 | 84 | 75 | 84 | 49 |
| Condition 6 | 0 | 0.66 | 10 | 111 | 99 | 111 | 64 |
| Condition 7 | 0 | 0.75 | 10 | 126 | 112 | 126 | 73 |
| Condition 8 | 0 | 1.00 | 10 | 168 | 150 | 168 | 97 |
| Condition 9 | 0 | 1.25 | 10 | 210 | 187 | 210 | 122 |
| Condition 10 | 0 | 1.50 | 10 | 252 | 224 | 252 | 146 |
| Condition 11 | 0 | 1.75 | 10 | 294 | 262 | 294 | 170 |
| Condition 12 | 0 | 2.00 | 10 | 336 | 299 | 336 | 195 |

Table 9

| | Graphite | | Single-walled CNTs (mass%) | CMC (mass%) | SBR (mass%) | Total amount of materials other than active material and CNTs | Limit overvoltage load (mV) |
|---|---|---|---|---|---|---|---|
| | Content (mass%) | Average particle size (μm) | | | | | |
| Comparative Example 10 | 97.50 | 17.0 | - | 1.00 | 1.50 | 2.50 | 86 |
| Comparative Example 11 | 99.50 | 17.0 | 0.50 | - | - | - | 77 |
| Comparative Example 12 | 97.50 | 5.0 | - | 1.00 | 1.50 | 2.50 | 150 |
| Example 9 | 99.50 | 5.0 | 0.50 | - | - | - | 195 or more |

From the above results, it can be understood that neither reducing the particle size of the negative electrode active material nor reducing the amount of negative electrode constituent materials other than the negative electrode active material by adding a small amount of carbon nanotubes, independently, could sufficiently reduce the overvoltage load at any of the temperatures described above, and the charge-discharge cycle characteristics and the rate characteristics were also insufficient. In contrast, it can be understood that in the present invention, in which the particle size of the negative electrode active material was reduced and in which the amount of negative electrode constituent materials other than the negative electrode active material was reduced by adding a small amount of carbon nanotubes, the overvoltage load could be sufficiently reduced at any of the temperatures described above, and the charge-discharge cycle characteristics and the rate characteristics were improved. Note that in Example 9, even when the overvoltage load was increased to that in condition 12, the 10-cycle capacity retention did not fall below 99%; therefore, it can be understood that the limit overvoltage load is greater than 195 mV, which is the overvoltage load in condition 12, and thus, the value of the limit overvoltage load in Table 9 is shown as 195 or more.

Test Example 9: Life Characteristics

The lithium ion secondary batteries of Example 9 and Comparative Examples 10 and 12 were subjected to a charge-discharge cycle test at 25°C. The charge and discharge conditions were as follows. Constant current, constant voltage charge (CCCV charge) was performed to an upper-limit voltage of 4.0 V at a charge rate of 0.5 C until the current value reached 0.05 C, followed by a 10-minute pause. Thereafter, discharge was performed to a lower-limit voltage of 2.7 V at a discharge rate of 0.5 C, followed by a 10-minute pause. These charge and discharge processes were regarded as one cycle, and the charge-discharge cycle test was conducted.

Table 10 and Fig. 13 show the results of charge-discharge cycle characteristics.

Table 10

| | Graphite | | Single-walled CNTs (mass%) | CMC (mass%) | SBR (mass%) | Total amount of materials other than active material and CNTs | 120-cycle capacity retention (%) |
|---|---|---|---|---|---|---|---|
| | Content (mass%) | Average particle size (μm) | | | | | |
| Comparative Example 10 | 97.50 | 17.0 | - | 1.00 | 1.50 | 2.50 | 92.7 |
| Comparative Example 12 | 97.50 | 5.0 | - | 1.00 | 1.50 | 2.50 | 92.2 |
| Example 9 | 99.50 | 5.0 | 0.50 | - | - | - | 94.1 |

It can be understood from the results that the present invention, in which the particle size of the negative electrode active material is reduced and in which the amount of negative electrode constituent materials other than the negative electrode active material is reduced by adding a small amount of carbon nanotubes, can sufficiently reduce the overvoltage load and improve the charge-discharge cycle characteristics and rate characteristics.

Third Embodiment

Comparative Example 13

93.0 mass% of $LiNi_{1/3}Mn_{1/3}Co_{1/3}O_2$ (NMC111; average particle size: 10 μm) as a positive electrode active material, 4.0 mass% of acetylene black (AB) as a conductive aid other than carbon nanotubes, 3.0 mass% of polyvinylidene fluoride (PVdF) as another positive electrode constituent material, and an appropriate amount of N-methyl-2-pyrrolidone (NMP) were added and kneaded to prepare a slurry. The slurry was applied to aluminum foil (thickness: 15 pm) with a doctor blade so that the weight per unit area of the positive electrode active material layer after drying was 21.2 mg/cm$^2$, dried at 100°C, roll-pressed so that the density of the positive electrode active material layer was 2.55 g/cm$^3$, and dried under reduced pressure at 170°C to obtain a positive electrode.

Example 13

96.0 mass% of $LiNi_{1/3}Mn_{1/3}Co_{1/3}O_2$ (NMC111; average particle size: 10 μm) as a positive electrode active material, 0.5 mass% of single-walled carbon nanotubes (bundled single-walled CNT aggregate; per single-walled CNT, average outer diameter: 2 nm, average length: >5 um, and G/D: 80 to 150), 3.5 mass% of acetylene black (AB) as a conductive aid other than carbon nanotubes, and an appropriate amount of N-methyl-2-pyrrolidone (NMP) were added and kneaded to prepare a slurry. The slurry was applied to aluminum foil (thickness: 15 pm) with a doctor blade so that the weight per unit area of the positive electrode active material layer after drying was 20.6 mg/cm$^2$, dried at 100°C, roll-pressed so that the density of the positive electrode active material layer was 2.55 g/cm$^3$, and dried under reduced pressure at 170°C to obtain a positive electrode.

Table 11 shows the formulations of the Example and the Comparative Example.

Table 11

| | Formulation | | | |
|---|---|---|---|---|
| | NMC111 | Single-walled CNTs | AB | PVdF |
| Comparative Example 13 | 93.0 mass%<br>83.88 volume% | - | 4.0 mass%<br>8.93 volume% | 3.0 mass%<br>7.19 volume% |
| Example 13 | 96.0 mass%<br>90.28 volume% | 0.5 mass%<br>1.58 volume% | 3.5 mass%<br>8.14 volume% | - |

Production Example: Production of Lithium Ion Secondary Batteries

Each of the positive electrodes obtained in Example 13 and Comparative Example 13 was used as a positive electrode.

Graphite particles (spherical coated natural graphite; average particle size: 17 μm) (97.5 mass% based on the total weight of the negative electrode composition) as a negative electrode active material, carboxymethyl cellulose (CMC) (1.0 mass% based on the total weight of the negative electrode composition) and styrene-butadiene rubber (SBR) (1.5 mass% based on the total weight of the negative electrode composition) as other negative electrode constituent materials, and an appropriate amount of water were added and kneaded to prepare a slurry. The slurry was applied to copper foil (thickness: 10 pm) with a doctor blade so that the weight per unit area of the negative electrode active material layer after drying was 10.6 mg/cm$^2$, dried at 60°C, roll-pressed so that the density of the negative electrode active material layer was 1.3 g/cm$^3$, and dried under reduced pressure at 120°C to obtain a negative electrode.

The electrolyte used was composed of a mixture of ethylene carbonate (EC) and methyl ethyl carbonate (MEC) at a volume ratio of 3:7 as a solvent, and 1 mol/L of lithium hexafluorophosphate ($LiPF_6$) as a salt. The electrolyte was impregnated into a porous polyethylene film as a separator.

Lithium ion secondary batteries composed of the positive electrode, the negative electrode, the electrolyte, and the separator were produced. The facing area between the positive and negative electrodes of the produced lithium ion secondary batteries was 2.8 cm$^2$.

Test Example 10: Initial Charge-discharge Characteristics

A charge-discharge test was conducted to investigate the initial charge-discharge capacity of each of the produced lithium ion secondary batteries of Example 13 and Comparative Example 13.

For charge and discharge, constant current, constant voltage charge (CCCV charge) was performed to an upper-limit voltage of 4.2 V at a charge rate of 0.2 C until the current value reached 0.05 C, followed by a 10-minute pause; thereafter, discharge was performed to a lower-limit voltage of 2.7 V at a discharge rate of 0.2 C, followed by a 10-minute pause. As a result, in Example 13, the charge capacity was 9.32 mAh, the discharge capacity was 7.93 mAh, and the coulombic efficiency was 85.09%, and in Comparative Example 13, the charge capacity was 9.53 mAh, the discharge capacity was 8.24 mAh, and the coulombic efficiency was 86.46%.

Even when positive electrode constituent materials other than the positive electrode active material, carbon nanotubes, and conductive aids other than the carbon nanotubes are not contained, there was almost no effect on the initial characteristics, and the initial charge-discharge characteristics were equivalent to those of the battery containing such a positive electrode constituent material.

Test Example 11: Internal Resistance under High-Load Conditions

The internal resistance of each of the lithium ion secondary batteries of Example 13 and Comparative Example 13 was measured by a high-load current rest method to investigate the degree of uneven reaction distribution.

Specifically, the lithium ion secondary batteries of Example 13 and Comparative Example 13 were subjected to constant current, constant voltage charge (CCCV charge) to an upper-limit voltage of 4.2 V, which corresponds to an SOC of 100%, at 25°C, under the conditions of a charge rate of 0.5 C and a cut off current of 0.05 C, followed by a 10-minute pause. Thereafter, discharge was performed to an SOC of 90% (for 2 minutes) at a discharge rate of 3.0 C, followed by a 10-minute pause. The state of charge (SOC) is defined according to the following formula (1) :

$$\text{SOC (\%)} = \text{Remaining capacity (Ah)/Full charge capacity (Ah)} \times 100 \quad (1).$$

The internal resistance was then calculated using the following formula:

Internal resistance = (Increase in voltage at pause ($\Delta$V(1 min))/Current value during discharge (3 C current)) $\times$ Facing area between positive electrode and negative electrode (2.8 $cm^2$)

Fig. 4 shows an outline of the analysis method used in the high-load current rest method.

The results of the high-load current rest method showed that the internal resistance of Example 13 was 25.90 $\Omega \cdot cm^2$, whereas the internal resistance of Comparative Example 13 was 36.46 $\Omega \cdot cm^2$.

The results confirmed that by adding a small amount of carbon nanotubes and not containing positive electrode constituent materials other than the positive electrode active material, carbon nanotubes, and conductive aids other than the carbon nanotubes, the internal resistance under high-load conditions is dramatically reduced; i.e., the uneven reaction distribution in the electrode is suppressed.

Test Example 12: Life Characteristics

The lithium ion secondary batteries of Example 13 and Comparative Example 13 were subjected to a charge-discharge cycle test at 45°C. The charge and discharge conditions were as follows. Constant current, constant voltage charge (CCCV charge) was performed to an upper-limit voltage of 4.2 V at a charge rate of 0.5 C until the current value reached 0.05 C, followed by a 10-minute pause. Thereafter, discharge was performed to a lower-limit voltage of 2.7 V at a discharge rate of 0.5 C, followed by a 10-minute pause. These charge and discharge processes were regarded as one cycle, and the charge-discharge cycle test was performed for 400 cycles. At 50, 100, 200, and 300 cycles, charge and discharge were performed to investigate the capacity of each of the lithium ion secondary batteries of Example 13 and Comparative Example 13. In the charge and discharge to investigate the capacity, constant current, constant voltage charge (CCCV charge) was performed to an upper-limit voltage of 4.2 V at a charge rate of 0.2 C until the current value reached 0.05 C, followed by a 10-minute pause; thereafter, discharge was performed to a lower-limit voltage of 2.7 V at a discharge rate of 0.2 C, followed by a 10-minute pause.

As shown in the results of charge-discharge cycle characteristics in Fig. 15, the capacity retention (400 cycles) of Example 13 was 76.9%, and the capacity retention (400 cycles) of Comparative Example 13 was 53.5%. In Comparative Example 13, secondary degradation in which the rate of decrease in capacity retention relative to the number of cycles increased was observed after 200 cycles. This secondary degradation is presumably caused by uneven reaction distribution with progression of charge-discharge cycles. In contrast, in Example 13, in which a small amount of carbon nanotubes was added and in which positive electrode constituent materials other than the positive electrode active material, carbon nanotubes, and conductive aids other than the carbon nanotubes were not contained, it was confirmed that the secondary degradation was suppressed and that the charge-discharge cycle characteristics were improved. In Comparative Example 13, the capacity increased rapidly during charge and discharge to investigate the capacity at 50, 100, 200, and 300 cycles. From this, it can be understood that in Comparative Example 13, uneven reaction distribution was noticeable during charge-discharge cycling and that the uneven reaction distribution was reduced by charge and discharge to investigate the capacity, to thereby recover the capacity. In contrast, in Example 13, the capacity did not increase rapidly during charge and discharge to investigate the capacity. From this, it can be understood that the uneven reaction distribution was suppressed.

Fourth Embodiment

Comparative Example 14

90.0 mass% of hard carbon (hard carbon material; particle shape: spherical; average particle size: 5 μm) as a negative electrode active material, 5.0 mass% of acetylene black (AB) as a conductive aid other than carbon nanotubes, 5.0 mass% of polyvinylidene fluoride (PVdF) as another negative electrode constituent material, and an appropriate amount of N-methylpyrrolidone (NMP) were added and kneaded to prepare a slurry. The slurry was applied to copper foil (thickness: 10 pm) with a doctor blade so that the weight per unit area of the negative electrode active material layer after drying was 10.6 mg/cm$^2$, dried at 100°C, roll-pressed so that the density of the negative electrode active material layer was 1.0 g/cm$^3$, and dried under reduced pressure at 170°C to obtain a negative electrode.

Example 14

90.0 mass% of hard carbon (hard carbon material; particle shape: spherical; average particle size: 5 μm) as a negative electrode active material, 0.1 mass% of single-walled carbon nanotubes (bundled single-walled CNT aggregate; per single-walled CNT, average outer diameter: 2 nm, average length: >5 pm; and G/D: 80 to 150) as carbon nanotubes, 4.9 mass% of acetylene black (AB) as a conductive aid other than the carbon nanotubes, 5.0 mass% of polyvinylidene fluoride (PVdF) as another negative electrode constituent material, and an appropriate amount of N-methylpyrrolidone (NMP) were added and kneaded to prepare a slurry. The slurry was applied to the copper foil described above with a doctor blade so that the weight per unit area of the negative electrode active material layer after drying was 10.6 mg/cm$^2$, dried at 100°C, roll-pressed so that the density of the negative electrode active material layer was 1.0 g/cm$^3$, and dried under reduced pressure at 170°C to obtain a negative electrode.

Table 12 shows the formulations of the Example and the Comparative Example.

Table 12

| | Formulation | | | |
|---|---|---|---|---|
| | Hard carbon | Single-walled CNTs | AB | CMC |
| Comparative Example 14 | 90.0 mass% | - | 5.0 mass% | 5.0 mass% |
| Example 14 | 90.0 mass% | 0.1 mass% | 4.9 mass% | 5.0 mass% |

Production Example: Production of Lithium Ion Secondary Batteries

Each of the negative electrodes obtained in Example 14 and Comparative Example 14 was used as a negative electrode.

$LiNi_{0.8}Co_{0.15}Al_{0.05}O_2$ (NCA; average particle size: 6 um) (92.0 mass% based on the total weight of the positive electrode composition) as a positive electrode active material, polyvinylidene fluoride (PVdF) (4.0 mass% based on the total weight of the positive electrode composition) and acetylene black (AB) (4.0 mass% based on the total weight of the positive electrode composition) as other positive electrode constituent materials, and an appropriate amount of N-methyl-2-pyrrolidone (NMP) were added and kneaded to prepare a slurry. The slurry was applied to aluminum foil (thickness: 17 pm) with a doctor blade so that the mass per unit area of the positive electrode active material layer after drying was 16.2 mg/cm$^2$, dried at 100°C, roll-pressed so that the density of the positive electrode active material layer was 3.0 g/cm$^3$, and dried under reduced pressure at 170°C to obtain a positive electrode.

The electrolyte used was composed of a mixture of ethylene carbonate (EC) and methyl ethyl carbonate (MEC) at a volume ratio of 3:7 as a solvent, and 1 mol/L of lithium hexafluorophosphate ($LiPF_6$) as a salt. The electrolyte was impregnated into a porous polyethylene film as a separator.

Lithium ion secondary batteries composed of the negative electrode, the positive electrode, the electrolyte, and the separator were produced. The facing area between the positive and negative electrodes of the produced lithium ion secondary batteries was 2.8 cm$^2$.

Test Example 13: Initial Charge-discharge Characteristics

A charge-discharge test was conducted to investigate the initial charge-discharge capacity of each of the produced lithium ion secondary batteries of Example 14 and Comparative Example 14.

For charge and discharge, constant current, constant voltage charge (CCCV charge) was performed to an upper-limit voltage of 4.05 V at a charge rate of 0.1 C until the current value reached 0.05 C, followed by a 10-minute pause; thereafter, discharge was performed to a lower-limit voltage of 2.0 V at a discharge rate of 0.1 C, followed by a 10-minute pause. As a result, in Example 14, the charge capacity was 7.68 mAh, the discharge capacity was 5.14 mAh, and the coulombic efficiency was 66.9%, and in Comparative Example 14, the charge capacity was 7.76 mAh, the discharge capacity was 4.90 mAh, and the coulombic efficiency was 63.1%.

The results confirmed that by containing a small amount of carbon nanotubes to form a uniform electron conduction path, the initial coulombic efficiency was improved, and the discharge capacity was increased.

Test Example 14: Internal Resistance under High-Load Conditions

The internal resistance of each of the lithium ion secondary batteries of Example 14 and Comparative Example 14 was measured by a high-load current rest method to investigate the degree of uneven reaction distribution.

Specifically, the lithium ion secondary batteries of Example 14 and Comparative Example 14 were subjected to constant current, constant voltage charge (CCCV charge) to an upper-limit voltage of 4.05 V, which corresponds to an SOC of 100%, at 25°C, under the conditions of a charge rate of 0.5 C and a cut off current of 0.05 C, followed by a 10-minute pause. Thereafter, discharge was performed to an SOC of 90% (for 2 minutes) at a discharge rate of 3.0 C, followed by a 10-minute pause. The state of charge (SOC) is defined according to the following formula (1) :

SOC (%) = Remaining capacity (Ah)/Full charge capacity (Ah) × 100 (1).

The internal resistance was then calculated using the following formula:

Internal resistance = (Increase in voltage at pause ($\Delta$V(10 min))/Current value during discharge (3C current)) $\times$ Facing area between positive electrode and negative electrode (2.8 cm$^2$).

Fig. 4 shows an outline of the analysis method used in the high-load current rest method.

The results of the high-load current rest method showed that the internal resistance of Example 14 was 21.67 $\Omega\cdot$cm$^2$, whereas the internal resistance of Comparative Example 14 was 28.25 $\Omega\cdot$cm$^2$.

The results confirmed that by using hard carbon and adding a small amount of carbon nanotubes, the internal resistance under high-load conditions was dramatically reduced; i.e., the uneven reaction distribution in the electrode was suppressed.

Test Example 15: Life Characteristics

The lithium ion secondary batteries of Example 14 and Comparative Example 14 were subjected to a charge-discharge cycle test at 25°C. The charge and discharge conditions were as follows. Constant current, constant voltage charge (CCCV charge) was performed to an upper-limit voltage of 4.05 V at a charge rate of 0.5 C until the current value reached 0.05 C, followed by a 10-minute pause. Thereafter, discharge was performed to a lower-limit voltage of 2.0 V at a discharge rate of 0.5 C, followed by a 10-minute pause. These charge and discharge processes were regarded as one cycle, and the charge-discharge cycle test was conducted.

As shown in the results of charge-discharge cycle characteristics in Fig. 16, the capacity retention (150 cycles) of Example 14 was 93.0%, whereas the capacity retention (150 cycles) of Comparative Example 14 was 79.7%.

The results confirmed that by using hard carbon and adding a small amount of carbon nanotubes, the charge-discharge cycle characteristics were improved.

## Claims

1. A composition for forming an electrode active material layer for lithium ion secondary batteries, the composition comprising

   an electrode active material and
   a carbon nanotube,

   wherein, based on the total amount of the composition taken as 100 mass%,

   the content of the carbon nanotube is 0.01 to 1.4 mass% and
   the content of one or more electrode constituent materials other than the electrode active material and the carbon nanotube is 0 to 10.0 mass%.

2. The composition for forming an electrode active material layer for lithium ion secondary batteries according to claim 1, wherein

   the content of the electrode active material is 96.6 to 99.9 mass%,
   the content of the electrode constituent materials other than the electrode active material and the carbon nanotube is 0 to 2.0 mass%, and
   the composition is for forming a negative electrode active material layer for lithium ion secondary batteries.

3. The composition for forming an electrode active material layer for lithium ion secondary batteries according to claim 1, wherein

   the content of the electrode active material is 97.4 to 99.9 mass%, and
   the content of the electrode constituent materials other than the electrode active material and the carbon nanotube is 0 to 1.2 mass%.

4. The composition for forming an electrode active material layer for lithium ion secondary batteries according to claim 3, wherein the composition is for forming a negative electrode active material layer for lithium ion secondary batteries.

5. The composition for forming an electrode active material layer for lithium ion secondary batteries according to any one of claims 1 to 4, wherein

   the content of the carbon nanotube is 0.01 to 0.8 mass%,
   the electrode active material comprises an amorphous carbon material, and
   the composition is for forming a negative electrode active material layer for lithium ion secondary batteries.

6. A composition for forming an electrode active material layer for lithium ion secondary batteries, the composition comprising

   an electrode active material and
   a carbon nanotube,

   wherein, based on the total volume of the composition taken as 100 vol%,

   the percentage by volume of the electrode active material is 75.06 to 99.97 vol%,
   the percentage by volume of the carbon nanotube is 0.02 to 4.55 vol%, and
   the percentage by volume of electrode constituent materials other than the electrode active material and the carbon nanotube is 0 to 21.56 vol%.

7. The composition for forming an electrode active material layer for lithium ion secondary batteries according to claim 6, wherein, based on the total volume of the composition taken as 100 vol%,

the percentage by volume of the electrode active material is 93.38 to 99.98 vol%,
the percentage by volume of the carbon nanotube is 0.02 to 2.18 vol%,
the percentage by volume of the electrode constituent materials other than the negative electrode active material and the carbon nanotube is 0 to 4.52 vol%, and
the composition is for forming a negative electrode active material layer for lithium ion secondary batteries.

**8.** The composition for forming an electrode active material layer for lithium ion secondary batteries according to claim 6, wherein

the percentage by volume of the electrode active material is 96.19 to 99.98 vol%,
the percentage by volume of the carbon nanotube is 0.02 to 2.18 vol%, and
the percentage by volume of the electrode constituent materials other than the electrode active material and the carbon nanotube is 0 to 1.63 vol%.

**9.** The composition for forming an electrode active material layer for lithium ion secondary batteries according to claim 8, wherein the composition is for forming a negative electrode active material layer for lithium ion secondary batteries.

**10.** The composition for forming an electrode active material layer for lithium ion secondary batteries according to any one of claims 1 to 9, wherein the electrode active material has an average particle size of 0.1 to 13.0 um.

**11.** The composition for forming an electrode active material layer for lithium ion secondary batteries according to claim 10, wherein

the electrode active material has an average particle size of 0.1 to 13.0 um,
the content of the electrode active material is 96.6 to 99.9 mass%,
the content of the carbon nanotube is 0.01 to 1.4 mass%,
the content of the electrode constituent materials other than the electrode active material and the carbon nanotube is 0 to 2.0 mass%, and
the composition is for forming a negative electrode active material layer for lithium ion secondary batteries.

**12.** The composition for forming an electrode active material layer for lithium ion secondary batteries according to claim 10, wherein

the electrode active material has an average particle size of 0.1 to 13.0 pm,
the percentage by volume of the electrode active material is 93.38 to 99.98 vol%,
the percentage by volume of the carbon nanotube is 0.02 to 2.18 vol%,
the percentage by volume of the electrode constituent materials other than the electrode active material and the carbon nanotube is 0 to 4.52 vol%, and
the composition is for forming a negative electrode active material layer for lithium ion secondary batteries.

**13.** The composition for forming an electrode active material layer for lithium ion secondary batteries according to claim 1 or 10, wherein

the content of the electrode active material is 88.6 to 99.9 mass%,
the content of conductive aids other than the carbon nanotube is 0 to 10.0 mass%,
the composition contains no electrode constituent materials other than the electrode active material, the carbon nanotube, and the conductive aids other than the carbon nanotube, and
the composition is for forming a positive electrode active material layer for lithium ion secondary batteries.

**14.** The composition for forming an electrode active material layer for lithium ion secondary batteries according to claim 6 or 10, wherein

the percentage by volume of the electrode active material is 75.06 to 99.97 vol%,
the content of the carbon nanotube is 0.03 to 4.55 vol%,
the content of conductive aids other than the carbon nanotube is 0 to 21.56 vol%,
the composition contains no electrode constituent materials other than the electrode active material, the carbon nanotube, and the conductive aids other than the carbon nanotube, and
the composition is for forming a positive electrode active material layer for lithium ion secondary batteries.

**15.** The composition for forming an electrode active material layer for lithium ion secondary batteries according to any one of claims 1 to 14, wherein the electrode active material is a material capable of absorbing and releasing a lithium ion.

**16.** The composition for forming an electrode active material layer for lithium ion secondary batteries according to any one of claims 1 to 15, wherein the carbon nanotube is a single-walled carbon nanotube.

**17.** The composition for forming an electrode active material layer for lithium ion secondary batteries according to any one of claims 1 to 16, which is for use to reduce uneven reaction distribution in a lithium ion secondary battery.

**18.** The composition for forming an electrode active material layer for lithium ion secondary batteries according to any one of claims 1 to 17, which is for a lithium ion secondary battery for use in an electric vehicle for car sharing.

**19.** An electrode active material layer for lithium ion secondary batteries comprising the composition for forming an electrode active material layer for lithium ion secondary batteries of any one of claims 1 to 18.

**20.** The electrode active material layer for lithium ion secondary batteries according to claim 19, which is for a lithium ion secondary battery for use in an electric vehicle for car sharing.

**21.** An electrode for lithium ion secondary batteries comprising the electrode active material layer for lithium ion secondary batteries of claim 19 or 20.

**22.** The electrode for lithium ion secondary batteries according to claim 21, which is for a lithium ion secondary battery for use in an electric vehicle for car sharing.

**23.** A lithium ion secondary battery comprising the electrode for lithium ion secondary batteries of claim 21 or 22.

**24.** The lithium ion secondary battery according to claim 23, wherein the lithium ion secondary battery has an internal resistance of 1.0 to 35.0 $\Omega \cdot cm^2$ as calculated according to the following formula (2):

Internal resistance = (Increase in voltage at pause (V)/Current value during discharge (A)) x Facing area between positive electrode and negative electrode ($cm^2$)

wherein the increase in voltage at pause is a value measured after discharging from a state of charge (SOC) of 100% to an SOC of 90% at 25°C and 3.0 C and then pausing for 10 minutes, wherein the SOC is defined according to the following formula (1):

SOC (%) = Remaining capacity (Ah)/Full charge capacity (Ah) x 100 (1).

**25.** The lithium ion secondary battery according to claim 23 or 24, wherein the lithium ion secondary battery has an internal resistance of 1.0 to 45.0 $\Omega \cdot cm^2$ as calculated according to the following formula (2):

Internal resistance = (Increase in voltage at pause (V)/Current value during discharge (A)) x Facing area between positive electrode and negative electrode ($cm^2$)

wherein the increase in voltage at pause is a value measured after discharging from a state of charge (SOC) of 100% to an SOC of 90% at 0°C and 0.5 C and then pausing for 1 minute, wherein the SOC is defined according to the following formula (1):

SOC (%) = Remaining capacity (Ah)/Full charge capacity (Ah) x 100

**26.** The lithium ion secondary battery according to any one of claims 23 to 25 for use in an electric vehicle for car sharing.

**27.** A method for assessing uneven reaction distribution in a lithium ion battery, comprising

discharging the battery from a state of charge (SOC) of 100% to an SOC of 90% at 25°C and 2.5 C and then pausing for 10 minutes, wherein the SOC is defined according to the following formula (1):

SOC (%) = Remaining capacity (Ah)/Full charge capacity (Ah) x 100

measuring an increase in voltage at pause, and
calculating an internal resistance according to the following formula (2):

Internal resistance = (Increase in voltage at pause (V)/Current value during discharge (A)) x Facing area between positive electrode and negative electrode ($cm^2$)

Fig.1

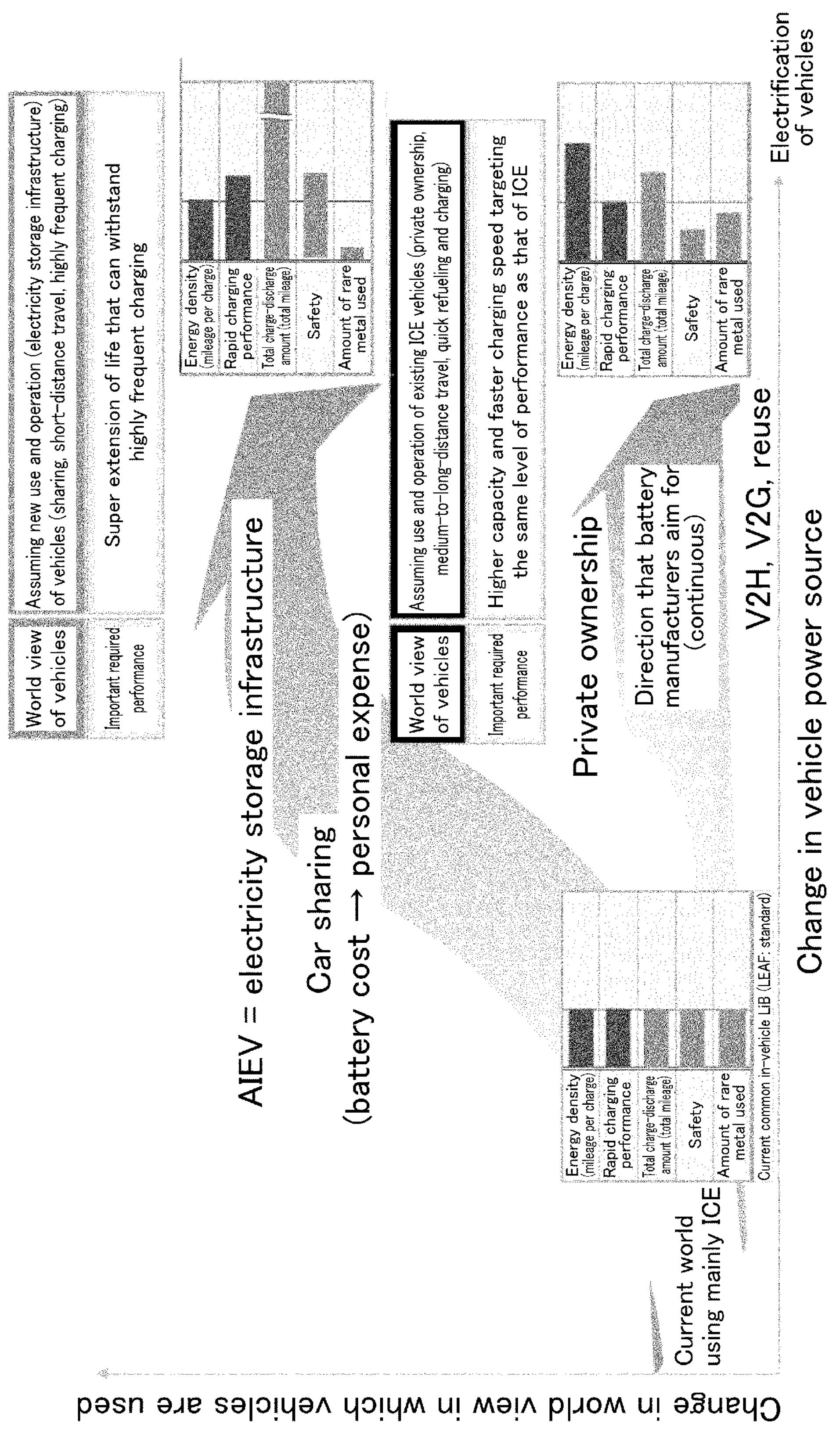
Change in world view in which vehicles are used
Current world using mainly ICE
Energy density (mileage per charge)
Rapid charging performance
Total charge-discharge amount (total mileage)
Safety
Amount of rare metal used
Current common in-vehicle LiB (LEAF: standard)
AIEV = electricity storage infrastructure
Car sharing
(battery cost → personal expense)
World view of vehicles
Assuming new use and operation (electricity storage infrastructure) of vehicles (sharing, short-distance travel, highly frequent charging)
Important required performance
Super extension of life that can withstand highly frequent charging
Energy density (mileage per charge)
Rapid charging performance
Total charge-discharge amount (total mileage)
Safety
Amount of rare metal used
Private ownership
Direction that battery manufacturers aim for (continuous)
V2H, V2G, reuse
World view of vehicles
Assuming use and operation of existing ICE vehicles (private ownership, medium-to-long-distance travel, quick refueling and charging)
Important required performance
Higher capacity and faster charging speed targeting the same level of performance as that of ICE
Energy density (mileage per charge)
Rapid charging performance
Total charge-discharge amount (total mileage)
Safety
Amount of rare metal used
Change in vehicle power source
Electrification of vehicles

Fig.2

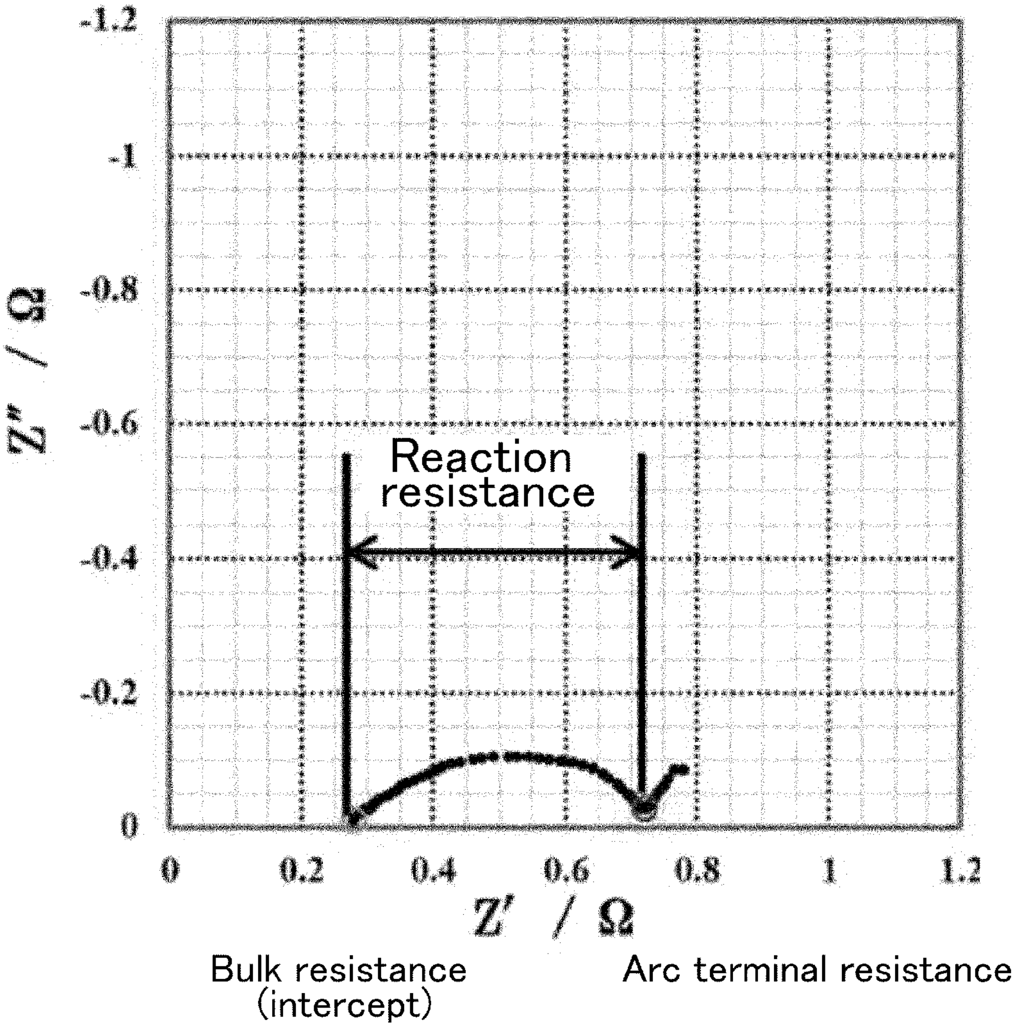
-1.2
-1
-0.8
-0.6
-0.4
-0.2
0
Z″ / Ω
Reaction resistance
0
0.2
0.4
0.6
0.8
1
1.2
Z′ / Ω
Bulk resistance (intercept)
Arc terminal resistance

Fig.3

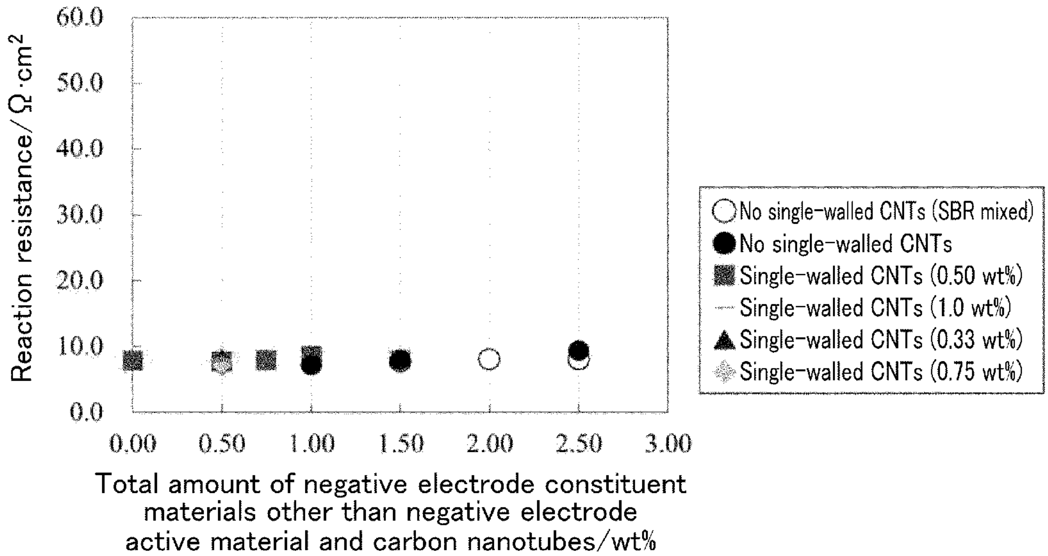
60.0
50.0
40.0
30.0
20.0
10.0
0.0
Reaction resistance/Ω·cm²
0.00
0.50
1.00
1.50
2.00
2.50
3.00
Total amount of negative electrode constituent materials other than negative electrode active material and carbon nanotubes/wt%
No single-walled CNTs (SBR mixed)
No single-walled CNTs
Single-walled CNTs (0.50 wt%)
Single-walled CNTs (1.0 wt%)
Single-walled CNTs (0.33 wt%)
Single-walled CNTs (0.75 wt%)

Fig.4

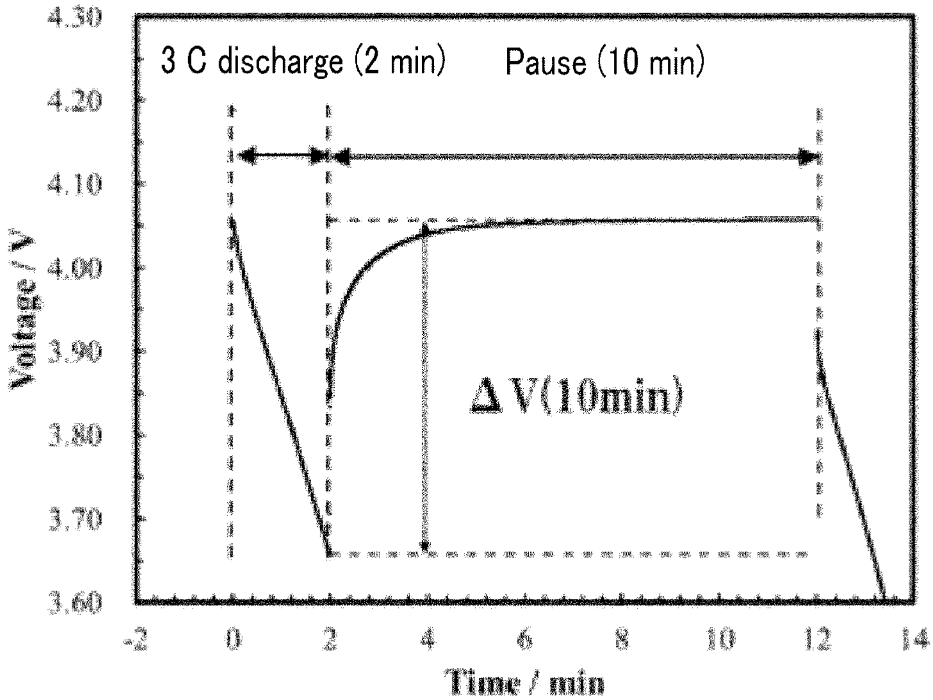
3 C discharge (2 min)
Pause (10 min)
ΔV(10min)
Voltage / V
4.30
4.20
4.10
4.00
3.90
3.80
3.70
3.60
-2
0
2
4
6
8
10
12
14
Time / min

Fig.5

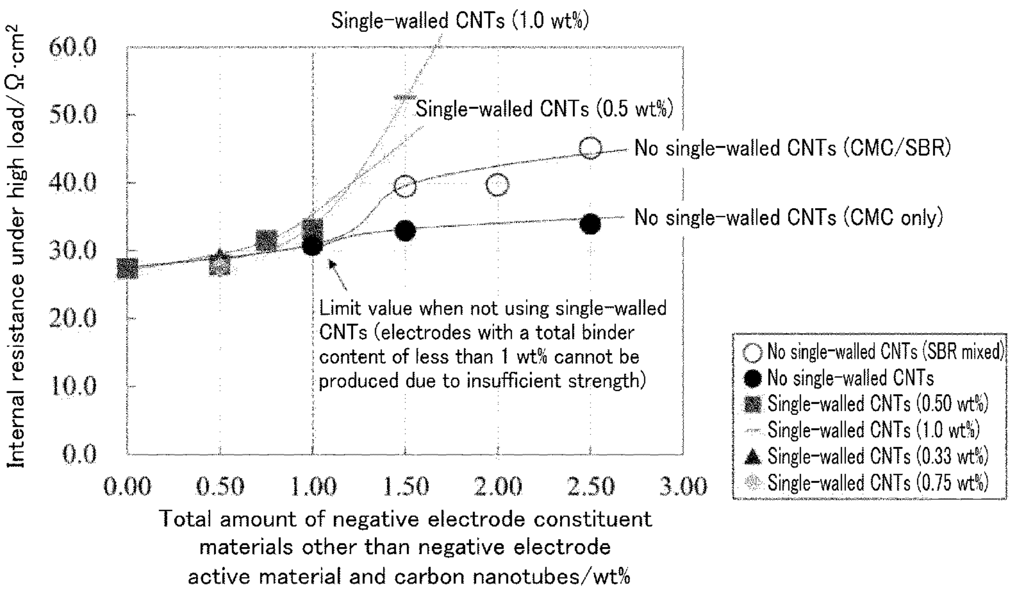

Single-walled CNTs (1.0 wt%)
Single-walled CNTs (0.5 wt%)
No single-walled CNTs (CMC/SBR)
No single-walled CNTs (CMC only)
Limit value when not using single-walled CNTs (electrodes with a total binder content of less than 1 wt% cannot be produced due to insufficient strength)
Internal resistance under high load/Ω·cm²
60.0
50.0
40.0
30.0
20.0
10.0
0.0
0.00
0.50
1.00
1.50
2.00
2.50
3.00
Total amount of negative electrode constituent materials other than negative electrode active material and carbon nanotubes/wt%
No single-walled CNTs (SBR mixed)
No single-walled CNTs
Single-walled CNTs (0.50 wt%)
Single-walled CNTs (1.0 wt%)
Single-walled CNTs (0.33 wt%)
Single-walled CNTs (0.75 wt%)

Fig.6

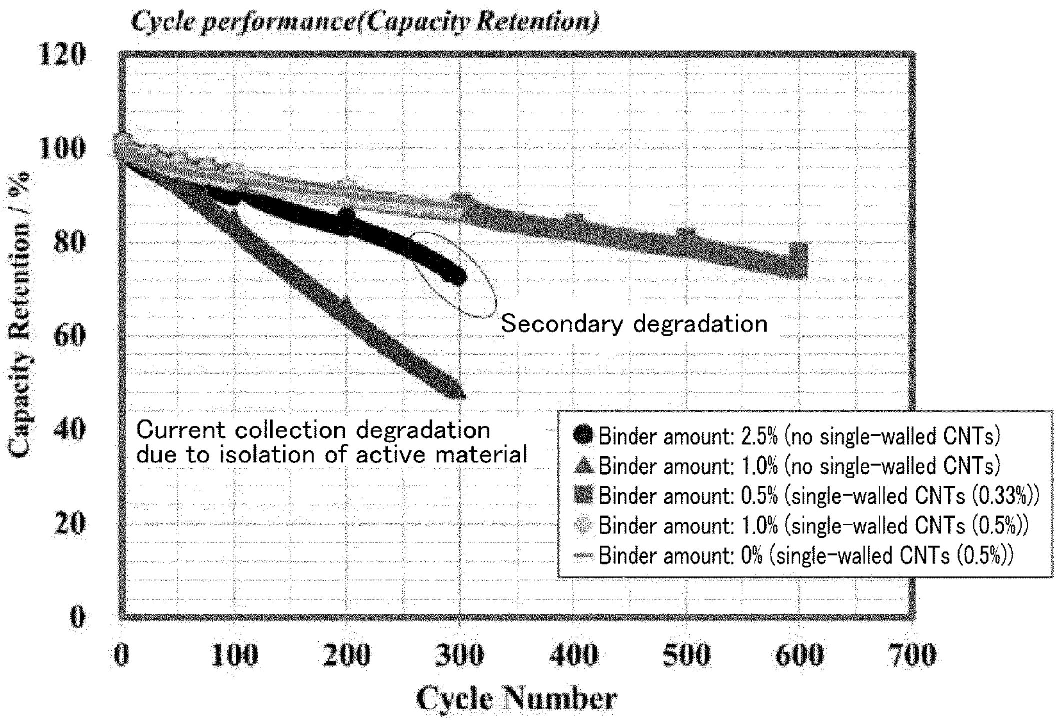
Cycle performance(Capacity Retention)
Capacity Retention / %
120
100
80
60
40
20
0
0
100
200
300
400
500
600
700
Cycle Number
Secondary degradation
Current collection degradation
due to isolation of active material
Binder amount: 2.5% (no single-walled CNTs)
Binder amount: 1.0% (no single-walled CNTs)
Binder amount: 0.5% (single-walled CNTs (0.33%))
Binder amount: 1.0% (single-walled CNTs (0.5%))
Binder amount: 0% (single-walled CNTs (0.5%))

Fig.7

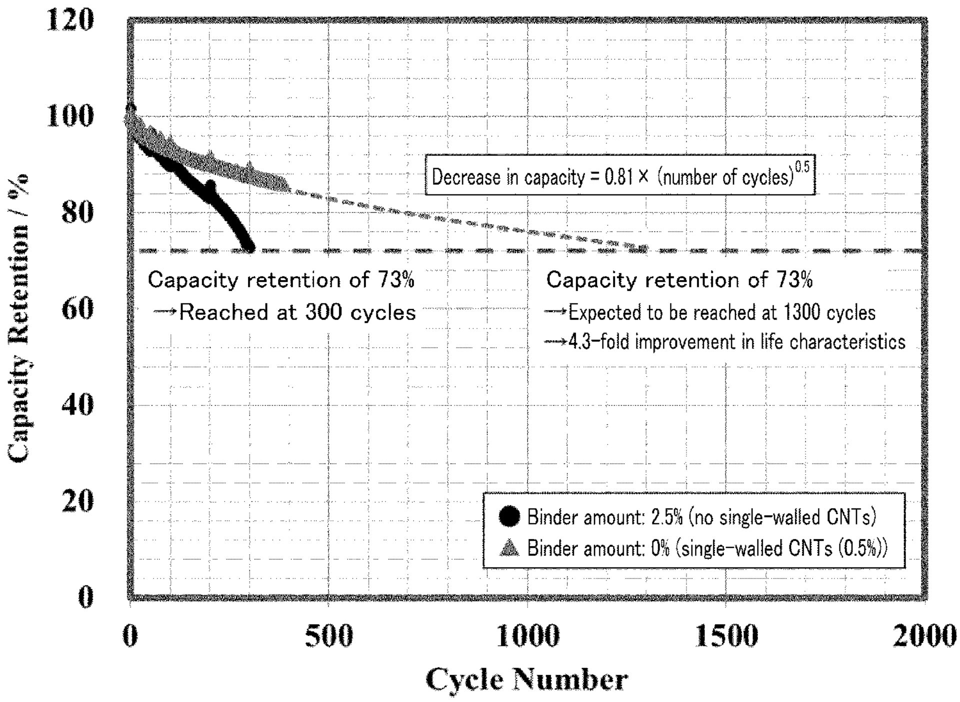
Capacity Retention / %
120
100
80
60
40
20
0
0
500
1000
1500
2000
Cycle Number
Decrease in capacity = 0.81 × (number of cycles)^0.5
Capacity retention of 73%
→Reached at 300 cycles
Capacity retention of 73%
→Expected to be reached at 1300 cycles
→4.3-fold improvement in life characteristics
Binder amount: 2.5% (no single-walled CNTs)
Binder amount: 0% (single-walled CNTs (0.5%))

Fig.8

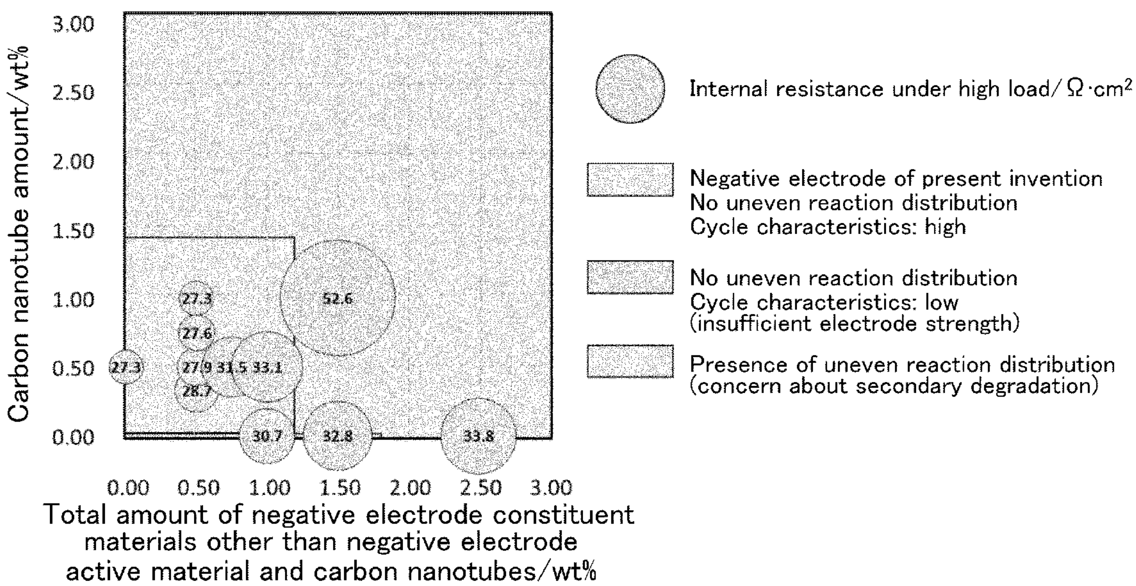
Carbon nanotube amount/wt%
3.00
2.50
2.00
1.50
1.00
0.50
0.00
27.3
27.6
27.3
27.9
31.5
33.1
28.7
52.6
30.7
32.8
33.8
0.00 0.50 1.00 1.50 2.00 2.50 3.00
Total amount of negative electrode constituent materials other than negative electrode active material and carbon nanotubes/wt%
Internal resistance under high load/Ω·cm2
Negative electrode of present invention
No uneven reaction distribution
Cycle characteristics: high
No uneven reaction distribution
Cycle characteristics: low
(insufficient electrode strength)
Presence of uneven reaction distribution
(concern about secondary degradation)

Fig.9

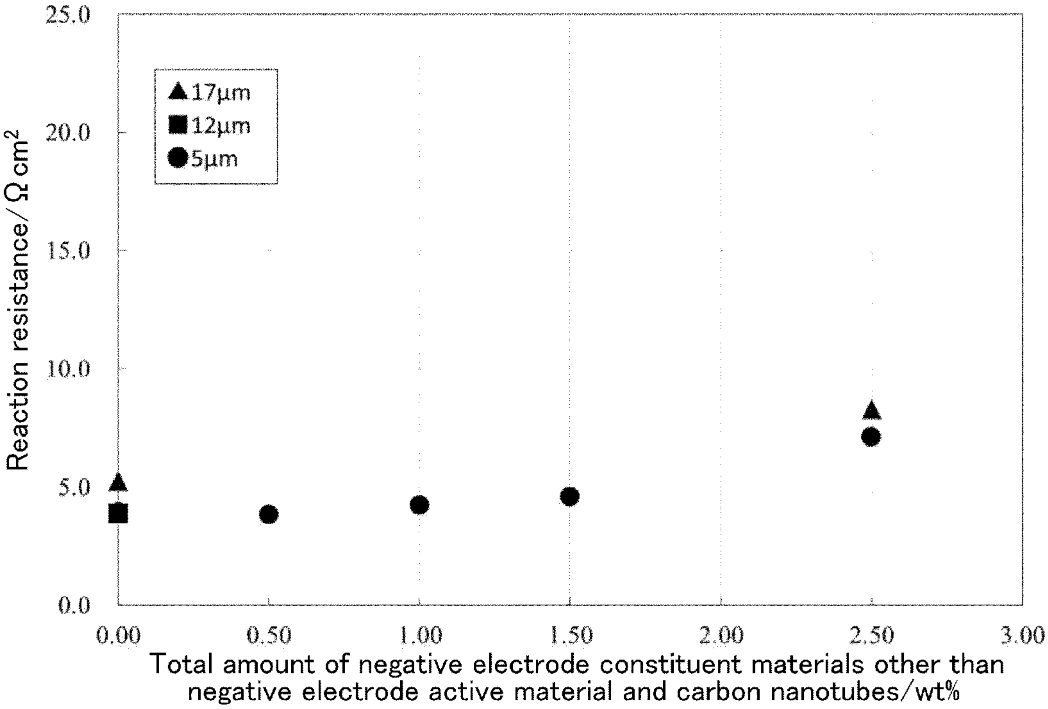

▲17μm
■12μm
●5μm
Reaction resistance/Ω cm²
25.0
20.0
15.0
10.0
5.0
0.0
0.00
0.50
1.00
1.50
2.00
2.50
3.00
Total amount of negative electrode constituent materials other than negative electrode active material and carbon nanotubes/wt%

Fig.10

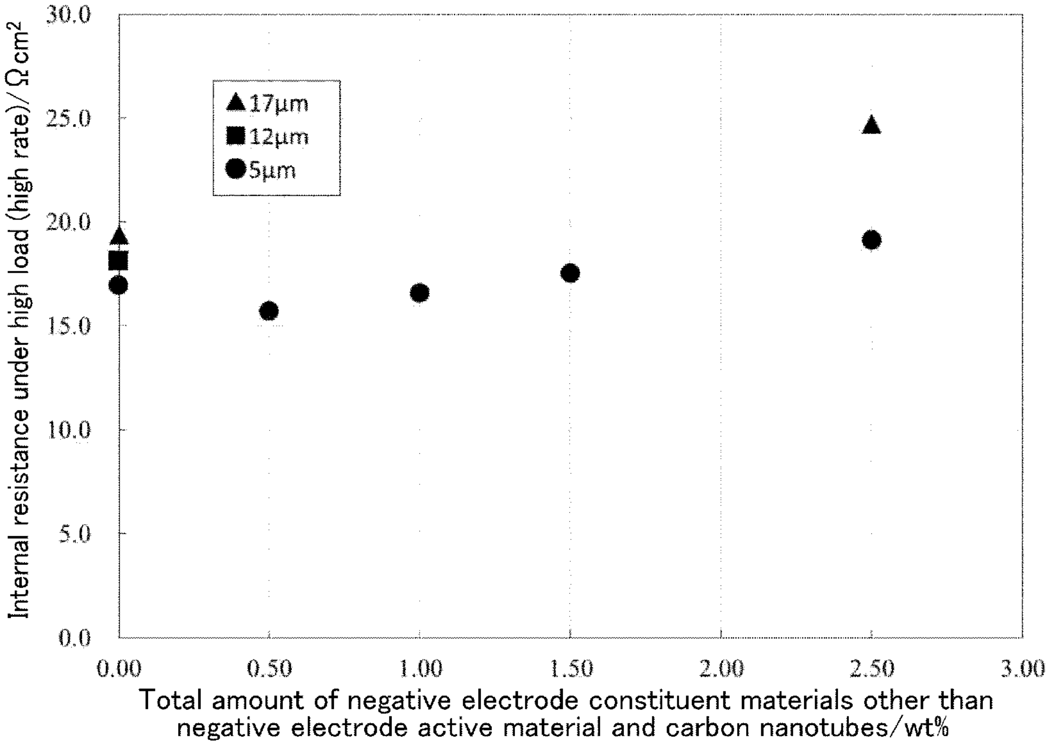

Internal resistance under high load (high rate)/Ω cm2
30.0
25.0
20.0
15.0
10.0
5.0
0.0
▲17μm
■12μm
●5μm
0.00
0.50
1.00
1.50
2.00
2.50
3.00
Total amount of negative electrode constituent materials other than negative electrode active material and carbon nanotubes/wt%

Fig.11

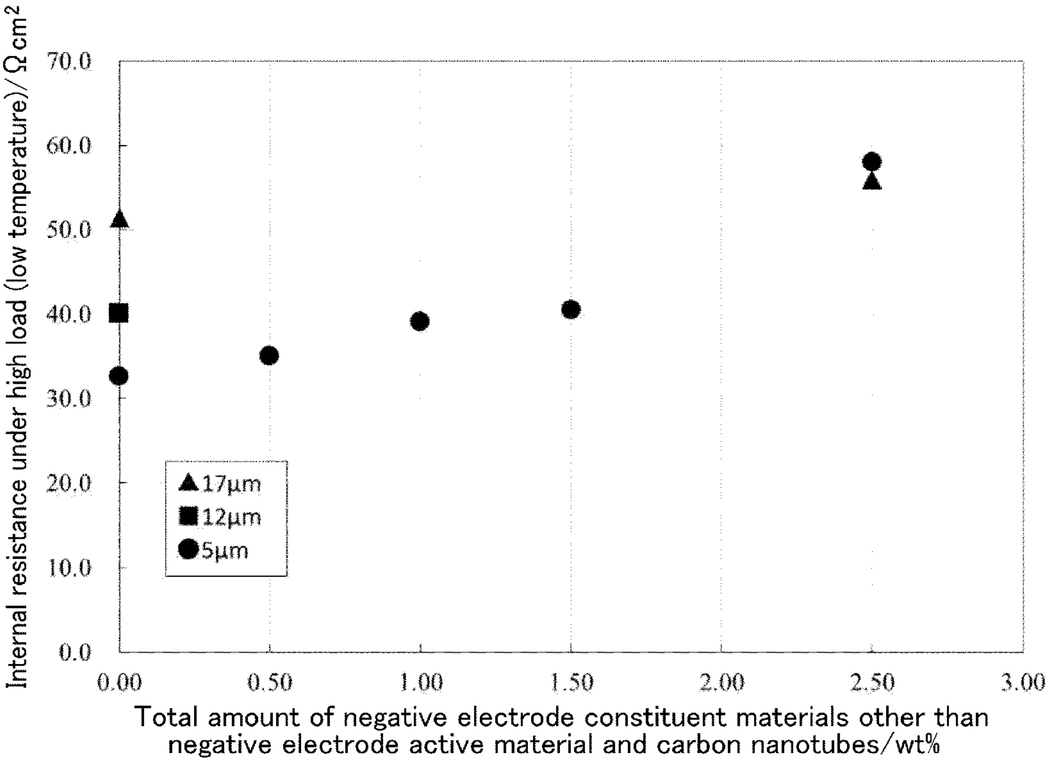
Internal resistance under high load (low temperature)/Ω cm2
70.0
60.0
50.0
40.0
30.0
20.0
10.0
0.0
0.00
0.50
1.00
1.50
2.00
2.50
3.00
▲17μm
■12μm
●5μm
Total amount of negative electrode constituent materials other than negative electrode active material and carbon nanotubes/wt%

Fig.12

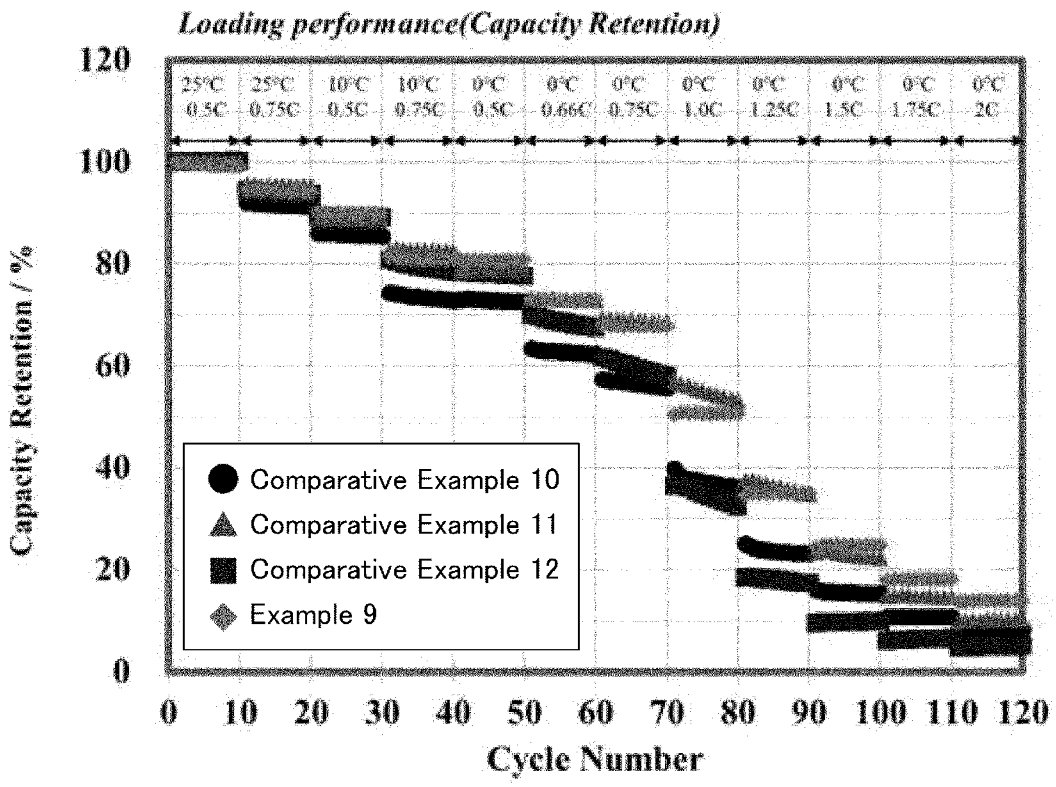
Loading performance(Capacity Retention)
25°C 0.5C
25°C 0.75C
10°C 0.5C
10°C 0.75C
0°C 0.5C
0°C 0.66C
0°C 0.75C
0°C 1.0C
0°C 1.25C
0°C 1.5C
0°C 1.75C
0°C 2C
Comparative Example 10
Comparative Example 11
Comparative Example 12
Example 9
Capacity Retention / %
0
20
40
60
80
100
120
0 10 20 30 40 50 60 70 80 90 100 110 120
Cycle Number

Fig.13

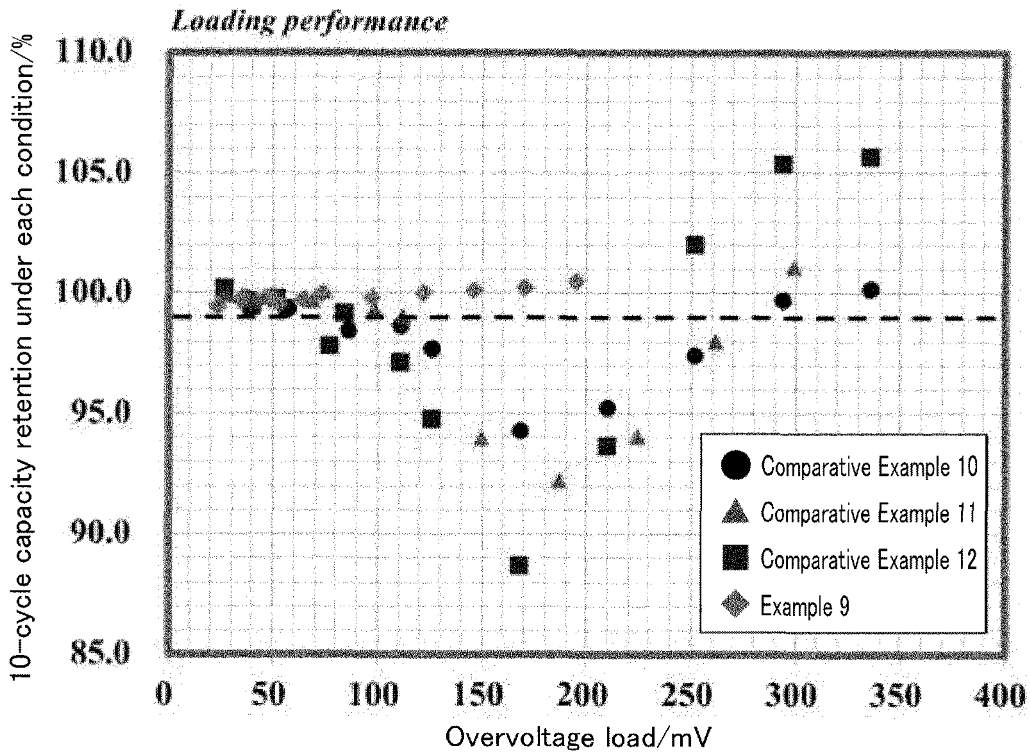
Loading performance
10-cycle capacity retention under each condition/%
110.0
105.0
100.0
95.0
90.0
85.0
0
50
100
150
200
250
300
350
400
Overvoltage load/mV
Comparative Example 10
Comparative Example 11
Comparative Example 12
Example 9

Fig.14

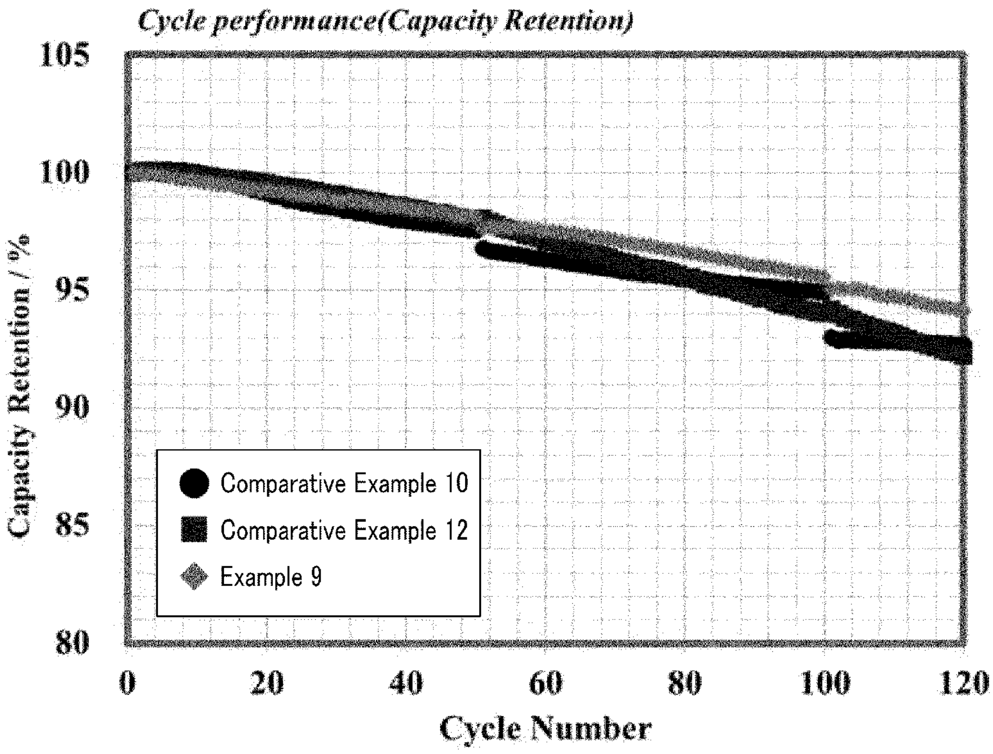
Cycle performance(Capacity Retention)
Capacity Retention / %
105
100
95
90
85
80
0
20
40
60
80
100
120
Cycle Number
Comparative Example 10
Comparative Example 12
Example 9

Fig.15

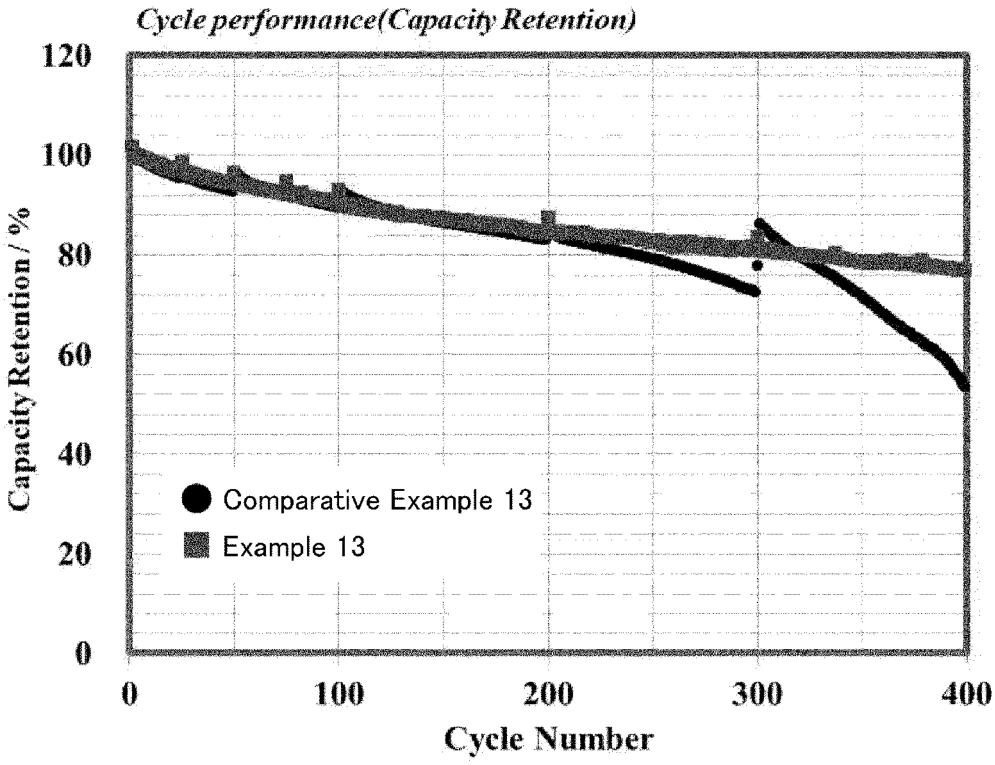
Cycle performance(Capacity Retention)
Capacity Retention / %
120
100
80
60
40
20
0
0
100
200
300
400
Cycle Number
Comparative Example 13
Example 13

Fig.16

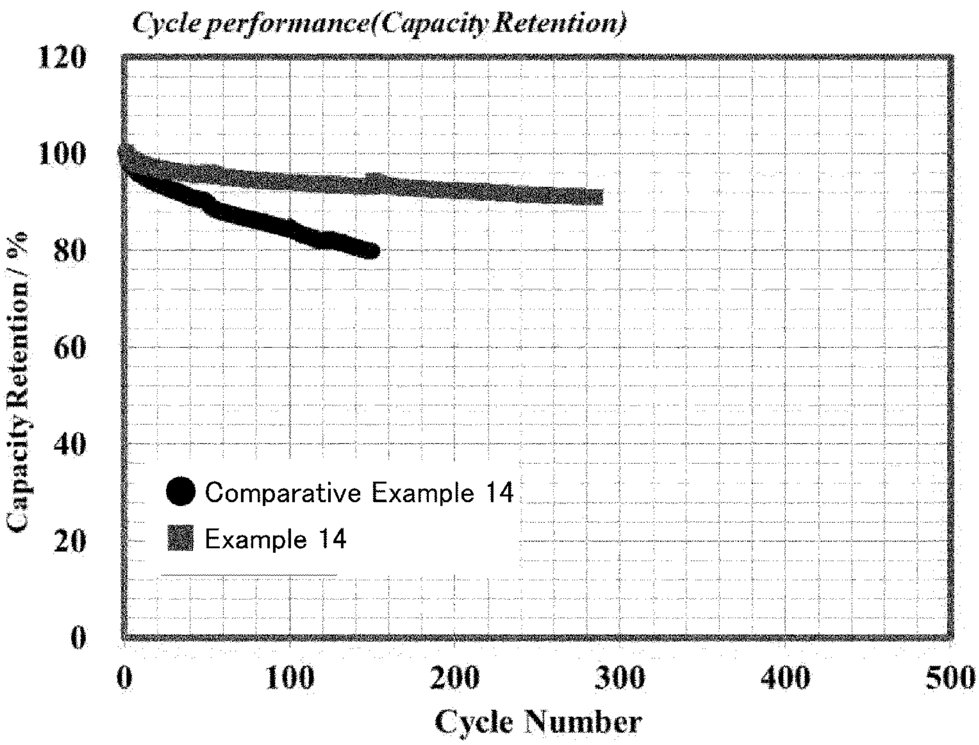
Cycle performance(Capacity Retention)
Capacity Retention / %
120
100
80
60
40
20
0
0
100
200
300
400
500
Cycle Number
Comparative Example 14
Example 14

## INTERNATIONAL SEARCH REPORT

International application No.
**PCT/JP2022/043005**

**A. CLASSIFICATION OF SUBJECT MATTER**

***H01M 4/13***(2010.01)i; ***G01R 31/382***(2019.01)i; ***G01R 31/385***(2019.01)i; ***G01R 31/389***(2019.01)i; ***H01M 4/133***(2010.01)i; ***H01M 4/587***(2010.01)i; ***H01M 4/62***(2006.01)i; ***H01M 10/052***(2010.01)i; ***H01M 10/48***(2006.01)i
FI: H01M4/13; H01M4/587; H01M10/052; H01M4/62 Z; H01M4/133; G01R31/382; G01R31/385; G01R31/389; H01M10/48 P

According to International Patent Classification (IPC) or to both national classification and IPC

**B. FIELDS SEARCHED**

Minimum documentation searched (classification system followed by classification symbols)

H01M4/13; G01R31/382; G01R31/385; G01R31/389; H01M4/133; H01M4/587; H01M4/62; H01M10/052; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/105729 A1 (SHINSHU UNIVERSITY) 28 May 2020 (2020-05-28) claims, paragraphs [0010], [0021]-[0099], fig. 8 | 1, 3, 6, 8, 10, 13-17, 19, 21, 23-25 |
| Y | | 18, 20, 22, 26 |
| A | | 2, 4-5, 7, 9, 11-12, 27 |
| X | JP 2021-150051 A (PANASONIC CORP.) 27 September 2021 (2021-09-27) claims, paragraphs [0020]-[0095] | 1, 3, 6, 8, 10, 15-17, 19, 21, 23-25 |
| Y | | 18, 20, 22, 26 |
| A | | 2, 4-5, 7, 9, 11-14, 27 |
| X | WO 2021/067127 A1 (YAZAKI CORP.) 08 April 2021 (2021-04-08) claim 1, table 1 | 1, 6, 16-17, 19, 21, 23-25 |
| Y | | 18, 20, 22, 26 |
| A | | 2-5, 7-15, 27 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 January 2023** | **07 February 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

INTERNATIONAL SEARCH REPORT

International application No.
PCT/JP2022/043005

C. DOCUMENTS CONSIDERED TO BE RELEVANT

| Category* | Citation of document, with indication, where appropriate, of the relevant passages | Relevant to claim No. |
|---|---|---|
| X | JP 2005-4974 A (MATSUSHITA ELECTRIC INDUSTRIAL CO., LTD.) 06 January 2005 (2005-01-06) claim 1, paragraphs [0041]-[0027], fig. 2 | 1, 5-6, 15, 17, 19, 21, 23-25 |
| Y | | 18, 20, 22, 26 |
| A | | 2-4, 7-14, 16, 27 |
| X | JP 2016-28109 A (HODOGAYA CHEMICAL CO., LTD.) 25 February 2016 (2016-02-25) paragraphs [0072]-[0080] | 1-2, 6-7, 15, 17, 19, 21, 23-25 |
| Y | | 18, 20, 22, 26 |
| A | | 3-5, 8-14, 16, 27 |
| Y | WO 2019/159146 A1 (ALFAZERO S. P. A.) 22 August 2019 (2019-08-22) p. 2, lines 10-15, p. 7, lines 27-30, p. 11, lines 22-25, p. 16, lines 9-11 | 18, 20, 22, 26 |
| P, X | JP 2022-137007 A (SK INNOVATION CO., LTD.) 21 September 2022 (2022-09-21) paragraphs [0071]-[0074] | 1, 6, 15, 17, 19, 21, 23-25 |

Form PCT/ISA/210 (second sheet) (January 2015)

**INTERNATIONAL SEARCH REPORT**
**Information on patent family members**

International application No.
**PCT/JP2022/043005**

| Patent document cited in search report | Publication date (day/month/year) | Patent family member(s) | Publication date (day/month/year) |
|---|---|---|---|
| WO 2020/105729 A1 | 28 May 2020 | US 2021/0313559 A1<br>claims, paragraphs [0012], [0045]-[0141], fig. 8<br>CN 112823437 A<br>KR 10-2021-0054524 A | |
| JP 2021-150051 A | 27 September 2021 | US 2021/0296638 A1<br>claims, paragraphs [0022]-[0096]<br>CN 113410428 A | |
| WO 2021/067127 A1 | 08 April 2021 | US 2022/0223877 A1<br>CN 114503320 A<br>KR 10-2022-0074955 A | |
| JP 2005-4974 A | 06 January 2005 | US 2004/0248010 A1<br>claim 1, paragraphs [0054]-[0062], fig. 2<br>CN 1574444 A<br>CN 1917277 A | |
| JP 2016-28109 A | 25 February 2016 | WO 2014/077252 A1 | |
| WO 2019/159146 A1 | 22 August 2019 | CN 111971811 A | |
| JP 2022-137007 A | 21 September 2022 | US 2022/0285690 A1<br>paragraphs [0079]-[0082]<br>EP 4057380 A2<br>KR 10-2022-0126004 A<br>CN 115050924 A | |

Form PCT/ISA/210 (patent family annex) (January 2015)